# EUROPEAN PATENT APPLICATION

(11) **EP 4 583 089 A1**
(43) Date of publication of application: **09.07.2025**
(21) Application number: 23953270.8
(22) Date of filing: 17.10.2023
(51) Int. Cl.: G09G 3/32, G11C 19/18

(54) **DISPLAY SUBSTRATE AND DISPLAY APPARATUS**

(71) Applicant: BOE TECHNOLOGY GROUP CO., LTD., Beijing 100015 (CN); Chengdu BOE Optoelectronics Technology Co., Ltd., Chengdu, Sichuan 611731 (CN)
(72) Inventor: CHEN, Wenbo, Beijing 100176 (CN); YU, Ziyang, Beijing 100176 (CN); CHENG, Tianyi, Beijing 100176 (CN); JIANG, Zhiliang, Beijing 100176 (CN); YAO, Xing, Beijing 100176 (CN); LIU, Miao, Beijing 100176 (CN); LIU, Wei, Beijing 100176 (CN)
(74) Representative: Durán-Corretjer, S.L.P.
(86) International application number: PCT/CN2023/125026
(87) International publication number: WO 2025/081349

(57) **Abstract**

A display substrate and a display apparatus, the display substrate includes shift registers, a shift register includes a shift sub-circuit and an output sub-circuit configured to provide a signal of a first power supply terminal (VH1) or a second power supply terminal (VL1) to a cascaded signal output terminal (OUTC) under control of signals of a signal input terminal (IN), a first clock signal terminal (CK) and a second clock signal terminal (CB); the output sub-circuit is configured to provide signals of the third power supply terminal (VH2) and the fourth power supply terminal (VL2) to the drive signal output terminal (OUT) under control of signals of a latch signal terminal (MS), a control signal terminal (G) and the cascaded signal output terminal (OUTC); the control signal terminal (G) is connected with a first node of a shift register of a previous stage of shift register of a current stage of shift register, the drive signal output terminal (OUT) is connected with a pixel drive circuit.

## Description

### Technical Field

The present disclosure relates to, but is not limited to, the field of display technologies, and more particularly, to a display substrate and a display apparatus.

### Background

An Organic Light Emitting Diode (OLED for short) and a Quantum dot Light Emitting Diode (QLED for short) are active light emitting display devices and have advantages such as self-luminescence, wide viewing angle, high contrast ratio, low power consumption, very high response speed, lightness and thinness, flexibility, and low cost. With constant development of display technologies, a flexible display apparatus (Flexible Display) in which an OLED or a QLED is used as a light emitting device and signal control is performed through a Thin Film Transistor (TFT) has become a mainstream product in the field of display at present.

### Summary

The following is a summary of subject matter described in the present disclosure in detail. This summary is not intended to limit the protection scope of claims.

In a first aspect, the present disclosure provides a display substrate having a display area and a non-display area, wherein the display area is provided with a pixel drive circuit, and the non-display area is provided with a gate drive circuit, the gate drive circuit includes a plurality of shift registers which are cascaded, at least one stage of shift register includes a shift sub-circuit and an output sub-circuit, wherein the shift sub-circuit is provided with a first node, a second node, a third node, a fourth node, and a fifth node;
the shift sub-circuit is connected with a signal input terminal, a first clock signal terminal, a second clock signal terminal, a first power supply terminal, a second power supply terminal and a cascaded signal output terminal respectively, and is configured to provide a signal of the first power supply terminal or the second power supply terminal to the cascaded signal output terminal under control of signals of the signal input terminal, the first clock signal terminal and the second clock signal terminal;
the output sub-circuit is connected with a control signal terminal, the second node, the third node, the fourth node, a third power supply terminal, a fourth power supply terminal, the cascaded signal output terminal and a drive signal output terminal respectively, and is configured to provide a signal of the third power supply terminal or the fourth power supply terminal to the drive signal output terminal under control of signals of the control signal terminal, the second node, the third node, the fourth node, and the cascaded signal output terminal;
the control signal terminal is connected with a first node of a previous stage of shift register with respect to a current stage of shift register, the drive signal output terminal is connected with the pixel drive circuit, and the cascaded signal output terminal is connected with a signal input terminal of at least one stage of shift register other than the current stage of shift register.

In an exemplary implementation, the shift sub-circuit includes at least a sixth transistor, a seventh transistor, a ninth transistor, and a tenth transistor;
the first node is connected with the sixth transistor and the seventh transistor respectively, the ninth transistor is connected with the first power supply terminal and the cascaded signal output terminal respectively, and the tenth transistor is connected with the second power supply terminal and the cascaded signal output terminal respectively.

In an exemplary implementation, the shift sub-circuit includes a fourth capacitor;
a first plate of the fourth capacitor is connected with the second power supply terminal, and a second plate of the fourth capacitor is connected with the cascaded signal output terminal.
a range of a capacitance value of the fourth capacitor is from 10 farads to 80 farads.

In an exemplary implementation, the output sub-circuit includes at least a nineteenth transistor, a twentieth transistor, a twenty-fourth transistor, a twenty-fifth transistor, and a twenty-sixth transistor;
the nineteenth transistor is connected with the latch signal terminal, the twentieth transistor is connected with the cascaded signal output terminal, the twenty-fourth transistor is connected with the third power supply terminal, the twenty-fifth transistor is connected with the third power supply terminal and the drive signal output terminal respectively, and the twenty-sixth transistor is connected with the fourth power supply terminal and the drive signal output terminal respectively.

In an exemplary implementation, the shift sub-circuit is further provided with a fifth node, the shift sub-circuit further includes a fourth transistor and a fifth transistor, the fifth node is connected with the fourth transistor and the fifth transistor respectively;
the output sub-circuit is further connected with the fifth node and the fourth power supply terminal respectively.

In an exemplary implementation, the output sub-circuit includes at least a nineteenth transistor, a twentieth transistor, a twenty-second transistor, a twenty-third transistor, a twenty-fourth transistor, a twenty-fifth transistor, and a twenty-sixth transistor;
the nineteenth transistor is connected with the latch signal terminal, the twentieth transistor is connected with the cascaded signal output terminal, the twenty-second transistor is connected with the fourth power supply terminal, the twenty-third transistor is connected with the fifth node and the fourth power supply terminal respectively, the twenty-fourth transistor is connected with the third power supply terminal, the twenty-fifth transistor is connected with the third power supply terminal and the drive signal output terminal respectively, and the twenty-sixth transistor is connected with the fourth power supply terminal and the drive signal output terminal respectively.

In an exemplary implementation, the shift sub-circuit includes a ninth transistor and a tenth transistor, and the output sub-circuit includes a twenty-fifth transistor and a twenty-sixth transistor, a transistor includes an active pattern;
a length of an active pattern of at least one of the twenty-fifth transistor and the twenty-sixth transistor in a first direction is greater than a length of an active pattern of at least one of the ninth transistor and the tenth transistors in the first direction, and a length of an active pattern of at least one of the twenty-fifth transistor and the twenty-sixth transistor in a second direction is greater than a length of an active pattern of at least one of the ninth transistor and the tenth transistor in the second direction, wherein the first direction and the second direction intersect.

In an exemplary implementation, a channel width-to-length ratio of the active pattern of at least one of the twenty-fifth transistor and the twenty-sixth transistor is greater than or equal to 80/3.

In an exemplary implementation, the display substrate further includes: a plurality of signal lines located in the non-display area, the shift registers includes a plurality of transistors and a plurality of capacitors, the plurality of signal lines are connected with the shift registers, at least one of the plurality of signal lines extend at least partially in a second direction, a transistor includes: an active pattern, a gate electrode, a first electrode and a second electrode;
the display substrate includes a base substrate and a drive structure layer disposed on the base substrate, wherein the drive structure layer is provided with a pixel drive circuit and a gate drive circuit, and the drive structure layer includes a semiconductor layer, a first conductive layer, a second conductive layer, a third conductive layer and a fourth conductive layer sequentially stacked on the base substrate;
the semiconductor layer includes at least an active pattern of at least one transistor of the plurality of transistors;
the first conductive layer includes at least a gate electrode of at least one transistor of the plurality of transistors and a first plate of at least one capacitor of the plurality of capacitors;
the second conductive layer includes at least a second plate of at least one capacitor of the plurality of capacitors;
the third conductive layer includes at least a first electrode and a second electrode of at least one transistor of the plurality of transistors;
the fourth conductive layer at least includes at least one signal line of the plurality of signal lines.

In an exemplary implementation, the shift sub-circuit includes a fifth transistor, a ninth transistor, a tenth transistor, and a twenty-first transistor; the display substrate further includes: N voltage stabilization connection lines, N cascaded connection lines and N cascaded output lines, wherein a second electrode of the ninth transistor and a second electrode of the tenth transistor in a shift register are formed into an integral structure, and a gate electrode of the twenty-first transistor and a first plate of the fifth capacitor are formed into an integral structure;
an n-th stabilization connection line is connected with an n-th cascaded connection line and an integral structure of a second electrode of a ninth transistor and a second electrode of a tenth transistor in an n-th stage of shift register respectively, and an n-th cascaded output line is connected with an n-th cascaded connection line and a first electrode of a first transistor in an (n+1)-st stage of shift register respectively, where 1≤n≤N, and N is a total number of stages of the shift register; and
for at least one stage of shift register, an orthographic projection of an integral structure of a second electrode of a ninth transistor and a second electrode of a tenth transistor on the base substrate is at least partially overlapped with an orthographic projection of an integral structure of a gate electrode of a twenty-first transistor and a first plate of a fifth capacitor on the base substrate.

In an exemplary implementation, the stabilization connection lines are located in the semiconductor layer, the cascaded output lines are located in the second conductive layer, and the cascaded connection lines are located in the third conductive layer.

In an exemplary implementation, a line width of a voltage stabilization connection line is greater than a line width of a cascaded connection line and greater than a line width of a cascaded output line;
a range of a resistance value of the voltage stabilization connection line is from 500 ohms to 5000 ohms.

In an exemplary implementation, the shift sub-circuit includes a fifth transistor, a ninth transistor, a tenth transistor, a twenty-first transistor and a fourth capacitor, wherein the display substrate, the display substrate further includes N cascaded output lines, a second electrode of a ninth transistor and a second electrode of the tenth transistor in a shift register are formed into an integral structure, a gate electrode of the twenty-first transistor and a first plate of the fifth capacitor are formed into an integral structure;
an integral structure of a second electrode of a ninth transistor and a second electrode of a tenth transistor in an n-th stage of shift register is connected with an n-th cascaded output line and a second plate of a fourth capacitor in the n-th stage of shift register respectively, where 1≤n≤N, and N is a total number of stages of shift register;
for at least one stage of shift register, an orthographic projection of an integral structure of a second electrode of a ninth transistor and a second electrode of a tenth transistor on the base substrate is not overlapped with an orthographic projection of an integral structure of a gate electrode of a twenty-first transistor and a first plate of a fifth capacitor on the base substrate.

In an exemplary implementation, the cascaded output lines are located in the second conductive layer.

In an exemplary implementation, the display substrate further includes N-1 node connection lines, and a shift register further includes a sixth transistor, a seventh transistor, and a nineteenth transistor; a second electrode of the sixth transistor and a first electrode of the seventh transistor in the shift register are formed into an integral structure;
an i-th node connection line is connected with an integral structure of a second electrode of a sixth transistor and a first electrode of a seventh transistor in an i-th stage of shift register and a gate electrode of a nineteenth transistor in an (i+1)-st stage of shift register respectively, where 1≤i≤N-1.

In an exemplary implementation, a node connection line includes: a first node connection line and a second node connection line disposed in different layers;
for the i-th node connection line, a first node connection line is connected with a second node connection line and the integral structure of the second electrode of the sixth transistor and the first electrode of the seventh transistor in the i-th stage of shift register respectively, and the second node connection line is electrically connected with the gate electrode of the nineteenth transistor in the (i+1)-st stage of shift register;
at least one connection line of the first node connection line and the second node connection line extends at least partially in the second direction, an orthographic projection of the first node connection line on the base substrate is not overlapped with an orthographic projection of at least one of the plurality of signal lines on the base substrate, an orthographic projection of the second node connection line on the base substrate is at least partially overlapped with orthographic projections of some of the plurality of signal lines on the base substrate, and an orthographic projection of a part of the second node connection line on the base substrate is at least partially overlapped with an orthographic projection of a first signal line on the base substrate, wherein the first signal line is a signal line of the plurality of signal lines away from the display area.

In an exemplary implementation, the first node connection line is located in the fourth conductive layer and the second node connection line is located in the third conductive layer.

In an exemplary implementation, a node connection line includes: a first node connection portion and a second node connection portion, and the first node connection portion and the second node connection portion are formed into an integral structure;
for the i-th node connection line, a first node connection portion is connected with a second node connection portion and the integral structure of the second electrode of the sixth transistor and the first electrode of the seventh transistor in the i-th stage of shift register respectively, and the second node connection portion is electrically connected with the gate electrode of the nineteenth transistor in the (i+1)-st stage of shift register; and
the first node connection portion extends at least partially in the second direction, the second node connection portion extends at least partially in a first direction, an orthographic projection of the second node connection portion on the base substrate is at least partially overlapped with orthographic projections of some of the plurality of signal lines on the base substrate, and an orthographic projection of a part of the second node connection portion on the base substrate is located on a side of an orthographic projection of a first signal line on the base substrate close to the display area, wherein the first signal line is a signal line of the plurality of signal lines away from the display area.

In an exemplary implementation, the drive structure layer further includes: a fifth conductive layer located on a side of the fourth conductive layer away from the base substrate; and
the node connection lines are located in the fifth conductive layer.

In an exemplary implementation, the node connection lines include: a first node connection line and a second node connection line disposed in different layers;
for the i-th node connection line, a first node connection line is connected with the integral structure of the second electrode of the sixth transistor and the first electrode of the seventh transistor in the i-th stage of shift register and a second node connection line respectively, and the second node connection line is electrically connected with the gate electrode of the nineteenth transistor in the (i+1)-st stage of shift register; and
the first node connection line extends at least partially in the second direction, the second node connection line extends at least partially in a first direction, an orthographic projection of the second node connection line on the base substrate is at least partially overlapped with orthographic projections of some of the plurality of signal lines on the base substrate, and an orthographic projection of a part of the second node connection line on the base substrate is located on a side of an orthographic projection of a first signal line on the base substrate close to the display area, wherein the first signal line is a signal line of the plurality of signal lines away from the display area.

In an exemplary implementation, the drive structure layer further includes: a fifth conductive layer located on a side of the fourth conductive layer away from the base substrate; and
the first node connection line is located in the fifth conductive layer, and the second node connection line is located in the third conductive layer.

In an exemplary implementation, a node connection line includes: a first node connection line, a second node connection line and a third node connection line disposed in different layers;
for the i-th node connection line, a first node connection line is connected with a third node connection line and the integral structure of the second electrode of the sixth transistor and the first electrode of the seventh transistor in the i-th stage of shift register respectively, and a second node connection line is electrically connected with the third node connection line and the gate electrode of the nineteenth transistor in the (i+1)-st stage of shift register respectively;
the first node connection line and the third node connection line extend at least partially in the second direction, the second node connection line extends at least partially in a first direction, an orthographic projection of the third node connection line on the base substrate is not overlapped with an orthographic projection of at least one of the plurality of signal lines on the base substrate, an orthographic projection of the second node connection line on the base substrate is at least partially overlapped with orthographic projections of some of the plurality of signal lines on the base substrate, and an orthographic projection of a part of the second node connection line on the base substrate is located on a side of an orthographic projection of a first signal line on the base substrate close to the display area, wherein the first signal line is a signal line of the plurality of signal lines away from the display area.

In an exemplary implementation, the drive structure layer further includes: a fifth conductive layer located on a side of the fourth conductive layer away from the base substrate; and
the first node connection line is located in the fifth conductive layer, the third node connection line is located in the fourth conductive layer, and the second node connection line is located in the third conductive layer.

In an exemplary implementation, the plurality of signal lines include a latch signal line, a first clock signal line, a second clock signal line, a first power supply line, a second power supply line, a third power supply line, a fourth power supply line, a fifth power supply line, a sixth power supply line, a seventh power supply line, an eighth power supply line, and a ninth power supply line arranged sequentially along a direction close to the display area;
the latch signal line is configured to provide a signal to a latch signal terminal to which a shift register is connected, and at least one of the first power supply line, the third power supply line, the fifth power supply line and the ninth power supply line is configured to provide a signal to the second power supply terminal or the fourth power supply terminal to which a shift register is connected; the second power supply line, the sixth power supply line, the seventh power supply line and the eighth power supply line are configured to provide signals to the first power supply terminal and the third power supply terminal to which a shift register is connected, and the fourth power supply line is configured to provide a signal to the fifth power supply terminal to which a shift register is connected; and
wherein the seventh power supply line is configured to provide a signal to a third power supply terminal to which an i-th shift register is connected, and the eighth power supply line is configured to provide a signal to a third power supply terminal to which an (i+1)-st shift register is connected.

In an exemplary implementation, an orthographic projection of the latch signal line on the base substrate is located on a side of orthographic projections of the plurality of transistors in the shift registers on the base substrate away from the display area, and an orthographic projection of at least one of the first clock signal line, the second clock signal line, the first power supply line, the second power supply line, the third power supply line, the fourth power supply line, the fifth power supply line, the sixth power supply line, the seventh power supply line, the eighth power supply line, and the ninth power supply line on the base substrate is at least partially overlapped with orthographic projections of some of the transistors in the shift registers on the base substrate.

In an exemplary implementation, signals of at least two of the second power supply line, the sixth power supply line, the seventh power supply line, and the eighth power supply line are the same; or
signals of the second power supply line and the sixth power supply line are the same, signals of the seventh power supply line and the eighth power supply line are the same, and voltage values of signals of the second power supply line and the seventh power supply line are different; or
signals of the sixth power supply line, the seventh power supply line, and the eighth power supply line are the same, and voltage values of signals of the second power supply line and the sixth power supply line are different.

In an exemplary implementation, signals of at least two of the first power supply line, the third power supply line, the fifth power supply line, and the ninth power supply line are the same; or
signals of at least two of the first power supply line, the third power supply line, and the fifth power supply line are the same and are different from a signal of the ninth power supply line.

In an exemplary implementation, orthographic projections of at least some of transistors and at least some of capacitors included in the output sub-circuit on the base substrate are around a side of orthographic projections of at least some of transistors and at least some of capacitors included in the shift sub-circuit on the base substrate, and are located on a side of the shift sub-circuit close to the display area.

In an exemplary implementation, the shift sub-circuit includes a fourth capacitor; orthographic projections of at least some of transistors included in the output sub-circuit on the base substrate are around at least one side of an orthographic projection of the fourth capacitor on the base substrate.

In a second aspect, the present disclosure provides a display apparatus, including the above-mentioned display substrate.

Other aspects of the present disclosure may be comprehended after the drawings and the detailed descriptions are read and understood.

### Brief Description of Drawings

Accompany drawings are used to provide understanding of technical solution of the present disclosure, and form a part of the specification. The accompany drawings and embodiments of the present disclosure are adopted to explain the technical solution of the present disclosure, and do not form limitations on the technical solution of the present disclosure.
FIG. 1 is a schematic diagram of a structure of a display apparatus.
FIG. 2A is a first schematic diagram of a planar structure of a display substrate.
FIG. 2B is a second schematic diagram of a planar structure of a display substrate.
FIG. 2C is a third schematic diagram of a planar structure of a display substrate.
FIG. 3 is a schematic diagram of a structure of a shift register according to an embodiment of the present disclosure.
FIG. 4 is a schematic diagram of a structure of another shift register.
FIG. 5A is an equivalent circuit diagram of a shift register.
FIG. 5B is an equivalent circuit diagram of another shift register.
FIG. 6 is an operation timing diagram of part of shift registers.
FIG. 7 is a first schematic diagram of a structure of a display substrate.
FIG. 8 is a second schematic diagram of a structure of a display substrate.
FIG. 9 is a third schematic diagram of a structure of a display substrate.
FIG. 10 is a fourth schematic diagram of a structure of a display substrate.
FIG. 11 is a fifth schematic diagram of a structure of a display substrate.
FIG. 12 is a schematic diagram of a partial structure of the display substrate according to FIGS. 7, 9, 10, and 11.
FIG. 13 is a schematic diagram of a partial structure of the display substrate according to FIG. 8.
FIG. 14 is a schematic diagram of the display substrate according to FIGS. 7, 9 and 11 after a pattern of a semiconductor layer is formed.
FIG. 15 is a schematic diagram of the display substrate according to FIG. 8 after a pattern of a semiconductor layer is formed.
FIG. 16 is a schematic diagram of a pattern of a first conductive layer of the display substrate according to FIGS. 7, 9 and 11.
FIG. 17 is a schematic diagram of a pattern of a first conductive layer of the display substrate according to FIGS. 7, 9 and 11.
FIG. 18 is a schematic diagram of a pattern of a first conductive layer of the display substrate according to FIG. 8.
FIG. 19 is a schematic diagram of the display substrate according to FIG. 8 after a pattern of a first conductive layer is formed.
FIG. 20 is a schematic diagram of a pattern of a second conductive layer of the display substrate according to FIGS. 7, 9 and 11.
FIG. 21 is a schematic diagram of the display substrate according to FIGS. 7, 9 and 11 after a pattern of a second conductive layer is formed.
FIG. 22 is a schematic diagram of a pattern of a second conductive layer of the display substrate according to FIG. 8.
FIG. 23 is a schematic diagram of the display substrate according to FIG. 8 after a pattern of a second conductive layer is formed.
FIG. 24 is a schematic diagram of the display substrate according to FIGS. 7, 10 and 11 after a pattern of a third insulation layer is formed.
FIG. 25 is a schematic diagram of the display substrate according to FIG. 8 after a pattern of a third insulation layer is formed.
FIG. 26 is a schematic diagram of the display substrate according to FIG. 9 after a pattern of a third insulation layer is formed.
FIG. 27 is a schematic diagram of a pattern of a third conductive layer of the display substrate according to FIG. 7.
FIG. 28 is a schematic diagram of the display substrate according to FIG. 7 after a pattern of a third conductive layer is formed.
FIG. 29 is a schematic diagram of a pattern of a third conductive layer of the display substrate according to FIG. 8.
FIG. 30 is a schematic diagram of the display substrate according to FIG. 8 after a pattern of a third conductive layer is formed.
FIG. 31 is a schematic diagram of a pattern of a third conductive layer of the display substrate according to FIG. 9.
FIG. 32 is a schematic diagram of the display substrate according to FIG. 9 after a pattern of a third conductive layer is formed.
FIG. 33 is a schematic diagram of a pattern of a third conductive layer of the display substrate according to FIGS. 10 and 11.
FIG. 34 is a schematic diagram of the display substrate according to FIGS. 10 and 11 after a pattern of a third conductive layer is formed.
FIG. 35 is a schematic diagram of the display substrate according to FIG. 7 after a pattern of a fourth insulation layer is formed.
FIG. 36 is a schematic diagram of the display substrate according to FIG. 8 after a pattern of a fourth insulation layer is formed.
FIG. 37 is a schematic diagram of the display substrate according to FIG. 9 after a pattern of a fourth insulation layer is formed.
FIG. 38 is a schematic diagram of the display substrate according to FIG. 10 after a pattern of a fourth insulation layer is formed.
FIG. 39 is a schematic diagram of the display substrate according to FIG. 11 after a pattern of a fourth insulation layer is formed.
FIG. 40 is a schematic diagram of a pattern of a fourth conductive layer of the display substrate according to FIGS. 7 and 8.
FIG. 41 is a schematic diagram of the display substrate according to FIG. 7 after a pattern of a fourth conductive layer is formed.
FIG. 42 is a schematic diagram of the display substrate according to FIG. 8 after a pattern of a fourth conductive layer is formed.
FIG. 43 is a schematic diagram of a pattern of a fourth conductive layer of the display substrate according to FIGS. 9 and 10.
FIG. 44 is a schematic diagram of the display substrate according to FIG. 9 after a pattern of a fourth conductive layer is formed.
FIG. 45 is a schematic diagram of the display substrate according to FIG. 10 after a pattern of a fourth conductive layer is formed.
FIG. 46 is a schematic diagram of a pattern of a fourth conductive layer of the display substrate according to FIG. 11.
FIG. 47 is a schematic diagram of the display substrate according to FIG. 11 after a pattern of a fourth conductive layer is formed.
FIG. 48 is a schematic diagram of the display substrate according to FIG. 9 after a pattern of a first planarization layer is formed.
FIG. 49 is a schematic diagram of the display substrate according to FIG. 10 after a first planarization layer is formed.
FIG. 50 is a schematic diagram of the display substrate according to FIG. 11 after a pattern of a first planarization layer is formed.
FIG. 51 is a schematic diagram of a pattern of a fifth conductive layer of the display substrate according to FIG. 9.
FIG. 52 is a schematic diagram of the display substrate according to FIG. 9 after a pattern of a fifth conductive layer is formed.
FIG. 53 is a schematic diagram of a pattern of a fifth conductive layer of the display substrate according to FIG. 10.
FIG. 54 is a schematic diagram of the display substrate according to FIG. 10 after a pattern of a fifth conductive layer is formed.
FIG. 55 is a schematic diagram of a pattern of a fifth conductive layer of the display substrate according to FIG. 11.
FIG. 56 is a schematic diagram of the display substrate according to FIG. 11 after a pattern of a fifth conductive layer is formed.

### Detailed Description

To make the objectives, technical solutions, and advantages of the present disclosure clearer, the embodiments of the present disclosure will be described in detail below with reference to the accompany drawings. It is to be noted that implementations may be implemented in multiple different forms. Those of ordinary skills in the art can easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings in the embodiments of the present disclosure relate only to the structures involved in the embodiments of the present disclosure, and other structures may be described with reference to conventional designs.

Scales of the drawings in the present disclosure may be used as a reference in actual processes, but are not limited thereto. For example, a width-length ratio of a channel, a thickness and spacing of each film, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one implementation of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, "electrical connection" includes connection of constituent elements through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

In the specification, "arranged in a same layer" refers to a structure formed by patterning two (or more than two) structures through a same patterning process, and their materials may be the same or different. For example, materials of precursors for forming multiple structures arranged in a same layer are the same, and final materials may be the same or different.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

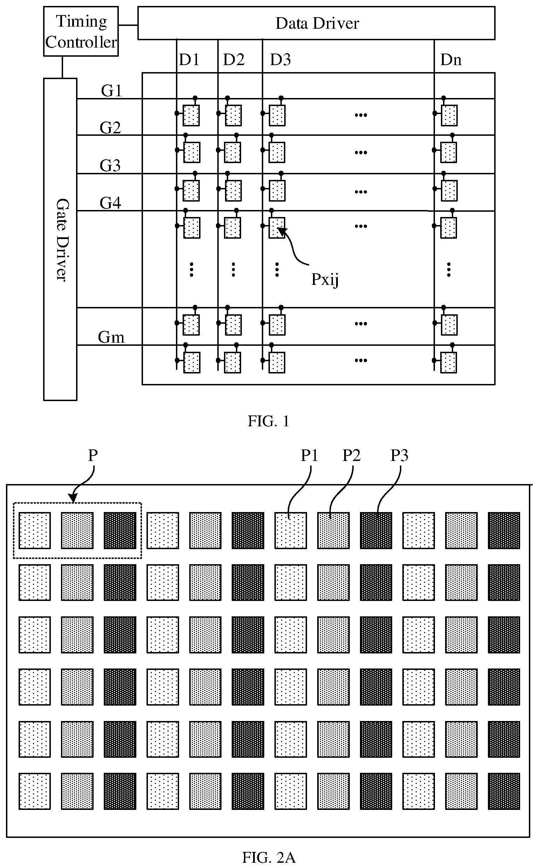

FIG. 1 is a schematic diagram of a structure of a display apparatus. As shown in FIG. 1, the display apparatus may include a timing controller, a data driver, a gate driver, and a pixel array. The timing controller is connected with the data driver and the gate driver respectively, the data driver is connected with a plurality of data signal lines (D1 to Dn) respectively, and the gate driver is connected with a plurality of gate signal lines (G1 to Gm) respectively. The pixel array may include multiple sub-pixels Pxij, wherein i and j may be natural numbers. At least one sub-pixel Pxij may include a circuit unit and a light emitting device connected with the circuit unit. The circuit unit may include a pixel drive circuit, and the pixel drive circuit may be connected with a gate signal line, and a data signal line respectively.

In an exemplary implementation, the timing controller may provide the data driver with a gray scale value and a control signal which are suitable for the specification of the data driver, provide the scan driver with a clock signal and a scan start signal and the like which are suitable for the specification of the scan driver, and provide the light emitting driver with a clock signal and an emission stop signal and the like which are suitable for the specification of the light emitting driver. The data driver may generate data voltages to be provided to the data signal lines D1, D2, D3, ..., and Dn using the grayscale value and the control signal that are received from the timing controller. For example, the data driver may sample the gray scale value using the clock signal and apply a data voltage corresponding to the gray scale value to the data signal lines D1 to Dn by taking a pixel row as a unit, wherein n may be a natural number.

In an exemplary implementation, the gate driver may generate a scan signal to be provided to the gate signal lines G1, G2, G3, ..., to Gm by receiving the clock signal, the gate start signal, and the like from the timing controller. For example, the scan driver may sequentially provide a scan signal with an on-level pulse to the gate signal lines G1 to Gm. For example, the gate driver may be constructed in a form of a shift register and may generate a scan signal in a manner in which a scan start signal provided in a form of an on-level pulse is transmitted to a next-stage circuit sequentially under control of the clock signal, wherein m may be a natural number.

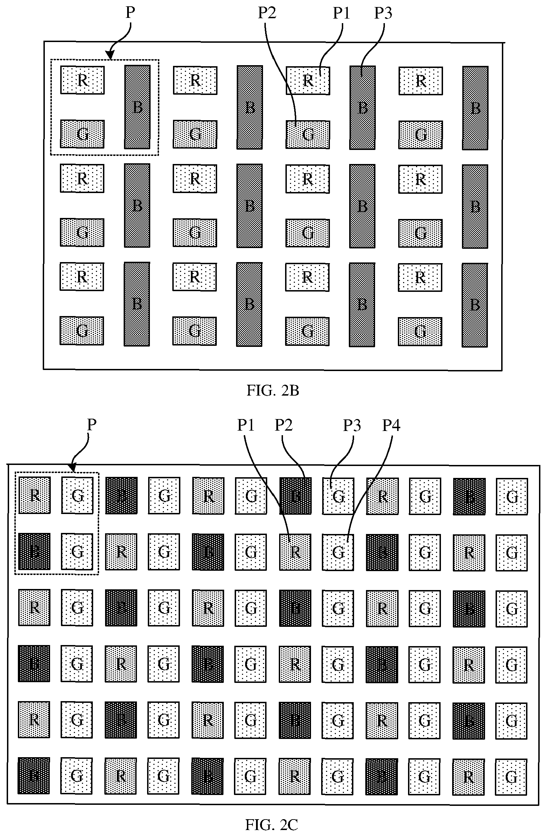

FIG. 2A is a first schematic diagram of a planar structure of a display substrate, FIG. 2B is a second schematic diagram of a planar structure of a display substrate, and FIG. 2C is a third schematic diagram of a planar structure of a display substrate. As shown in FIGS. 2A to 2C, the display substrate may include multiple pixel units P arranged in a matrix, at least one of the multiple pixel units P includes a first sub-pixel P1 emitting light of a first color, a second sub-pixel P2 emitting light of a second color, and a third sub-pixel P3 emitting light of a third color. The first sub-pixel P1, the second sub-pixel P2, and the third sub-pixel P3 each includes a pixel drive circuit and a light emitting device. Pixel drive circuits in the first sub-pixel P1, the second sub-pixel P2, and the third sub-pixel P3 are connected with a gate signal line and a data signal line respectively. The pixel drive circuit is configured to receive a data voltage transmitted by the data signal line and output a corresponding current to the light emitting device under control of the gate signal line. Light emitting devices in the first sub-pixel P1, the second sub-pixel P2, and the third sub-pixel P3 are respectively connected with the pixel drive circuits of the sub-pixels in which the light emitting devices is located, and the light emitting devices are configured to emit light with a corresponding brightness in response to currents outputted by the pixel drive circuits of the sub-pixels in which the light emitting devices are located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light.

In an exemplary implementation, a sub-pixel may be in a shape of a rectangle, a rhombus, a pentagon, or a hexagon. Three sub-pixels may be arranged side by side horizontally, side by side vertically, or in a delta-shaped arrangement, the present disclosure is not limited thereto.

In an exemplary implementation, a pixel unit may include three sub-pixels, and the three sub-pixels may be arranged side by side horizontally, side by side vertically, or in delta-shaped arrangement, and the present disclosure is not limited herein. FIG. 2A and FIG. 2B are illustrated by taking a pixel unit including three sub-pixels as an example. The three sub-pixels in FIG. 2A are arranged side by side horizontally, and the three sub-pixels in FIG. 2B are arranged in a delta-shaped arrangement.

In an exemplary implementation, a pixel unit may include four sub-pixels, and the four sub-pixels may be arranged in a manner to stand side by side horizontally, in a manner to stand side by side vertically, or in a manner of forming a square, which is not limited here in the present disclosure. FIG. 2C illustrates an example in which a pixel unit includes four sub-pixels and the four sub-pixels are arranged in a manner of forming a square.

In an exemplary implementation, the pixel drive circuit may be a structure of 3T1C 4T1C, 5T1C, 5T2C, 6T1C, 7T1C, or 8T1C, which is not limited by the present disclosure.

In some exemplary implementation, the light emitting device L may include any one of an organic light emitting diode (OLED), a quantum dot light emitting diode, and an inorganic light emitting diode. For example, the light emitting device may be a micron-scale light emitting device, such as a Micro Light emitting Diode (Micro LED), a Mini Light emitting Diode (Mini LED), a Micro Organic Light Emitting Diode (Micro OLED), and the like, which are not limited by the embodiments of the present disclosure. For example, taking a case in which the light emitting device L is an organic electroluminescent diode (OLED) as an example, the light emitting device may include a first electrode (for example, as an anode), an organic light emitting layer, and a second electrode (for example, as a cathode) which are stacked.

In an exemplary implementation, the organic emitting layer may include an Emitting Layer (EML), and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, one or more of hole injection layers, hole transport layers, electron block layers, hole block layers, electron transport layers and electron injection layers of all sub-pixels may be connected together to form a common connected layer. The emitting layers of adjacent sub-pixels may overlap slightly with each other, or may be isolated from each other.

In the display market, Low Temperature Poly-Silicon (LTPS) technology is used in most display substrates. LTPS technology has advantages of high resolution, high response speed, high brightness and high aperture ratio. Although it is welcomed by the market, the LTPS technology also has some defects, such as relatively high production cost and relatively large power consumption. At this time, a technology solution of Low Temperature Polycrystalline Oxide (LTPO for short) came into being. Compared with the LTPS technology, in the LTPO technology, a leakage current is smaller, pixel point response is faster, and an additional layer of an oxide is added to a display substrate, which reduces energy consumption required for exciting pixel points, thus reducing power consumption during screen display.

The display product includes a gate drive circuit and a plurality of sub-pixels. A sub-pixel includes a pixel drive circuit. When displaying a picture by the display product, the gate drive circuit generates a drive signal, and the pixel drive circuit is initialized and written data under control of the drive signal, thus implementing the display. When the display product is displaying, the picture will be refreshed in each frame, that is, the pixel drive circuit needs to be initialized and data written in each frame. However, for some special pictures (such as off-screen displayed picture, static picture or infrequently updated picture, etc.), it is not necessary to initialize and write data to the pixel drive circuit in at least some display frames, and the original brightness can be maintained by the pixel drive circuit with low leakage current. A gate drive circuit of the display product generates a drive signal in each frame regardless of which picture is displayed, and repeatedly initializes and writes data to the pixel drive circuit, so that power consumption of the display product is high.

The embodiment of the present disclosure provides a display substrate, which has a display area and a non-display area. The display area is provided with a pixel drive circuit, and the non-display area is provided with a gate drive circuit. The gate drive circuit includes a plurality of shift registers cascaded.

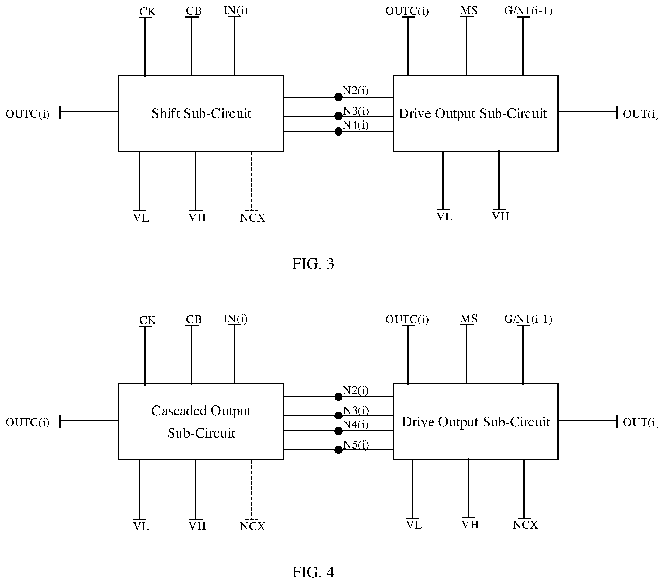

FIG. 3 is a schematic diagram of a structure of a shift register according to an embodiment of the present disclosure. As shown in FIG. 3, at least one stage of shift register includes a shift sub-circuit and an output sub-circuit. The shift sub-circuit is provided with a first node N1. Herein, for an i-th shift register, the shift sub-circuit is connected with a signal input terminal IN(i), a first clock signal terminal CK, a second clock signal terminal CB, a first power supply terminal VH1, a second power supply terminal VL1 and a cascaded signal output terminal OUTC(i) respectively, and is configured to provide a signal of the first power supply terminal VH1 or the second power supply terminal VL1 to the cascaded signal output terminal OUTC(i) under control of signals of the signal input terminal IN(i), the first clock signal terminal CK and the second clock signal terminal CB. The output sub-circuit is connected with a latch signal terminal MS, a control signal terminal G, a third power supply terminal VH2, a fourth power supply terminal VL2, the cascaded signal output terminal OUTC(i) and a drive signal output terminal OUT(i) respectively, and is configured to provide a signal of the third power supply terminal VH2 or the fourth power supply terminal VL2 to the drive signal output terminal OUT(i) under control of signals of the latch signal terminal MS, the control signal terminal G and the cascaded signal output terminal OUTC(i). FIG. 3 illustrates an example of an i-th shift register, wherein IN (i) represents a signal input terminal of the i-th shift register, OUTC (i) is a cascaded signal output terminal of the i-th shift register, OUT (i) is a drive signal output terminal of the i-th shift register, the second node N2 (i) is a second node of the i-th shift register, the third node N3 (i) is a third node of the i-th shift register, and the fourth node N4 (i) is a fourth node of the i-th shift register.

As shown in FIG. 3, for the i-th level shift register, the control signal terminal G is connected with a first node N1(i-1) of a previous stage of shift register with regard to the current stage of shift register, the drive signal output terminal OUT is connected with the pixel drive circuit, and the cascaded signal output terminal OUTC is connected with a signal input terminal IN of at least one stage of shift register other than the current stage of shift register.

In an exemplary implementation, since the control signal terminal G is connected with the first node of the previous stage of shift register of the current stage of shift register, a control signal terminal of a first-stage shift register in the shift register provides a signal through a signal line, and control signal terminals of all shift registers except for the first-stage shift register are connected with the first node of the previous stage of shift register.

By configuring a shift sub-circuit to output a cascaded signal provided for other shift registers to a cascaded signal output terminal, and configuring an output sub-circuit to output a drive signal provided for a pixel drive circuit to a drive signal output terminal, the present disclosure realizes that the cascaded signal and the drive signal are output by different sub-circuits, and can control whether to output a drive signal to the pixel drive circuit while ensuring normal output of the cascaded signal.

The above shift register according to the present disclosure can lock a signal of a corresponding latch signal terminal into an output sub-circuit according to a requirement of a refresh rate of the display area through a cooperation of the shift sub-circuit and the output sub-circuit, and can achieve controlling a signal output by the drive signal output terminal, and can realize implementation of different refresh rates in different areas of a display panel, that is, can realize coexistence of high and low refresh rates in a same frame. The embodiment of the present disclosure is not limited to the implementation of different refresh rates in a fixed area of the display panel, and can realize a dynamic refresh in any area, thereby reducing the power consumption of the display panel. Meanwhile, the output sub-circuit can use a phase difference between cascaded signals output from previous and subsequent stages of shift sub-circuit to store a control signal of the latch signal terminal into each stage of shift register, so as to realize a continuous and correct output of the current stage of shift register.

In an exemplary implementation, the shift sub-circuit is further provided with a second node N2, a third node N3, a fourth node N4 and a fifth node N5. The output sub-circuit is further connected with the second node N2, the third node N3, and the fourth node N4.

FIG. 4 is a schematic diagram of a structure of another shift register. In an exemplary implementation, a capacitor group further includes a fourth capacitor C4. A first plate of the fourth capacitor C4 is connected with the second power supply terminal VL1, and a second plate of the fourth capacitor C4 is connected with the cascaded signal output terminal OUTC(i). The arrangement of the fourth capacitor C4 can ensure stability of the signal of the cascaded signal output terminal OUTC (i), and is configured to stabilize the input of the next-level shift register, prevent the input signal of the next-level shift register from being unstable due to jitter during transmission of the cascaded signal output from the cascaded signal output terminal, and can improve the stability of the shift register.

In an exemplary implementation, a range of a capacitance value of the fourth capacitance C4 is from 10 farads to 80 farads.

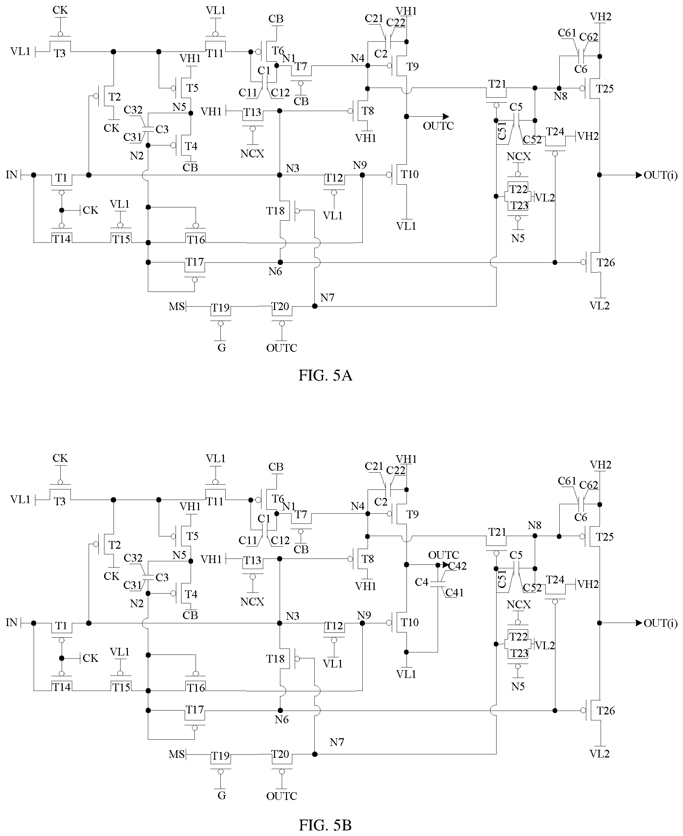

FIG. 5A is an equivalent circuit diagram of a shift register, and FIG. 5B is an equivalent circuit diagram of another shift register. As shown in FIGS. 5A and 5B, in an exemplary implementation, the shift sub-circuit includes a first transistor group and a capacitor group, or includes a first transistor group, a second transistor group and a capacitor group. The first transistor group includes at least a first transistor T1 to a tenth transistor T10. The second transistor group includes at least an eleventh transistor T11 to a twelfth transistor T12, or the eleventh transistor T11 to a thirteenth transistor T13, or the eleventh transistor T11 to a sixteenth transistor T16. The capacitor group includes a first capacitor C1 to a third capacitor C3, and any one of the first capacitor C1 to the third capacitor C3 includes a first plate and a second plate. When the shift sub-circuit includes the thirteenth transistor T13, the shift sub-circuit is further connected with the fifth power supply terminal NCX. FIGS. 5A and 5B are illustrated by an example in which the shift sub-circuit includes a first transistor group, a second transistor group, and a capacitor group, and the second transistor group includes the eleventh transistor T11 to the sixteenth transistors T16.

In an exemplary implementation, a gate electrode of the first transistor T1 is electrically connected with the first clock signal terminal CK, a first electrode of the first transistor T1 is electrically connected with the signal input terminal IN, and a second electrode of the first transistor T1 is electrically connected with the third node N3. A gate electrode of a second transistor T2 is electrically connected with the third node N3, a first electrode of the second transistor T2 is electrically connected with the first clock signal terminal CK, and a second electrode of the second transistor T2 is electrically connected with a second electrode of a third transistor T3, a gate electrode of the fifth transistor T5, and a first electrode of the eleventh transistor T11. A gate electrode of the third transistor T3 is electrically connected with the first clock signal terminal CK, and a first electrode of the third transistor T3 is electrically connected with the second power supply terminal VL1. A gate electrode of the fourth transistor T4 is electrically connected with the second node N2, a first electrode of the fourth transistor T4 is electrically connected with the second clock signal terminal CB, and a second electrode of the fourth transistor T4 is electrically connected with the fifth node N5. A first electrode of the fifth transistor T5 is electrically connected with the first power supply terminal VH1, and a second electrode of the fifth transistor T5 is electrically connected with the fifth node N5. A gate electrode of a sixth transistor T6 is electrically connected with a second electrode of the eleventh transistor T11 and a first plate C11 of the first capacitor, a first electrode of the sixth transistor T6 is electrically connected with the second clock signal terminal CB, and a second electrode of the sixth transistor T6 is electrically connected with the first node N1. A gate electrode of a seventh transistor T7 is electrically connected with the second clock signal terminal CB, a first electrode of the seventh transistor T7 is electrically connected with the first node N1, and a second electrode of the seventh transistor T7 is electrically connected with the fourth node N4. A gate electrode of an eighth transistor T8 is electrically connected with the third node N3, a first electrode of the eighth transistor T8 is electrically connected with the first power supply terminal VH1, and a second electrode of the eighth transistor T8 is electrically connected with the fourth node N4. A gate electrode of a ninth transistor T9 is electrically connected with the fourth node N4, a first electrode of the ninth transistor T9 is electrically connected with the first power supply terminal VH1, and a second electrode of the ninth transistor T9 is electrically connected with the cascaded signal output terminal OUTC (i). A gate electrode of a tenth transistor T10 is electrically connected with the ninth node N9, a first electrode of the tenth transistor T10 is electrically connected with the second power supply terminal VL1, and a second electrode of the tenth transistor T10 is electrically connected with the cascaded signal output terminal OUTC (i). A gate electrode of the eleventh transistor T11 is electrically connected with the second power supply terminal VL1. A gate electrode of the twelfth transistor T12 is electrically connected with the second power supply terminal VL1, a first electrode of the twelfth transistor T12 is electrically connected with the third node N3, and a second electrode of the twelfth transistor T12 is electrically connected with the ninth node N9. A gate electrode of the thirteenth transistor T13 is electrically connected with the fifth power supply terminal NCX, a first electrode of the thirteenth transistor T13 is electrically connected with the first power supply terminal VH1, and a second electrode of the thirteenth transistor T13 is electrically connected with the third node N3. A gate electrode of the fourteenth transistor T14 is electrically connected with the first clock signal terminal CK, a first electrode of the fourteenth transistor T14 is electrically connected with the signal input terminal IN, and a second electrode of the fourteenth transistor T14 is electrically connected with a first electrode of a fifteenth transistor T15. A gate electrode of the fifteenth transistor T15 is electrically connected with the second power supply terminal VL1, and a second electrode of the fifteenth transistor T15 is electrically connected with the second node N2. A gate electrode of the sixteenth transistor T16 is electrically connected with the second node N2, and a first electrode of the sixteenth transistor T16 is electrically connected with the ninth node N9. A second plate of the first capacitor C1 is electrically connected with the first power supply terminal VH1, a first plate C21 of a second capacitor C2 is electrically connected with the fourth node N4, a second plate C22 of the second capacitor C2 is electrically connected with the first power supply terminal VH1, a first plate C31 of the third capacitor C3 is electrically connected with the second node N2, and a second plate C32 of the third capacitor C3 is electrically connected with the fifth node N5.

In an exemplary implementation, the shift sub-circuit may have a circuit structure of 10T3C, 10T4C, 12T3C, 12T4C, 13T3C, 13T4C, 16T3C, or 16T4C, which is not limited in the present disclosure.

In an exemplary implementation, when the shift sub-circuit is in the circuit structure of 10T3C, the shift sub-circuit includes the first transistor T1 to the tenth transistor T10 and the first capacitor C1 to the third capacitor C3.

In an exemplary implementation, when the shift sub-circuit is in the circuit structure of 10T4C, the shift sub-circuit includes the first transistor T1 to the tenth transistor T10 and the first capacitor C1 to a fourth capacitor C4.

In an exemplary implementation, when the shift sub-circuit is in the circuit structure of 12T3C, the shift sub-circuit includes the first transistor T1 to the twelfth transistor T12 and the first capacitor C1 to the third capacitor C3.

In an exemplary implementation, when the shift sub-circuit is in the circuit structure of 12T4C, the shift sub-circuit includes the first transistor T1 to the twelfth transistor T12, the first capacitor C1 to the third capacitor C3, and the fourth capacitor C4.

In an exemplary implementation, when the shift sub-circuit is in the circuit structure of 13T3C, the shift sub-circuit includes the first transistor T1 to the thirteenth transistor T13 and the first capacitor C1 to the third capacitor C3.

In an exemplary implementation, when the shift sub-circuit is in the circuit structure of 13T4C, the shift sub-circuit includes the first transistor T1 to the thirteenth transistor T13 and the first capacitor C1 to the fourth capacitor C4.

In an exemplary implementation, when the shift sub-circuit is in the circuit structure of 16T3C, the shift sub-circuit includes the first transistor T1 to the sixteenth transistor T16 and the first capacitor C1 to the third capacitor C3.

In an exemplary implementation, as shown in FIG. 5A, the output sub-circuit includes a seventeenth transistor T17 to a twenty-first transistor T21, a twenty-fourth transistor T24, a twenty-fifth transistor T25, a twenty-sixth transistor T26, a fifth capacitor C5, and a sixth capacitor C6, and any one of the fifth capacitor C5 and the sixth capacitor C6 includes a first plate and a second plate. Among them, a gate electrode and a first electrode of the seventeenth transistor T17 are connected with the second node N2. A second electrode of the seventeenth transistor T17 is connected with the sixth node N6. A gate electrode of a eighteenth transistor T18 is connected with the seventh node N7, a first electrode of the eighteenth transistor T18 is connected with the third node N3, and a second electrode of the eighteenth transistor T18 is connected with the sixth node N6. A gate electrode of a nineteenth transistor T19 is connected with the control signal terminal G, a first electrode of the nineteenth transistor T19 is connected with the latch signal terminal MS, and a second electrode of the nineteenth transistor T19 is connected with a first electrode of a twentieth transistor T20. A gate electrode of the twentieth transistor T20 is connected with the cascaded signal output terminal OUTC, and a second electrode of the twentieth transistor T20 is connected with the seventh node N7. A gate electrode of a twenty-first transistor T21 is connected with the seventh node N7, a first electrode of the twenty-first transistor T21 is connected with the fourth node N4, and a second electrode of the twenty-first transistor T21 is connected with the eighth node N8. A gate electrode of the twenty-fourth transistor T24 is connected with the sixth node N6, a gate electrode of the twenty-fourth transistor T24 is connected with the sixth node N6, a first electrode of the twenty-fourth transistor T24 is connected with the third power supply terminal VH3, and a second electrode of the twenty-fourth transistor T24 is connected with the eighth node N8. A gate electrode of the twenty-fifth transistor T25 is connected with the eighth node N8, a first electrode of the twenty-fifth transistor T25 is connected with the third power supply terminal VH2, a second electrode of the twenty-fifth transistor T25 is connected with the drive signal output terminal OUT. A gate electrode of the twenty-sixth transistor T26 is connected with the sixth node N6, a first electrode of the twenty-sixth transistor T26 is connected with the fourth power supply terminal VL2, a second electrode of the twenty-sixth transistor T26 is connected with the drive signal output terminal OUT. A first plate C51 of the fifth capacitor C5 is connected with the seventh node N7, and a second plate C52 of the fifth capacitor C5 is connected with the eighth node N8. A first plate C61 of the sixth capacitor C6 is connected with the eighth node N8, and a second plate C62 of the sixth capacitor C6 is connected with the third power supply terminal VH3.

In an exemplary implementation, as shown in FIG. 5B, the output sub-circuit includes a seventeenth transistor T17 to a twenty-sixth transistor T26, a fifth capacitor C5 and a sixth capacitor C6, and any one of the fifth capacitor C5 and the sixth capacitor C6 includes a first plate and a second plate. Among them, a gate electrode and a first electrode of the seventeenth transistor T17 are connected with the second node N2, and a second electrode of the seventeenth transistor T17 is connected with the sixth node N6. A gate electrode of an eighteenth transistor T18 is connected with the seventh node N7, a first electrode of the eighteenth transistor T18 is connected with the third node N3, and a second electrode of the eighteenth transistor T18 is connected with the sixth node N6. A gate electrode of a nineteenth transistor T19 is connected with the control signal terminal G, a first electrode of the nineteenth transistor T19 is connected with the latch signal terminal MS, and a second electrode of the nineteenth transistor T19 is connected with a first electrode of the twentieth transistor T20. A gate electrode of the twentieth transistor T20 is connected with the cascaded signal output terminal OUTC, a second electrode of the twentieth transistor T20 is connected with the seventh node N7, and a gate electrode of a twenty-first transistor T21 is connected with the seventh node N7. A first electrode of the twenty-first transistor T21 is connected with the fourth node N4, and a second electrode of the twenty-first transistor T21 is connected with the eighth node N8. A gate electrode of a twenty-second transistor T22 is connected with the fifth power supply terminal NCX, a first electrode of the twenty-second transistor T22 is connected with the fourth power supply terminal VL2, and a second electrode of the twenty-second transistor T22 is connected with the seventh node N7. A gate electrode of a twenty-third transistor T23 is connected with the fifth node N5, a first electrode of the twenty-third transistor T23 is connected with the fourth power supply terminal VL2, and a second electrode of the twenty-third transistor T23 is connected with the seventh node N7. A gate electrode of a twenty-fourth transistor T24 is connected with the sixth node N6, a first electrode of the twenty-fourth transistor T24 is connected with the third power supply terminal VH2, and a second electrode of the twenty-fourth transistor T24 is connected with the eighth node N8. A gate electrode of a twenty-fifth transistor T25 is connected with the eighth node N8, a first electrode of the twenty-fifth transistor T25 is connected with the third power supply terminal VH2, and a second electrode of the twenty-fifth transistor T25 is connected with the drive signal output terminal OUT. A gate electrode of the twenty-sixth transistor T26 is connected with the sixth node N6, a first electrode of the twenty-sixth transistor T26 is connected with the second power supply terminal VL1, and a second electrode of the twenty-sixth transistor T26 is connected with the drive signal output terminal OUT. A first plate C51 of the fifth capacitor C5 is connected with the seventh node N7, and a second plate C52 of the fifth capacitor C5 is connected with the eighth node N8. A first plate C61 of the sixth capacitor C6 is connected with the eighth node N8, and a second plate C62 of the sixth capacitor C6 is connected with the third power supply terminal VH3.

In an exemplary implementation, any of the first capacitor C1 to the sixth capacitor C6 may be a capacitor device made by a process, for example, the capacitor device may be implemented by making a special-purpose capacitor electrode, and a plurality of capacitor electrodes of the capacitor may be implemented by metal layers, semiconductor layers (e.g. doped polysilicon), or the like. Or, any of the first capacitance C1 to the sixth capacitance C6 may be a parasitic capacitance between a plurality of devices, and may be implemented by the transistor itself and other devices or lines. A connection mode of any of the first capacitor C1 to the sixth capacitor C6 includes but is not limited to the implementation described above, and may be another suitable connection mode which may store a level of a corresponding node. Herein, the illustrative embodiments of the present disclosure are not limited thereto.

In an exemplary implementation, the transistors may be divided into N type transistors and P type transistors according to their characteristics. When a transistor is a P-type transistor, its turn-on voltage is a low level voltage (e.g., 0V, -5 V, -10 V, or another suitable voltage), and its turn-off voltage is a high level voltage (e.g., 5 V, 10 V, or another suitable voltage). When a transistor is an N-type transistor, its turn-on voltage is a high level voltage (e.g., 5 V, 10 V, or another suitable voltage), and its turn-off voltage is a low level voltage (e.g., 0 V, -5 V, -10 V, or another suitable voltage).

In an exemplary implementation, the first transistor T1 to the twenty-sixth transistor T6 are all P-type transistors.

In an exemplary implementation, the signal of the latch signal terminal MS may be a low level signal or may be a high level signal. When the signal of the latch signal terminal MS is a low level signal, its level may be -20V to -5V, and when the signal of the latch signal terminal MS is a high level signal, its level may be 5V to 20V.

In an exemplary implementation, the signals of the first power supply terminal VH1 and the third power supply terminal VH2 may be high level signals, whose levels may range from 5 V to 10 V for example. The signals of the second power supply terminal VL1 and the fourth power supply terminal VL2 may be low level signals, whose level may range from -10 V to -5 V.

In an exemplary implementation, the signals of either of the first clock signal terminal CK and the second clock signal terminal CB may be square wave signals that repeat high or low voltages. Exemplarily, the signals of the first clock signal terminal CK and the second clock signal terminal CB may have a same period and may be configured as phase-shifted signals. Here, the signal of the second clock signal terminal CB may be phase shifted by half a cycle compared with the signal of the first clock signal terminal CK. A high voltage period of a signal of either of the first clock signal terminal CK and the second clock signal terminal CB in each cycle may be set longer than a low voltage period.

In an exemplary implementation, the fifth power supply terminal NCX is a low level signal during startup initialization stage, which prevents the ninth transistor T9 and the tenth transistor T10 of a control shift register of a last stage from simultaneously being turned on because of delay of an output signal, or is a low level signal during abnormal shutdown stage, which prevents the ninth transistor T9 and the tenth transistor T10 from simultaneously being turned on. The fifth power supply terminal NCX continuously provides the high level signal during a normal display stage, i.e., the thirteenth transistor T13 is turned off during the normal display stage.

In the exemplary implementation, when the signal of the cascaded signal output terminal in the shift register is a low level signal, the signals of the third node N3, the fourth node N4, and the ninth node N9 are effective level signals, the tenth transistor T10 is turned on, and since the third node N3 is turned on, the sixteenth transistor T16 and the seventeenth transistor T17 are turned on, the twenty-fourth transistor T24 and the twenty-sixth transistor T26 are turned on, and the signal of the fourth power supply terminal VL2 is written into the drive signal output terminal OUT. That is, the signal of the cascaded signal output terminal OUTC in the shift register is a low level signal, and the drive signal output terminal OUT also outputs a low level signal.

In the exemplary implementation, when the signal of the cascaded signal output terminal in the shift register is a high level signal, the signal of the fifth node N5 is an effective level signal, and the ninth transistor T9 is turned on. Due to existence of the twenty-first transistor T21, the signal of the fifth node N5 is not directly written into the twenty-fifth transistor T25, and the gate electrode of the twenty-first transistor T21 is determined by the nineteenth transistor T19, the twentieth transistor T20, and the fifth capacitor C5, which can be called a latch sub-circuit.

In an exemplary implementation, the nineteenth transistor T19, the twentieth transistor T20, and the fifth capacitor C5 may be referred to as latch sub-circuits. The gate electrode of the nineteenth transistor T19 is connected with the cascaded signal output terminal, and the gate electrode of the twentieth transistor T20 is connected with a first node of a previous stage of shift register. When the signal of the cascaded signal output terminal and a signal of the first node of the previous stage of shift register are both low level signals, the nineteenth transistor T19 and the twentieth transistor T20 are turned on, and the signal of the latch signal terminal MS is written into the seventh node N7 and the fifth capacitor C5, thereby controlling whether the twentieth transistor T21 is turned on, and whether the twenty-first transistor T21 is turned on determines whether the signal of the fourth node N4 is written into the eighth node N8, whether the twenty-fifth transistor T25 is turned on, and whether the signal of the third power supply terminal VH3 is written into the drive signal output terminal.

In an exemplary implementation, the twenty-second transistor T22 and the twenty-third transistor T23 may be referred to as initial stabilization units. The fifth power supply terminal NCX is a low level signal during a startup initialization stage, and the twenty-second transistor T22 is turned on. Since the display substrate does not perform displaying at this time, the signal of the fourth node N4 is a high level signal, the signal of the fourth power supply terminal VL2 is written into the seventh node N7, the twenty-first transistor T21 is turned on, the high level signal of the fourth node N4 is written into the eighth node N8, and the twenty-fifth transistor T25 is turned off, thereby preventing the drive signal output terminal from outputting the high level signal to the pixel drive circuit. In addition, when the cascaded signal output terminal outputs a low level signal, the signal of the fifth node N5 is a high level signal, the twenty-third transistor T23 is turned on, the signal of the fourth power supply terminal VL2 is written into the seventh node N7, the signal of the latch signal terminal pre-stored in the latch sub-circuit is replaced by the signal of the fourth power supply terminal VL2, the twenty-first transistor T21 is turned on, the high level signal of the fourth node N4 is written into the eighth node N8, and the twenty-fifth transistor T25 is turned off, thereby preventing the drive signal output terminal from outputting the high level signal to the pixel drive circuit. The initial stabilization unit can ensure that at least one stage of shift register has no leakage during the startup initialization stage, thereby improving reliability of the shift register.

In an exemplary implementation, a drive signal output by the drive signal output terminal of the shift register is mainly used for controlling at least one transistor in the pixel drive circuit of the display substrate. When the display substrate is in a refresh frame, the drive signal output terminal outputs a high level signal for a period of time, and outputs a low level signal during remaining time periods within the frame, to achieving refreshing of a data voltage. When the display substrate is not in the refresh frame, the drive signal output terminal always outputs a low level signal.

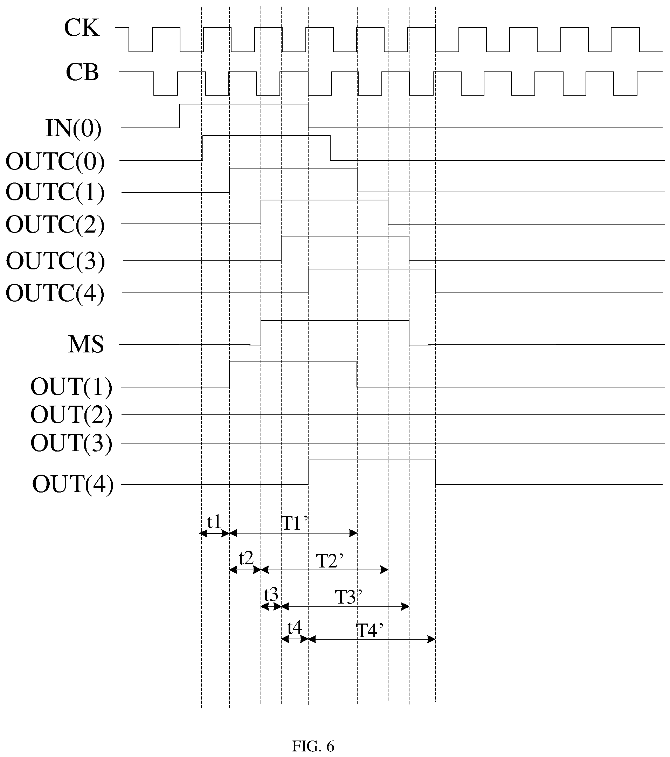

FIG. 6 is an operation timing diagram of part of shift registers. In the following, taking the shift registers shown in FIGS. 5A and 5B as an example, an operation principle of a shift register according to an embodiment of the present disclosure controlling a display panel to achieve different refresh rates in different areas is described with reference to a signal timing diagram shown in FIG. 6. FIG. 6 is illustrated by an example in which first four stages of shift registers are included.

The signal timing diagram shown in FIG. 6 takes only inputs (IN) and outputs (OUT(1), OUT(2), OUT(3), OUT(4)) of the first four stages of shift registers as an example. For example, when areas corresponding to a second row of sub-pixels and a third row of sub-pixels in the display substrate are low refresh rate areas, and areas corresponding to a first row of sub-pixels and a fourth row of sub-pixels are high refresh rate areas, the nineteenth transistor T19 and the twentieth transistor T20 are both turned on when a signal of a cascaded signal output terminal OUTC(1) of a first-stage shift register and a signal of a first node of a previous stage of shift register are both low level signals (time t1). That is, a low level signal of a latched signal terminal MS is locked in the fifth capacitor C5 at time t1, and when the cascaded signal output terminal GP(1) of the first-stage shift register outputs a high level (time T1'), since the fifth capacitor C5 maintains the low level signal of the latched signal terminal MS at time t1, the twenty-first transistor T21 and the twenty-fifth transistor T25 are turned on, then at time T1', a drive signal output terminal OUT(1) of the first-stage shift register outputs a high level signal of the third power supply terminal VH3, so as to achieve a high refresh rate of the first row of sub-pixels in the display area. Maintenance time of the drive signal output terminal OUT(1) of the first-stage shift register outputting the high level signal of the third power supply terminal VH3 can be set according to actual demands. For example, a duration in which the drive signal output terminal OUT(1) of the first-stage shift register outputs the high level signal of the third power supply terminal VH3 may be overlapped with a duration in which a drive signal output terminal OUT(4) of a fourth-stage shift register outputs a high level signal of the third power supply terminal VH3, and a pixel drive circuit corresponding to the drive signal output terminal OUT(4) of the fourth-stage shift register may be pre-charged. Similarly, a duration of a level signal output by a drive signal output terminal OUT(n) of another stage of shift register is similar, and will not be described in detail.

As shown in FIG. 6, when a signal of a cascaded signal output terminal GP(2) of a second-stage shift register and the signal of the first node of the first-stage shift register are both low level signals (time t2), the nineteenth transistor T19 and the twentieth transistor T20 are both turned on, that is, the high level signal of the latched signal terminal MS is locked in the fifth capacitor C5 at time t2. When the cascaded signal output terminal GP(2) of the second-stage shift register outputs a high level (time T2'), since the fourth capacitor C4 maintains the high level signal of the latch signal terminal MS at time t2, the twenty-fifth transistor T25 is turned off, and the twenty-sixth transistor T26 is turned on, then at time T2', a drive signal output terminal OUT(2) of the second-stage shift register outputs a low level signal of the fourth power supply terminal VL2, so as to achieve a low refresh rate of the second row of sub-pixels in the display area.

As shown in FIG. 6, when a signal of a cascaded signal output terminal GP(3) of a third-stage shift register and the signal of the first node of the second-stage shift register are both low level signals (time t3), the nineteenth transistor T19 and the twentieth transistor T20 are both turned on, that is, the high level signal of the latched signal terminal MS is locked in the fifth capacitor C5 at time t3. When the cascaded signal output terminal GP(3) of the third-stage shift register outputs a high level (T3' time), since the fourth capacitor C4 maintains the high level signal of the latch signal terminal MS at time t3, the twenty-fifth transistor T25 is turned off and the twenty-sixth transistor T26 is turned on, then at time T3', a drive signal output terminal OUT(3) of the third-stage of shift register outputs a low level signal of the fourth power supply terminal VL2, so as to achieve a low refresh rate of the third row of sub-pixels in the display area.

As shown in FIG. 6, when a signal of a cascaded signal output terminal GP(4) of a fourth-stage shift register and the signal of the first node of the third-stage shift register are both low level signals (time t4), the nineteenth transistor T19 and the twentieth transistor T20 are both turned on, that is, the low level signal of the latched signal terminal MS is locked in the fifth capacitor C5 at time t4. When the cascaded signal output terminal GP(4) of the fourth-stage shift register outputs a high level (time T4'), since the fourth capacitor C4 maintains the low level signal of the latched signal terminal MS at time t4, the twenty-first transistor T21 and the twenty-fifth transistor T25 are turned on, then at time T4', a drive signal output terminal OUT(4) of the fourth-stage shift register outputs a high level signal of the third power supply terminal VH2, so as to achieve a high refresh rate of the fourth row of sub-pixels in the display area.

Therefore, when a low refresh rate is needed in a certain area of the display substrate, a high level signal is supplied through the latch signal terminal MS, and the drive signal output terminal keeps outputting a low level signal, so that some of transistors corresponding to the pixel drive circuit in the display substrate are turned off, and then a data voltage in the display substrate is not charged, and a state of a previous frame is maintained, thereby achieving a low refresh rate in this area.

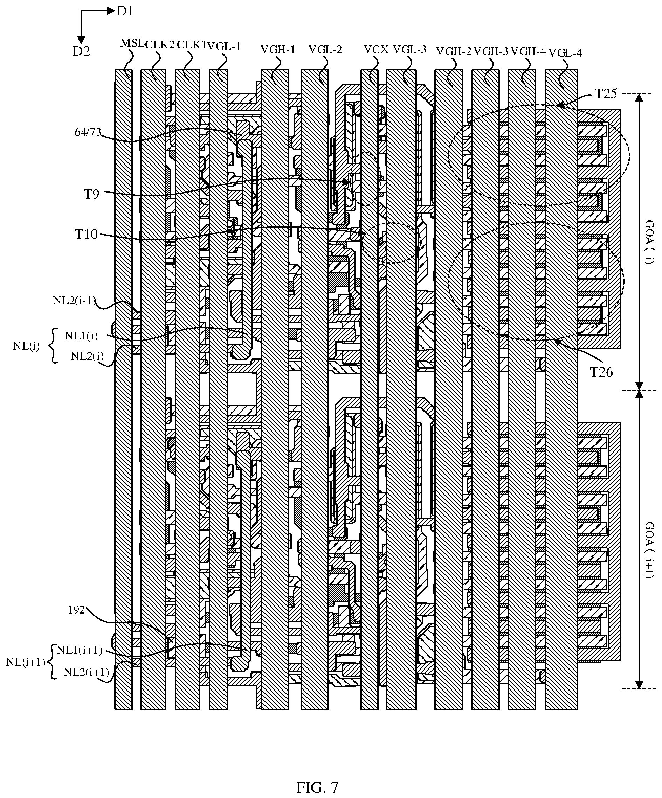

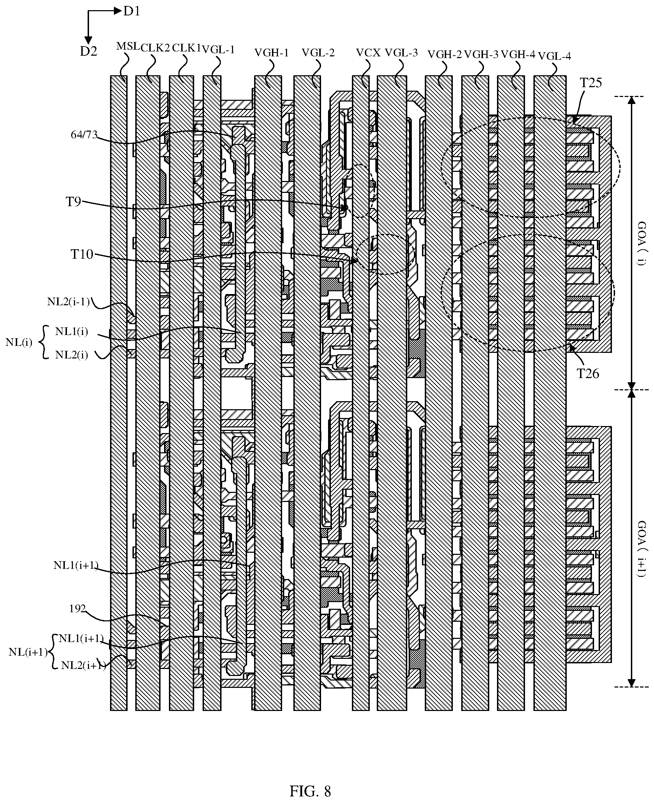

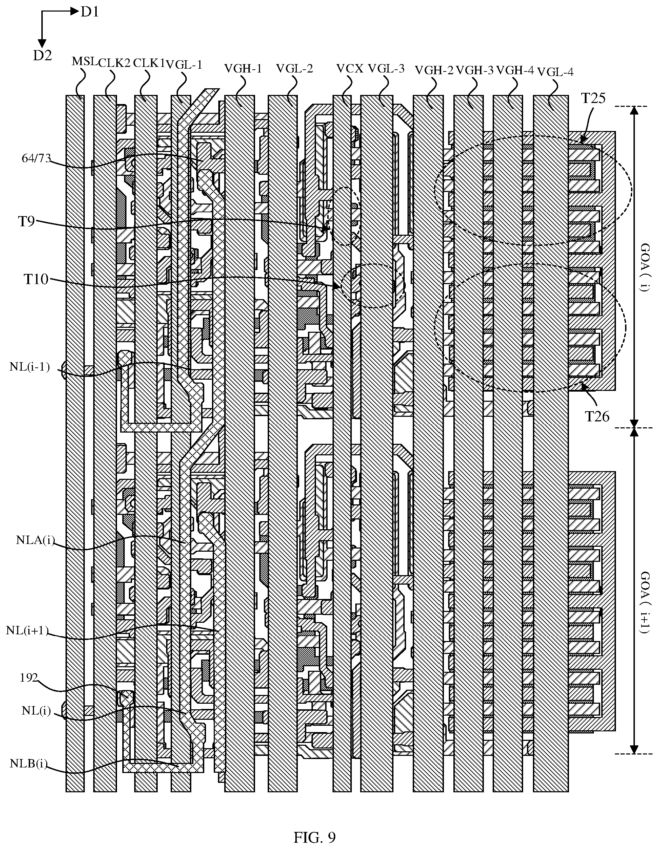

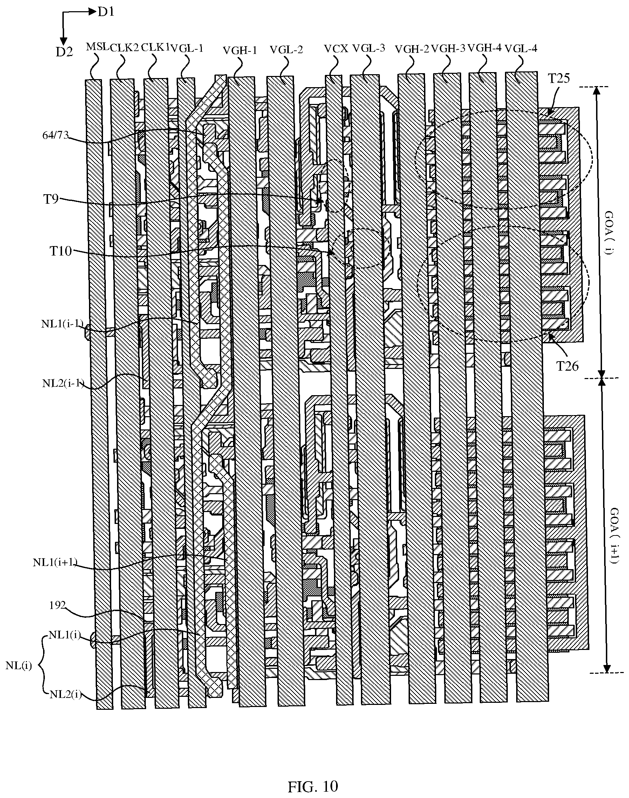

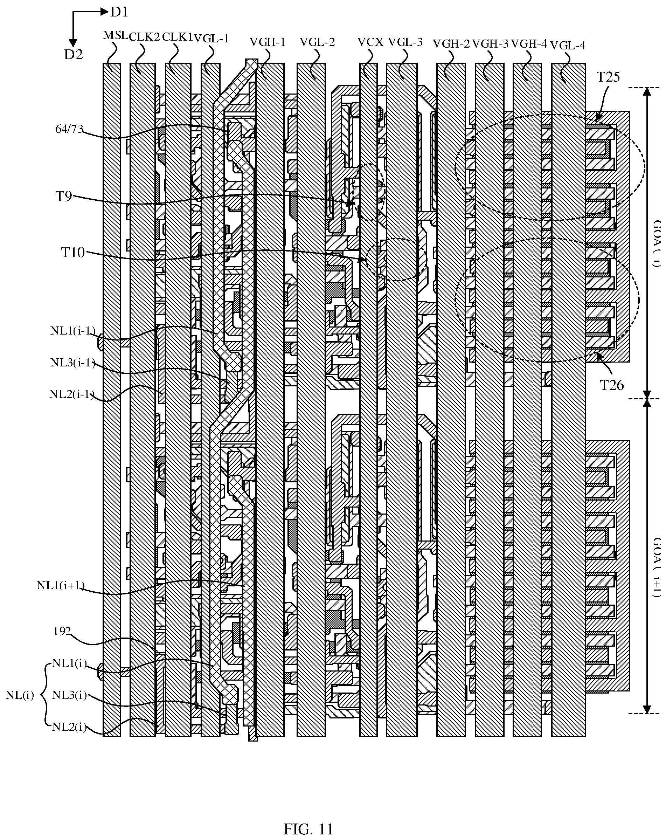

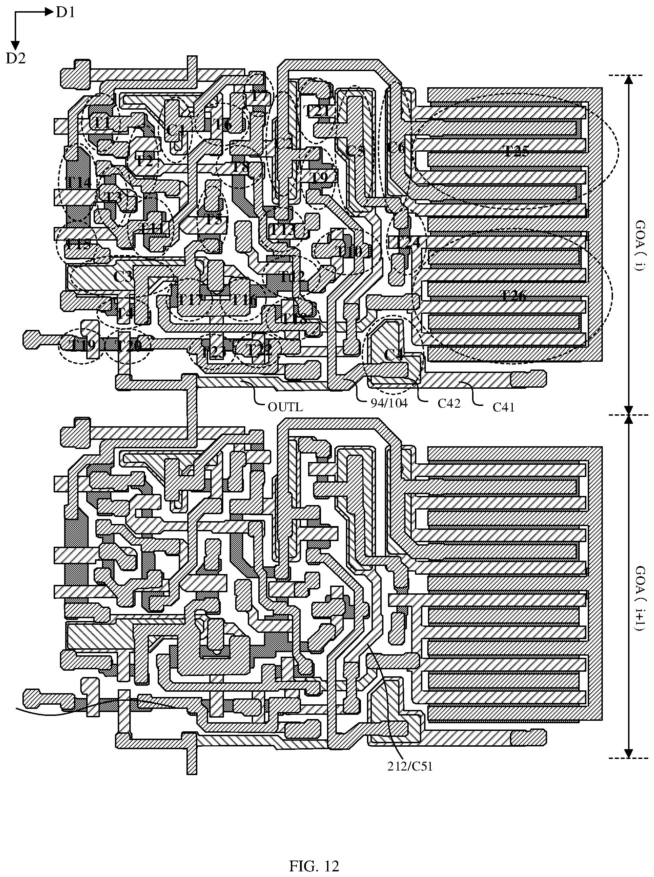

In the exemplary implementation, FIG. 7 is a first schematic diagram of a structure of a display substrate, FIG. 8 is a second schematic diagram of a structure of a display substrate structure, FIG. 9 is a third schematic diagram of a structure of a display substrate, FIG. 10 is a fourth schematic diagram of a structure of a display substrate, FIG. 11 is a fifth schematic diagram of a structure of a display substrate, FIG. 12 is a schematic diagram of a partial structure of the display substrate according to FIGS. 7, 9, 10, and 11, and FIG. 13 is a schematic diagram of a partial structure of the display substrate according to FIG. 8. FIGS. 7 to 11 illustrate two shift registers GOA(i) and GOA(i+1), and the shift registers in FIGS. 7, 9, 10 and 11 are the shift registers of FIG. 5B, and the shift registers in FIG. 8 are the shift registers according to FIG. 5A.

In an exemplary implementation, as shown in FIGS. 7 to 13, a transistor includes an active pattern. Among them a length of an active pattern of at least one of the twenty-fifth transistor T25 and the twenty-sixth transistor T26 in a first direction D1 is greater than a length of an active pattern of at least one of the ninth transistor T9 and the tenth transistor T10 in the first direction D1, and a length of the active pattern of at least one of the twenty-fifth transistor T25 and the twenty-sixth transistorT26 in a second direction D2 is greater than a length of the active pattern of at least one of the ninth transistor T9 and the tenth transistor T10 in the second direction D2, wherein the first direction D1 intersects with the second direction D2.

In an exemplary implementation, a channel width-to-length ratio of the active pattern of at least one of the twenty-fifth transistor T25 and the twenty-sixth transistor T26 is greater than or equal to 80/3.

In an exemplary implementation, as shown in FIGS. 7 to 11, the display substrate further includes a plurality of signal lines located in the non-display area, and a shift register includes a plurality of transistors and a plurality of capacitors. The plurality of signal lines are connected with shift registers, at least one of the plurality of signal lines extends at least partially in the second direction D2, and a transistor includes an active pattern, a gate electrode, a first electrode, and a second electrode.

In an exemplary implementation, the display substrate includes a base substrate and a drive structure layer disposed on the base substrate. The drive structure layer is provided with a pixel drive circuit and a gate drive circuit, and the drive structure layer includes a semiconductor layer, a first conductive layer, a second conductive layer, a third conductive layer, and a fourth conductive layer sequentially stacked on the base substrate.

The semiconductor layer includes at least: an active pattern of at least one transistor of the plurality of transistors.

The first conductive layer includes at least: a gate electrode of at least one of the plurality of transistors and a first plate of at least one of a plurality of capacitors.

The second conductive layer includes at least: a second plate of at least one capacitor of the plurality of capacitors.

The third conductive layer includes at least: a first electrode and a second electrode of at least one transistor of the plurality of transistors.

The fourth conductive layer includes at least: at least one of a plurality of signal lines.

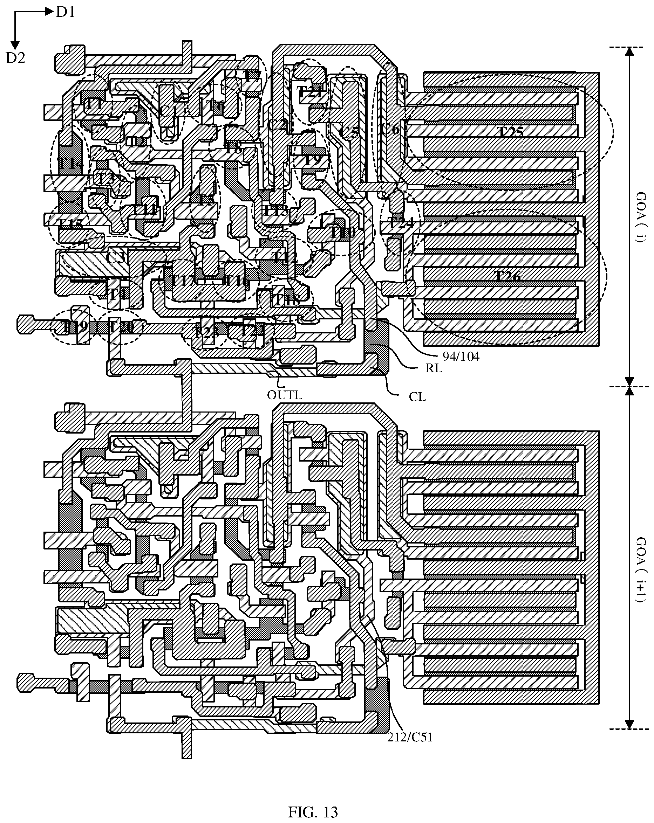

In an exemplary implementation, as shown in FIGS. 12 and 13, orthographic projections of all transistors (the seventeenth transistor T17 to the twenty-sixth transistor T26) and all capacitors (the fifth capacitor C5 and the sixth capacitor C6) included in an output sub-circuit on the base substrate are around one side of orthographic projections of all transistors (the first transistor T1 to the sixteenth transistor T16) and the first capacitor C1 to the third capacitor C3 included in a shift sub-circuit on the base substrate, and are located on a side of the shift sub-circuit close to the display area.

In an exemplary implementation, as shown in FIGS. 12 and 13, the seventeenth transistor T17 to the twentieth transistor T20, the twenty-second transistor T22, and the twenty-third transistor T23 are located on a side of some transistors in the shift sub-circuit close to a next stage of shift register, the twenty-first transistor T21 and the twenty-fourth transistor T24 are located on a side of some transistors in the shift sub-circuit close to the display area, and the twenty-fifth transistor T25 and the twenty-sixth transistor T26 are located on a side of at least one of the first transistor T1 to the twenty-fourth transistor T24 close to the display area.

In an exemplary implementation, as shown in FIG. 12, when the shift sub-circuit includes the fourth capacitor C4, the orthographic projections of all the transistors included in the output sub-circuit on the base substrate are around at least one side of an orthographic projection of the fourth capacitor C4 on the base substrate. The fourth capacitor C4 is located on a side of the twenty-fourth transistor T24 close to the next stage of shift register, on a side of the seventeenth transistor T17 to the twentieth transistor T20, the twenty-second transistor T22 and the twenty-third transistor T23 close to the display area, and on a side of the twenty-fifth transistor T25 and the twenty-sixth transistor T26 away from the display area.

In the exemplary implementation, as shown in FIGS. 8 and 13, when the shift register includes the first transistor T1 to the twenty-sixth transistor T26 and the first capacitor C1 to the third capacitor C3, the display substrate further includes N voltage stabilization connection lines RL, N cascaded connection lines CL and N cascaded output lines OUTL. A second electrode 94 of the ninth transistor T9 and a second electrode 104 of the tenth transistor T10 in the shift register are formed into an integral structure, and a gate electrode 212 of the twenty-first transistor T21 and the first plate C51 of the fifth capacitor C5 are formed into an integral structure. Among them, an n-th voltage stabilization connection line RL is respectively connected with an n-th cascaded connection line CL and an integral structure of a second electrode of a ninth transistor T9 and a second electrode of a tenth transistor T10 in an n-th stage of shift register, and an n-th cascaded output line OUTL is respectively connected with the n-th cascaded connection line CL and a first electrode of a first transistor T1 of an (n+1)-st stage of shift register, where 1≤n≤N, and N is a total number of stages of the shift registers.

In an exemplary implementation, as shown in FIGS. 8 and 13, for at least one stage of shift register, an orthographic projection of the integral structure of the second electrode of the ninth transistor T9 and the second electrode of the tenth transistor T10 on the base substrate is at least partially overlapped with an orthographic projection of the integral structure of the gate electrode of the twenty-first transistor T21 and the first plate C51 of the fifth capacitor C5 on the base substrate.

In an exemplary implementation, the voltage stabilization connection lines RL are located in the semiconductor layer, the cascaded output lines OUTL are located in the second conductive layer, and the cascaded connection lines CL are located in the third conductive layer.

In an exemplary implementation, a line width of a voltage stabilization connection line RL is greater than a line width of a cascaded connection line and greater than a line width of a cascaded output line.

In an exemplary implementation, a range of a resistance value of the voltage stabilization connection line RL is from 500 ohms to 5000 ohms.

In the exemplary implementation, the arrangement of the voltage stabilization connection line RL may increase a load of a connection structure connecting the integral structure of the second electrode of the ninth transistor T9 and the second electrode of the tenth transistor T10 in the n-th shift register with the first electrode of the first transistor T1 in the (n+1)-st shift register, and can ensure a stability of a signal transmitted between the integral structure of the second electrode of the ninth transistor T9 and the second electrode of the tenth transistor T10 in the n-th shift register and the first electrode of the first transistor T1 in the (n+1)-st shift register.

In an exemplary implementation, as shown in FIGS. 7, 9, 10, 11 and 12, when the shift register includes the first transistor T1 to the twenty-sixth transistor T26 and the first capacitor C1 to the fourth capacitor C4, the display substrate further includes N cascaded output lines OUTL. The second electrode of the ninth transistor T9 and the second electrode of the tenth transistor T10 in the shift register are formed into an integral structure, and the gate electrode of the twenty-first transistor T21 and the first plate of the fifth capacitor are formed into an integral structure. An integral structure of a second electrode of a ninth transistor T9 and a second electrode of a tenth transistor T10 in an ni-th shift register is respectively connected with an i-th cascaded output line OUTL and a second plate C42 of a fourth capacitor C4 in the n-th shift register.

In an exemplary implementation, as shown in FIGS. 7, 9, 10, 11 and 12, for at least one stage of shift register, there is no overlapping area between an orthographic projection of a second electrode of a ninth transistor T9 and a second electrode of a tenth transistor T10 on the base substrate and an orthographic projection of a gate electrode of a twenty-first transistor T21 and a first plate of a fifth capacitor on the base substrate.

In an exemplary implementation, as shown in FIGS. 7, 9, 10, 11 and 12, the cascaded output lines are located in the second conductive layer.

In an exemplary implementation, as shown in FIGS. 7 to 11, the display substrate further includes N-1 node connection lines NL, and a second electrode of the sixth transistor T6 and a first electrode of the seventh transistor T7 in the shift register are formed into an integral structure. Among them, an i-th node connection line NL(i) is connected with an integral structure of a second electrode 64 of a sixth transistor T6 and a first electrode 73 of a seventh transistor T7 in an i-th shift register GOA(i) and a gate electrode 192 of a nineteenth transistor T19 of an (i+1)-st shift register GOA(i+1) respectively, where 1≤i≤N-1.

In an exemplary implementation, as shown in FIGS. 7 and 8, a node connection line includes a first node connection line and a second node connection line arranged in different layers. For the i-th node connection line NL(i), a first node connection line NL1(i) is connected with the second node connection line NL2(i) and the integral structure of the second electrode 64 of the sixth transistor T6 and the first electrode 73 of the seventh transistor T7 in the i-th stage of shift register GOA(i) respectively, and the second node connection line NL1(i) is electrically connected with the gate electrode 192 of the nineteenth transistor T19 of the (i+1)-st stage of shift register GOA(i+1).

In an exemplary implementation, as shown in FIGS. 7 and 8, at least one of the first node connection line and the second node connection line extends at least partially in the second direction D2.

In an exemplary implementation, as shown in FIGS. 7 and 8, there is no overlapping area between an orthographic projection of the first node connection line on the base substrate and an orthographic projection of at least one of the plurality of signal lines on the base substrate. An orthographic projection of the second node connection line on the base substrate is at least partially overlapped with orthographic projections of some of the plurality of signal lines on the base substrate, and an orthographic projection of a part of the second node connection line on the base substrate is at least partially overlapped with an orthographic projection of a first signal line on the base substrate, wherein the first signal line is a signal line of the plurality of signal lines away from the display area.

In an exemplary implementation, as shown in FIGS. 7 and 8, the first node connection line is located in the fourth conductive layer, and the second node connection line is located in the third conductive layer.

In an exemplary implementation, as shown in FIG. 9, a node connection line includes a first node connection portion and a second node connection portion, and the first node connection portion and the second node connection portion are formed into an integral structure. For the i-th node connection line NL(i), the first node connection portion NLA(i) is connected with the integral structure of the second electrode 64 of the sixth transistor T6 and the first electrode 73 of the seventh transistor T7 in the i-th stage of shift register GOA(i) and a second node connection portion NLB(i) respectively, and the second node connection portion NLB(i) is electrically connected with the gate electrode 192 of the nineteenth transistor T19 in the (i+1)-st stage of shift register GOA(i+1).

In an exemplary implementation, as shown in FIG. 9, the first node connection portion extends at least partially in the second direction D2, and the second node connection portion extends at least partially in the first direction D1. An orthographic projection of the second node connection portion on the base substrate is at least partially overlapped with orthographic projections of some of the plurality of signal lines on the base substrate. An orthographic projection of a part of the second node connection portion on the base substrate is located on a side of an orthographic projection of a first signal line on the base substrate close to the display area. The first signal line is a signal line of the plurality of signal lines away from the display area. The arrangement of the node connection lines may reduce coupling capacitors between the node connection lines and the signal lines, avoid the signals of the node connection lines from being disturbed, and improve reliability of the display substrate.

In an exemplary implementation, as shown in Fig. 9, the orthographic projection of the first node connection portion on the base substrate may be at least partially overlapped with the orthographic projections of some of the plurality of signal lines on the base substrate.

In an exemplary implementation, as shown in FIG. 9, the drive structure layer further includes: a fifth conductive layer located on a side of the fourth conductive layer away from the base substrate, and the node connection lines are located in the fifth conductive layer.

In an exemplary implementation, as shown in FIG. 10, a node connection line includes a first node connection line and a second node connection line disposed in different layers. For the i-th node connection line NL(i), a first node connection line NL1(i) is connected with the integral structure of the second electrode 64 of the sixth transistor T6 and the first electrode 73 of the seventh transistor T7 in the i-th stage of shift register GOA(i) and a second node connection line NL2(i) respectively, and the second node connection line NL2(i) is electrically connected with the gate electrode 192 of the nineteenth transistor T19 of the (i+1)-st stage of shift register GOA(i+1).

In an exemplary implementation, as shown in FIG. 10, the first node connection line extends at least partially in the second direction D2, and the second node connection line extends at least partially in the first direction D1. An orthographic projection of the second node connection line on the base substrate is at least partially overlapped with orthographic projections of some of the plurality of signal lines on the base substrate. An orthographic projection of a part of the second node connection line on the base substrate is on a side of an orthographic projection of a first signal line on the base substrate close to the display area. The first signal line is a signal line of the plurality of signal lines away from the display area. The arrangement of the node connection lines may reduce coupling capacitors between the node connection lines and the signal lines, avoid the signals of the node connection lines from being disturbed, and improve the reliability of the display substrate.

In an exemplary implementation, as shown in FIG. 10, the orthographic projection of the first node connection line on the base substrate may be at least partially overlapped with the orthographic projections of some of the plurality of signal lines on the base substrate.

In an exemplary implementation, as shown in FIG. 10, the drive structure layer further includes: a fifth conductive layer located on a side of the fourth conductive layer away from the base substrate. The first node connection line is located in the fifth conductive layer, and the second node connection line is located in the third conductive layer.

In an exemplary implementation, as shown in FIG. 11, a node connection line includes a first node connection line, a second node connection line, and a third node connection line disposed in different layers. For the i-th node connection line NL(i), a first node connection line NL1(i) is connected with the integral structure of the second electrode 64 of the sixth transistor T6 and the first electrode 73 of the seventh transistor T7 in the i-th stage of shift register GOA(i) and a third node connection line NL3(i) respectively, and the second node connection line NL2(i) is electrically connected with the gate electrode 192 of the nineteenth transistor T19 of the (i+1)-st stage of shift register GOA(i+1).

In an exemplary implementation, as shown in FIG. 11, the first node connection line and the third node connection line extend at least partially in the second direction D2, and the second node connection line extends at least partially in the first direction D1. There is no overlapping area between an orthographic projection of the third node connection line on the base substrate and an orthographic projection of at least one of the plurality of signal lines on the base substrate. An orthographic projection of the second node connection line on the base substrate is at least partially overlapped with orthographic projections of some of the plurality of signal lines on the base substrate. An orthographic projection of a part of the second node connection line on the base substrate is located on a side of an orthographic projection of a first signal line on the base substrate close to the display area. The first signal line is a signal line of the plurality of signal lines away from the display area. The arrangement of the node connection lines may reduce coupling capacitors between the node connection lines and the signal lines, avoid the signals of the node connection lines from being disturbed, and improve the reliability of the display substrate.

In an exemplary implementation, as shown in FIG. 11, the drive structure layer further includes: a fifth conductive layer located on a side of the fourth conductive layer away from the base substrate. The first node connection line is located in the fifth conductive layer, the third node connection line is located in the fourth conductive layer, and the second node connection line is located in the third conductive layer.

In an exemplary implementation, as shown in FIGS. 7 to 11, the plurality of signal lines include a latch signal line MSL, a second clock signal line CLK2, a first clock signal line CLK1, a first power supply line VGL-1, a second power supply line VGH-1, a third power supply line VGL-2, a fourth power supply line VCX, a fifth power supply line VGL-3, a sixth power supply line VGH-2, a seventh power supply line VGH-3, an eighth power supply line VGH-4, and a ninth power supply line VGL-4 disposed sequentially along the display area. Among them, the latch signal line MSL is configured to provide a signal to a latch signal terminal to which a shift register is connected, and at least one of the first power supply line VGL-1, the third power supply line VGL-2, the fifth power supply line VGL-3, and the ninth power supply line VGL-4 is configured to provide a signal to a second power supply terminal or a fourth power supply terminal to which a shift register is connected. The second power supply line VGH-1, the sixth power supply line VGH-2, the seventh power supply line VGH-3, and the eighth power supply line VGH-4 are configured to provide signals to the first power supply terminal and the third power supply terminal to which a shift register is connected, and the fourth power supply line VCX is configured to provide a signal to the fifth power supply terminal to which a shift register is connected. The seventh power supply line VGH-3 is configured to provide a signal to a third power supply terminal to which an i-th shift register is connected, and the eighth power supply line VGH-4 is configured to provide a signal to a third power supply terminal to which an (i+1)-st shift register is connected.

In an exemplary implementation, a first power supply line to which some of the transistors in the shift sub-circuit are connected and a first power supply line to which some of the transistors in the output sub-circuit are connected are separately provided. A second power supply line to which some of the transistors in the shift sub-circuit and a second power supply line to which some of the transistors in the output sub-circuit are connected are separately provided, so that independent regulation of the shift sub-circuit and the output sub-circuit can be achieved.

In an exemplary implementation, the seventh power supply line VGH-3 is configured to provide a signal to a third power supply terminal connected with the i-th stage of shift register, and the eighth power supply line VGH-4 is configured to provide a signal to a third power supply terminal connected with the (i+1)-st stage of shift register. Third power supply terminals connected with adjacent stage of shift registers are connected with different power supply lines, which can improve output stability of high level signals of the adjacent shift registers, thereby improving the reliability of the display substrate.

In an exemplary implementation, an orthographic projection of the latch signal line MSL on the base substrate is located on a side of orthographic projections of the plurality of transistors in the shift registers on the base substrate away from the display area, and an orthographic projection of at least one of the first clock signal line CLK1, the second clock signal line CLK2, the first power supply line VGL-1, the second power supply line VGH-1, the third power supply line VGL-2, the fourth power supply line, the fifth power supply line VGL-3, the sixth power supply line VGH-2, the seventh power supply line VGH-3, the eighth power supply line VGH-4, and the ninth power supply line VGL-4 on the base substrate is at least partially overlapped with orthographic projections of some of transistors in the shift registers on the base substrate. The above signal lines are disposed in such a manner that an area occupied by the gate drive circuit and the signal lines connected thereto can be reduced, and a narrow bezel of the display substrate can be realized.

In an exemplary implementation, signals of at least two of the second power supply line VGH-1, the sixth power supply line VGH-2, the seventh power supply line VGH-3, and the eighth power supply line VGH-4 are the same, or, signals of the second power supply line VGH-1 and the sixth power supply line VGH-2 are the same, signals of the seventh power supply line VGH-3 and the eighth power supply line VGH-4 are the same, and voltage values of signals of the second power supply line VGH-1 and the seventh power supply line VGH-3 are different, or, signals of the sixth power supply line VGH-2, the seventh power supply line VGH-3 and the eighth power supply line VGH-4 are the same, and voltage values of signals of the second power supply line VGH-1 and the sixth power supply line VGH-2 are different.

In an exemplary implementation, signals of at least two of the first power supply line VGL-1, the third power supply line VGL-2, the fifth power supply line VGL-3, and the ninth power supply line VGL-4 are the same, or, signals of at least two of the first power supply line VGL-1, the third power supply line VGL-2, and the fifth power supply line VGL-3 are the same and are different from a signal of the ninth power supply line VGL-4.

In an exemplary implementation, the display substrate further includes a light emitting structure layer located on a side of the drive circuit layer away from the base substrate. Among them, the light emitting structure layer may include an anode, a pixel definition layer, an organic light emitting layer, and a cathode. The anode is connected with the pixel drive circuit through a via, the organic emitting layer is connected with the anode, the cathode is connected with the organic emitting layer, and the organic emitting layer emits light of a corresponding color under drive of the anode and the cathode.

In an exemplary implementation, the display substrate may further include an encapsulation structure layer located on a side of the light emitting structure layer away from the base substrate. Among them, the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer, which may ensure that external moisture cannot enter the light emitting structure layer.

In an exemplary implementation, the display substrate may further include a touch structure layer located on a side of the encapsulation structure layer away from the base substrate. Among them, the touch structure layer may include a first touch insulation layer disposed on the encapsulation structure layer, a first touch metal layer disposed on the first touch insulation layer, a second touch insulation layer covering the first touch metal layer, a second touch metal layer disposed on the second touch insulation layer and a touch protection layer covering the second touch metal layer. The first touch metal layer may include a plurality of bridge electrodes, the second touch metal layer may include a plurality of first touch electrodes and second touch electrodes, and the first touch electrodes or the second touch electrodes may be connected with the bridge electrodes through vias.

In an exemplary implementation, the display substrate according to the present disclosure may be applied to a display device with a gate drive circuit, such as an OLED, a quantum dot display (QLED), a light emitting diode display (Micro LED or Mini LED), or a Quantum Dot Light Emitting Diode display (QDLED), etc., which is not limited here in the present disclosure.

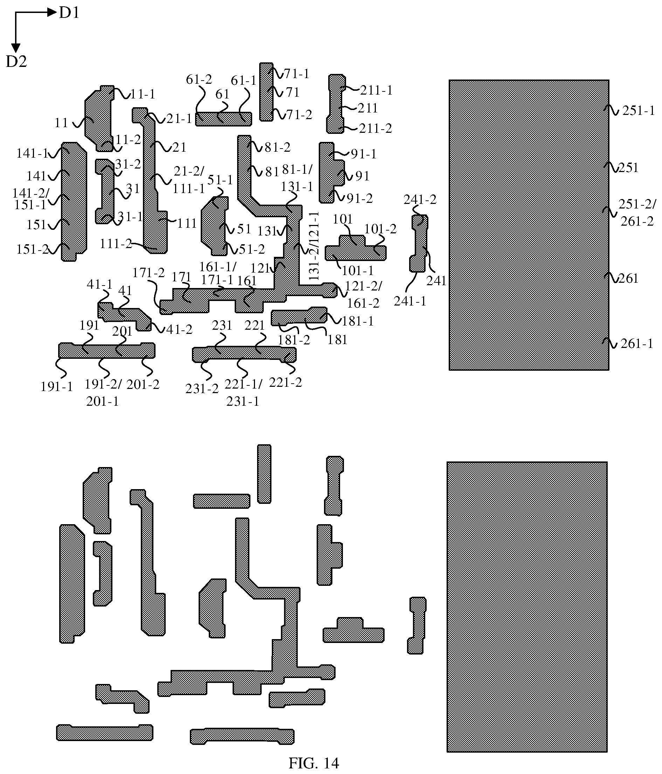

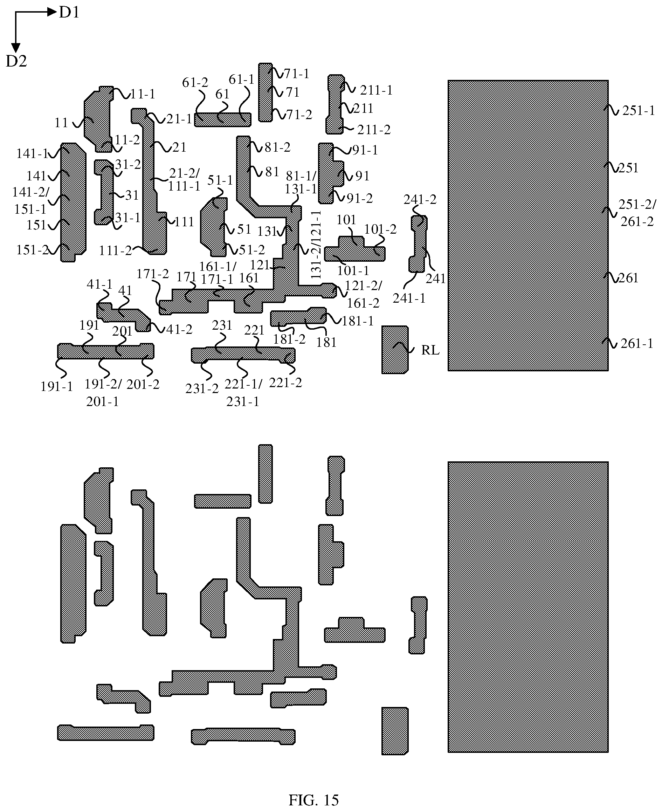

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are arranged in a same layer" in the present disclosure means that A and B are formed simultaneously through a same patterning process, and a "thickness" of a film layer is a dimension of the film layer in a direction perpendicular to a display substrate. In an exemplary implementation of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A coincides with the boundary of the orthographic projection of B.
(1) A pattern of a semiconductor layer is formed on a base substrate. In an exemplary implementation, forming the pattern of the semiconductor layer on a base substrate may include: depositing a semiconductor thin film on the base substrate, patterning the semiconductor thin film by a patterning process to form the pattern of the semiconductor layer. As shown in FIGS. 14 and 15, FIG. 14 is a schematic diagram of the display substrate according to FIGS. 7, 9 to 11 after the pattern of the semiconductor layer is formed, and FIG. 15 is a schematic diagram of the display substrate according to FIG. 8 after the pattern of the semiconductor layer is formed.

In an exemplary implementation, as shown in FIG. 14, the pattern of the semiconductor layer in the display substrate according to FIGS. 7, 9 to 11 may include at least an active pattern 11 of a first transistor to an active pattern 231 of a twenty-sixth transistor located in each stage of shift register.

In an exemplary implementation, as shown in FIG. 15, the pattern of the semiconductor layer in the display substrate according to FIG. 8 may include at least an active pattern 11 of a first transistor to an active pattern 231 of a twenty-sixth transistor located in each stage of shift register and a stabilization connection line RL.

In an exemplary implementation, as shown in FIGS. 14 and 15, an active pattern 21 of a second transistor and an active pattern 111 of an eleventh transistor are formed into an integral structure. An active pattern 81 of an eighth transistor, an active pattern 121 of a twelfth transistor, active pattern 131 of a thirteenth transistor, an active pattern 161 of a sixteenth transistor and an active pattern 171 of a seventeenth transistor are formed into an integral structure. An active pattern 141 of a fourteenth transistor and an active pattern 151 of a fifteenth transistor are formed into an integral structure. An active pattern 191 of a nineteenth transistor and an active pattern 201 of a twentieth transistor are formed into an integral structure. An active pattern 221 of a twenty-second transistor and an active pattern 231 of a twenty-third transistor are formed into an integral structure. An active pattern 251 of a twenty-fifth transistor and the active pattern 261 of the twenty-sixth transistor are formed into an integral structure. The active pattern 11 of the first transistor, an active pattern 31 of a third transistor, an active pattern 41 of a fourth transistor, an active pattern 51 of a fifth transistor, an active pattern 61 of a sixth transistor, an active pattern 71 of a seventh transistor, an active pattern 91 of a ninth transistor, an active pattern 101 of a tenth transistor, an active pattern 181 of an eighteenth transistor, an active pattern 211 of a twenty-first transistor and an active pattern 241 of a twenty-fourth transistor are separately disposed.

In an exemplary implementation, as shown in FIG. 15, the stabilization connection line RL is separately disposed.

In an exemplary implementation, as shown in FIGS. 14 and 15, the active pattern 11 of the first transistor is located on a side of an integral structure of the active pattern 141 of the fourteenth transistor and the active pattern 151 of the fifteenth transistor close to the display area, and is arranged in the second direction D2 with the active pattern 31 of the third transistor. An active pattern 31 of a third transistor of a current stage of shift register is located on a side of an active pattern 11 of a first transistor close to a next stage of shift register. The integral structure of the active pattern 21 of the second transistor and the active pattern 111 of the eleventh transistor is located on a side of the active pattern 31 of the third transistor close to the display area. The active pattern 51 of the fifth transistor and the active pattern 61 of the sixth transistor are located on a side of the integral structure of the active pattern 21 of the second transistor and the active pattern 111 of the eleventh transistor close to the display area. The active pattern 51 of the fifth transistor in the current stage of shift register is located on a side of the active pattern 61 of the sixth transistor close to the next stage of shift register. The active pattern 71 of the seventh transistor is located on a side of the active pattern 61 of the sixth transistor close to the display area. The active pattern 211 of the twenty-first transistor is located on a side of the active pattern 71 of the seventh transistor close to the display area. The integral structure of the active pattern 81 of the eighth transistor, the active pattern 121 of the twelfth transistor, the active pattern 131 of the thirteenth transistor, the active pattern 161 of the sixteenth transistor, and the active pattern 171 of the seventeenth transistor are located on a side of the active pattern 51 of the fifth transistor close to the display area. The active pattern 91 of the ninth transistor and the active pattern 101 of the tenth transistor are located on a side of the integral structure of the active pattern 81 of the eighth transistor, the active pattern 121 of the twelfth transistor, the active pattern 131 of the thirteenth transistor, the active pattern 161 of the sixteenth transistor, and the active pattern 171 of the seventeenth transistor close to the display area. The active pattern 241 of the twenty-fourth transistor is located on a side of the active pattern 101 of the tenth transistor and the active pattern 181 of the eighteenth transistor close to the display area. The active pattern 41 of the fourth transistor is located on a side of the active pattern 31 of the third transistor in the current stage of shift register close to the next stage of shift register. The integral structure of the active pattern 191 of the nineteenth transistor and the active pattern 201 of the twentieth transistor in the current stage of shift register are located on a side of the active pattern 41 of the fourth transistor close to the next stage of shift register. The integral structure of the active pattern 221 of the twenty-second transistor and the active pattern 231 of the twenty-third transistor is located on a side of the integral structure of the active pattern 191 of the nineteenth transistor and the active pattern 201 of the twentieth transistor close to the display area, and are arranged in the first direction D1 with the integral structure of the active pattern 191 of the nineteenth transistor and the active pattern 201 of the twentieth transistor. The active pattern 181 of the eighteenth transistor is located on a side of the active pattern 41 of the fourth transistor close to the display area. The integral structure of the active pattern 251 of the twenty-fifth transistor and the active pattern 261 of the twenty-sixth transistor is located on a side of the active pattern 241 of the twenty-fourth transistor close to the display area.

In an exemplary implementation, as shown in FIG. 15, the voltage stabilization connection line RL is located between the integral structure of the active pattern 221 of the twenty-second transistor and the active pattern 231 of the twenty-third transistor and the integral structure of the active pattern 251 of the twenty-fifth transistor and the active pattern 261 of the twenty-sixth transistor, and is located on a side of the active pattern 241 of the twenty-fourth transistor of in the current stage of shift register close to the next stage of shift register.

In an exemplary implementation, at least one of the active pattern 11 of the first transistor, the integral structure of the active pattern 21 of the second transistor and the active pattern 111 of the eleventh transistor, the active pattern 31 of the third transistor, the active pattern 51 of the fifth transistor, the active pattern 71 of the seventh transistor, the active pattern 91 of the ninth transistor, the integral structure of the active pattern 141 of the fourteenth transistor and the active pattern 151 of the fifteenth transistor, the active pattern 211 of the twenty-first transistor, the active pattern 241 of the twenty-fourth transistor, the integral structure of the active pattern 251 of the twenty-fifth transistor and the active pattern 261 of the twenty-sixth transistor is in a shape of a strip, and extends in the second direction D2.

In an exemplary implementation, at least one of the active pattern 41 of the fourth transistor, the active pattern 61 of the sixth transistor, the active pattern 101 of the tenth transistor, the active pattern 181 of the eighteenth transistor, the integral structure of the active pattern 191 of the nineteenth transistor and the active pattern 201 of the twentieth transistor, the integral structure of the active pattern 221 of the twenty-second transistor and the active pattern 231 of the twenty-third transistor is in a shape of a strip, and extends in the first direction D1.

In an exemplary implementation, a shape of the integral structure of the active pattern 81 of the eighth transistor, the active pattern 121 of the twelfth transistor, the active pattern 131 of the thirteenth transistor, the active pattern 161 of the sixteenth transistor, and the active pattern 171 of the seventeenth transistor is an inverted "T".

In an exemplary implementation, the voltage stabilization connection line RL is in a shape of a strip, and extends in the second direction D2.

In an exemplary implementation, an active pattern of each transistor may include a first region, a second region, and a channel region located between the first region and the second region. In an exemplary implementation, a second region 21-2 of the active pattern 21 of the second transistor may be served as a first region 111-1 of the active pattern 111 of the eleventh transistor. A first region 81-1 of the active pattern 81 of the eighth transistor may be served as a first region 131-1 of the active pattern 131 of the thirteenth transistor. A first region 121-1 of the active pattern 121 of the twelfth transistor may be served as a second region 131-2 of the active pattern 131 of the thirteenth transistor. A second region 121-2 of the active pattern 121 of the twelfth transistor may be served as a second region 161-2 of the active pattern 161 of the sixteenth transistor. A second region 141-2 of the active pattern 141 of the fourteenth transistor may be served as a first region 151-1 of the active pattern 151 of the fifteenth transistor. A first region 161-1 of the active pattern 161 of the sixteenth transistor may be served as a first region 171-1 of the active pattern 171 of the seventeenth transistor. A second region 191-2 of the active pattern 191 of the nineteenth transistor may be served as a first region 201-1 of the active pattern of the twentieth transistor. A first region 221-1 of the active pattern 221 of the twenty-second transistor may be served as a first region 231-1 of the active pattern 231 of the twenty-third transistor. A second region 251-2 of the active pattern of the twenty-fifth transistor may be served as a second region 261-2 of the active pattern of the twenty-sixth transistor. A first region 11-1 and a second region 11-2 of the active pattern 11 of the first transistor, a first region 21-1 of the active pattern 21 of the second transistor, a first region 31-1 and a second region 31-2 of the active pattern 31 of the third transistor, a first region 41-1 and a second region 41-2 of the active pattern 41 of the fourth transistor, a first region 51-1 and a second region 51-2 of the active pattern 51 of the fifth transistor, a first region 61-1 and a second region 61-2 of the active pattern 61 of the sixth transistor, a first region 71-1 and a second region 71-2 of the active pattern 71 of the seventh transistor, a second region 81-2 of the active pattern 81 of the eighth transistor, a first region 91-1 and a second region 91-2 of the active pattern 91 of the ninth transistor, a first region 101-1 and a second region 101-2 of the active pattern 101 of the tenth transistor, a second region 111-2 of the active pattern 111 of the eleventh transistor, a second region 131-2 of the active pattern 131 of the thirteenth transistor, a first region 141-1 of the active pattern 141 of the fourteenth transistor, a second region 151-2 of the active pattern 151 of the fifteenth transistor, a second region 171-2 of the active pattern 171 of the seventeenth transistor 1, a first region 181-1 and a second region 181-2 of the active pattern 181 of the eighteenth transistor, a first region 191-1 of the active pattern 191 of the nineteenth transistor, a second region 201-2 of the active pattern of the twentieth transistor, a first region 211-1 and a second region 211-2 of the active pattern 211 of the twenty-first transistor, a second region 221-2 of the active pattern 221 of the twenty-second transistor, the first region 231-1 of the active pattern 231 of the twenty-third transistor , a first region 241-1 and a second region 241-2 of the active pattern of the twenty-fourth transistor, a first region 251-1 of the active pattern of the twenty-fifth transistor, and a first region 261-1 of the active pattern of the twenty-sixth transistor are disposed separately.

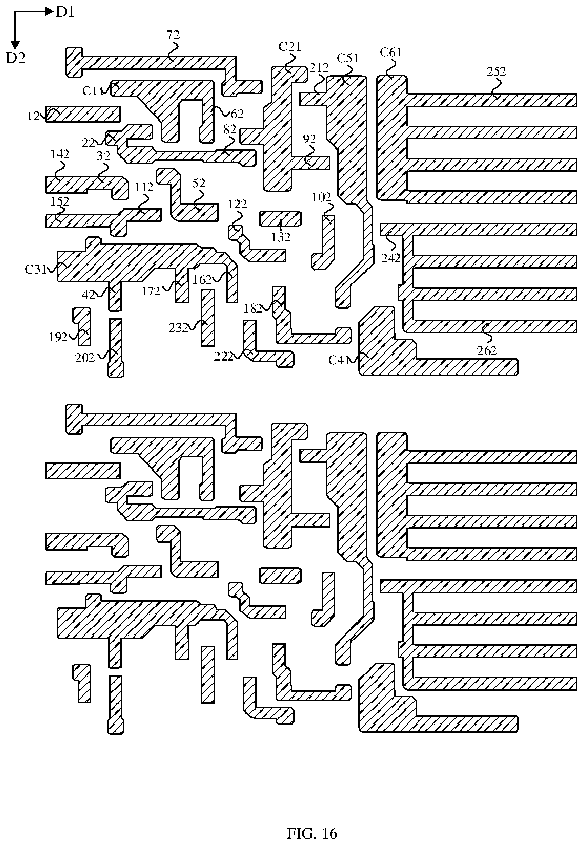

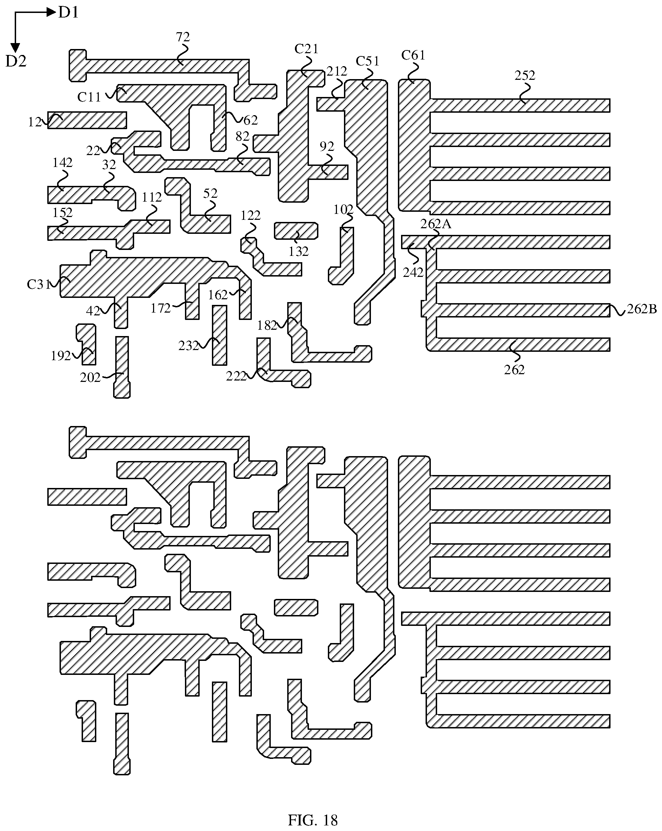

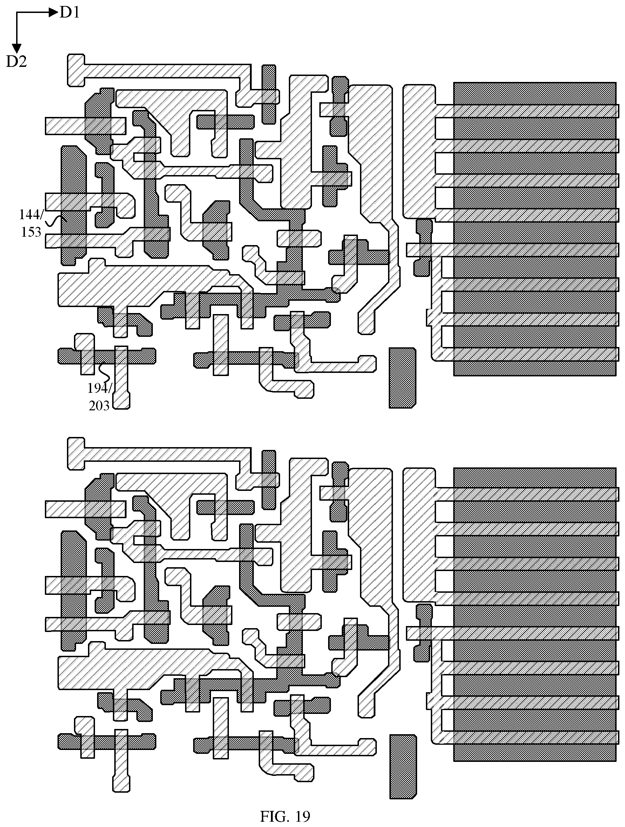

(2) A pattern of a first conductive layer is formed. In an exemplary implementation, forming the pattern of the first conductive layer may include depositing a first insulation thin film and a first conductive thin film on the base substrate on which the aforementioned patterns are formed, patterning the first conductive thin film through a patterning process, to form a first insulation layer covering the pattern of the semiconductor layer, and the pattern of the first conductive layer disposed on the first insulation layer, as shown in FIGS. 16 to 19. FIG. 16 is a schematic diagram of a pattern of a first conductive layer in the display substrate according to FIGS. 7, 9 to 11, FIG. 17 is a schematic diagram of the display substrate according to FIGS. 7, 9 to 11 after a pattern of a first conductive layer is formed, FIG. 18 is a schematic diagram of a pattern of a first conductive layer in the display substrate according to FIG. 8, and FIG. 19 is a schematic diagram of the display substrate according to FIG. 8 after a pattern of a first conductive layer is formed. In an exemplary implementation, the first conductive layer may be referred to as a first gate metal (GATE1) layer.

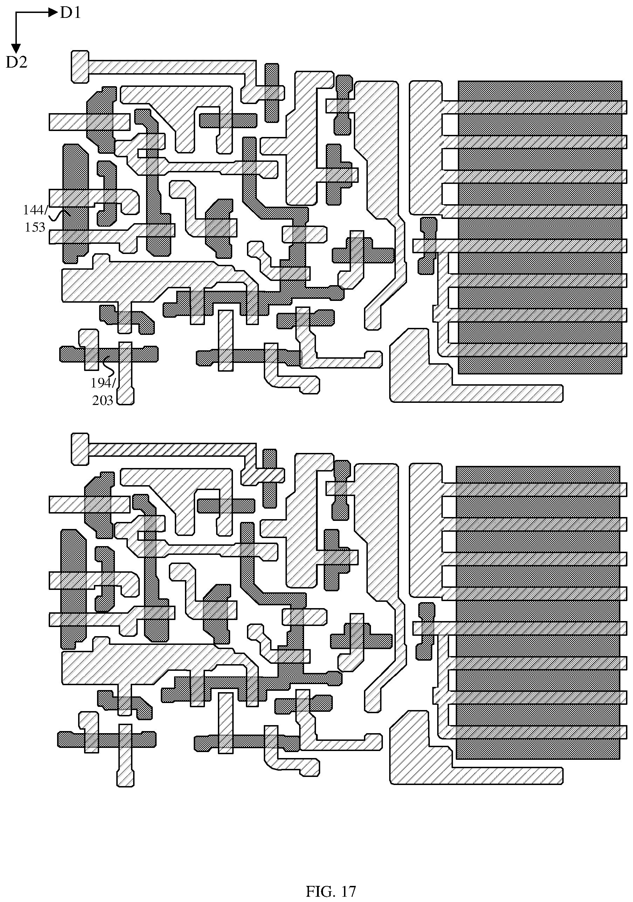

In an exemplary implementation, as shown in FIGS. 16 and 17, the pattern of the first conductive layer in the display substrate according to FIGS. 7, 9 to 11 may include at least a gate electrode 12 of a first transistor to a gate electrode 262 of a twenty-sixth transistor, a first plate C11 of a first capacitor to a first plate C61 of a sixth capacitor located in each stage of shift register.

In an exemplary implementation, as shown in FIGS. 18 and 19, the pattern of the first conductive layer in the display substrate according to FIG. 8 may include at least the gate electrode 12 of the first transistor to the gate electrode 262 of the twenty-sixth transistor, the first plate C11 of the first capacitor to a first plate C31 of a third capacitor, a first plate C51 of a fifth capacitor, and a first plate C61 of a sixth capacitor located in each stage of shift register.

In an exemplary implementation, the gate electrode 12 of the first transistor is disposed separately. The gate electrode 12 of the first transistor is a shape of a strip, and extends in the first direction D1.

In an exemplary implementation, a gate electrode 22 of the second transistor and a gate electrode 82 of the eighth transistor are formed into an integral structure. The gate electrode 22 of the second transistor may have a shape of letter "n" with an opening facing the display area, and the gate electrode 82 of the eighth transistor may have a polyline shape and extends at least partially in the first direction D1.

In an exemplary implementation, a gate electrode 32 of the third transistor and a gate electrode 142 of the fourteenth transistor are formed into an integral structure. The integral structure of the gate electrode 32 of the third transistor and the gate electrode 142 of the fourteenth transistor may have a shape of a strip, and extend in the first direction D1.

In an exemplary implementation, a gate electrode 42 of the fourth transistor, a gate electrode 162 of the sixteenth transistor, a gate electrode 172 of the seventeenth transistor, and the first plate C31 of the third capacitor are formed into an integral structure. A shape of C31 of the third capacitor is rectangular. The gate electrode 42 of the fourth transistor and the gate electrode 172 of the seventeenth transistor in the current stage of shift register are located on a side of the third capacitor C31 close to the next stage of shift register, and the gate electrode 42 of the fourth transistor and the gate electrode 172 of the seventeenth transistor have a shape of a stripe, and extend in the second direction D2. The gate electrode 162 of the sixteenth transistor is located on a side of the first plate C31 of the third capacitor close to the display area, and the gate electrode 162 of the sixteenth transistor has a shape of "┐". The integral structure of the gate electrode 42 of the fourth transistor, the gate electrode 162 of the sixteenth transistor, the gate electrode 172 of the seventeenth transistor, and the first plate C31 of the third capacitor may have a shape of letter "m".

In an exemplary implementation, a gate electrode 52 of the fifth transistor is disposed separately. The gate electrode 52 of the fifth transistor may have a shape of " └‴.

In an exemplary implementation, a gate electrode 62 of the sixth transistor and the first plate C11 of the first capacitor are formed into an integral structure. The gate electrode 62 of the sixth transistor is located on a side of the first plate C11 of the first capacitor close to the display area. The first plate C11 of the first capacitor may have a shape of letter "T", and the gate electrode 62 of the sixth transistor may have a shape of a strip and extends at least partially in the second direction D2. The integral structure of the gate electrode 62 of the sixth transistor and the first plate C11 of the first capacitor may have a shape of letter "n".

In an exemplary implementation, a gate electrode 72 of the seventh transistor is disposed separately. The gate electrode 72 of the seventh transistor has a polyline shape and extends at least partially in the first direction D1. The gate electrode 72 of the seventh transistor is at least partially around one side of the first plate C11 disposed around the first capacitor.

In an exemplary implementation, a gate electrode 92 of the ninth transistor and a first plate C21 of a second capacitor are formed into an integral structure. The gate electrode 92 of the ninth transistor is located on a side of the first plate C21 of the second capacitor close to the display area. The gate electrode 92 of the ninth transistor and the first plate C21 of the second capacitor may have a shape of letter "F".

In an exemplary implementation, a gate electrode 102 of the tenth transistor is disposed separately. The gate electrode 102 of the tenth transistor has a shape of a strip and extends in the second direction D2.

In an exemplary implementation, a gate electrode 112 of the eleventh transistor and a gate electrode 152 of the fifteenth transistor are formed into an integral structure, and the gate electrode 112 of the eleventh transistor (also the gate electrode 152 of the fifteenth transistor) has a shape of a strip and extends in the first direction D1.

In an exemplary implementation, a gate electrode 122 of the twelfth transistor is disposed separately. The gate electrode 122 of the twelfth transistor may have a shape of a strip and extend at least partially in the first direction D1.

In an exemplary implementation, a gate electrode 132 of the thirteenth transistor is disposed separately. The gate electrode 132 of the thirteenth transistor has a shape of a strip and extends in the first direction D1.

In an exemplary implementation, a gate electrode 182 of the eighteenth transistor is disposed separately. The gate electrode 182 of the eighteenth transistor may have a shape of "└‴.

In an exemplary implementation, a gate electrode 192 of the nineteenth transistor is disposed separately. The gate electrode 192 of the nineteenth transistor has a shape of a strip and extends in the second direction D2.

In an exemplary implementation, a gate electrode 202 of the twentieth transistor is disposed separately, and the gate electrode 202 of the twentieth transistor may have a shape of a strip and extend in the second direction D2.

In an exemplary implementation, a gate electrode 212 of the twenty-first transistor and the first plate C51 of the fifth capacitor are formed into an integral structure. The gate electrode 212 of the twenty-first transistor is located on a side of the first plate C51 of the fifth capacitor away from the display area. The integral structure of the gate electrode 212 of the twenty-first transistor and the first plate C51 of the fifth capacitor has a shape of a strip and extends at least partially in the second direction D2.

In an exemplary implementation, a gate electrode 222 of the twenty-second transistor is disposed separately. The gate electrode 222 of the twenty-second transistor may have a shape of "└‴.

In an exemplary implementation, a gate electrode 232 of the twenty-third transistor is disposed separately, and the gate electrode 232 of the twenty-third transistor may have a shape of a strip and extend in the second direction D2.

In an exemplary implementation, a gate electrode 242 of the twenty-fourth transistor and the gate electrode 262 of the twenty-sixth transistor are formed into an integral structure. The gate electrode 242 of the twenty-fourth transistor is located on a side of the gate electrode 262 of the twenty-sixth transistor away from the display area. The integral structure of the gate electrode 242 of the twenty-fourth transistor and the gate electrode 262 of the twenty-sixth transistor has a "comb-like" structure in shape, whose comb teeth are located on a side of the comb back close to the display area.

In an exemplary implementation, a gate electrode 252 of the twenty-fifth transistor and the first plate C61 of the sixth capacitor are formed into an integral structure. The gate electrode 252 of the twenty-fifth transistor is located on a side of the first plate C61 of the sixth capacitor close to the display area. The integral structure of the gate electrode 252 of the twenty-fifth transistor and the first plate C61 of the sixth capacitor has a "comb-like" structure in shape, whose comb teeth are located on a side of the comb back close to the display area.

In an exemplary implementation, the first plate C1 of the fourth capacitor is disposed separately. The first plate C1 of the fourth capacitor may have a shape of "└".

In an exemplary implementation, the gate electrode 12 of the first transistor is disposed across the active pattern of the first transistor. The gate electrode 22 of the second transistor (also the gate electrode 82 of the eighth transistor) is disposed across the active pattern of the second transistor and the active pattern of the eighth transistor. The gate electrode 32 of the third transistor (also the gate electrode 142 of the fourteenth transistor) is disposed across the active pattern of the third transistor and the active pattern of the fourteenth transistor. The gate electrode 42 of the fourth transistor (also the first electrode C31 of the third capacitor, the gate electrode 162 of the sixteenth transistor and the gate electrode 172 of the seventeenth transistor) is disposed across the active pattern of the fourth transistor, the active pattern of the sixteenth transistor and the active pattern of the seventeenth transistor. The gate electrode 52 of the fifth transistor is disposed across the active pattern of the fifth transistor. The gate electrode 62 of the sixth transistor (also the first electrode C11 of the first capacitor) is disposed across the active pattern of the sixth transistor. The gate electrode 72 of the seventh transistor is disposed across the active pattern of the seventh transistor. The gate electrode 92 of the ninth transistor (also the first plate C21 of the second capacitor) is disposed across the active pattern of the ninth transistor. The gate electrode 102 of the tenth transistor is disposed across the active pattern of the tenth transistor. The gate electrode 112 of the eleventh transistor (also the gate electrode 152 of the fifteenth transistor) is disposed across the active pattern of the eleventh transistor and the active pattern of the fifteenth transistor. The gate electrode 122 of the twelfth transistor is disposed across the active pattern of the twelfth transistor. The gate electrode 132 of the thirteenth transistor is disposed across the active pattern of the thirteenth transistor. The gate electrode 182 of the eighteenth transistor is disposed across the active pattern of the eighteenth transistor. The gate electrode 192 of the nineteenth transistor is disposed across the active pattern of the nineteenth transistor. The gate electrode 202 of the twentieth transistor is disposed across the active pattern of the twentieth transistor. The gate electrode 212 of the twenty-first transistor (also the first plate C51 of the fifth capacitor) is disposed across the active pattern of the twenty-first transistor. The gate electrode 222 of the twenty-second transistor is disposed across the active pattern of the twenty-second transistor. The gate electrode 232 of the twenty-third transistor is disposed across the active pattern of the twenty-third transistor. The gate electrode 242 of the twenty-fourth transistor (also the gate electrode 262 of the twenty-sixth transistor) is disposed across the active pattern of the twenty-fourth transistor and the active pattern of the twenty-sixth transistor. The gate electrode 252 of the twenty-fifth transistor is disposed across the active pattern of the twenty-fifth transistor, that is, an extension direction of a gate electrode of at least one transistor is perpendicular to an extension direction of an active pattern.

In an exemplary implementation, after the pattern of the first conductive layer is formed, a conductive treatment may be performed on the semiconductor layer by using the first conductive layer as a shield. A region of the semiconductor layer, which is shielded by the first conductive layer, forms channel regions of the first transistor to the twenty-sixth transistor, and a region of the semiconductor layer, which is not shielded by the first conductive layer, is made to be conductive. That is to say, both a first region and a second region of an active pattern of any one of the first transistor to the twenty-sixth transistor are made to be conductive. As shown in FIGS. 17 and 19, the second region of the active pattern of the fourteenth transistor (also the first region of the active pattern of the fifteenth transistor) after the conductive treatment in the present disclosure is served as the second electrode 144 of the fourteenth transistor (also the first electrode 153 of the fifteenth transistor), and the second region of the active pattern of the nineteenth transistor (also the first region of the active pattern of the twentieth transistor) is served as the second electrode 194 of the nineteenth transistor (also the first electrode 203 of the twentieth transistor).

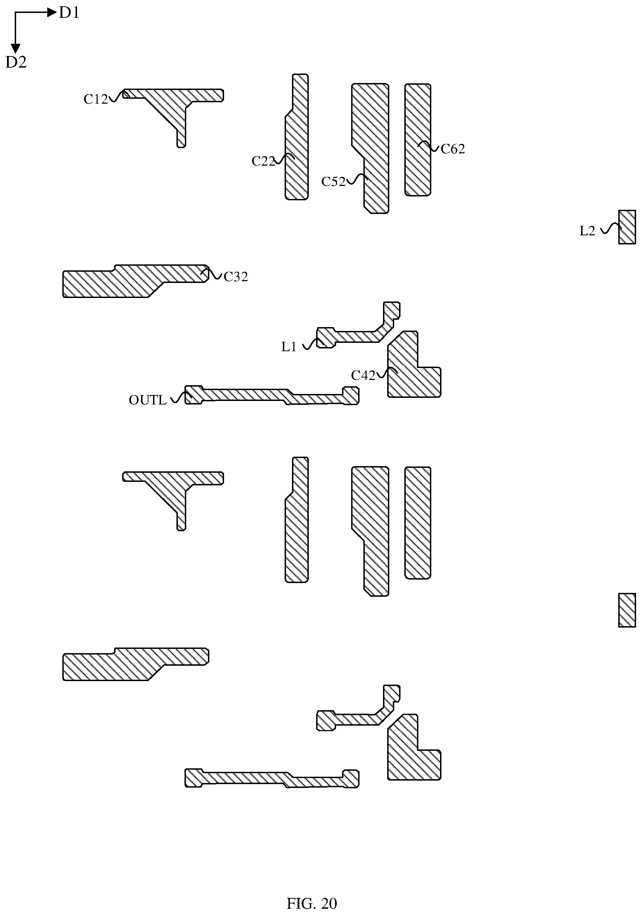

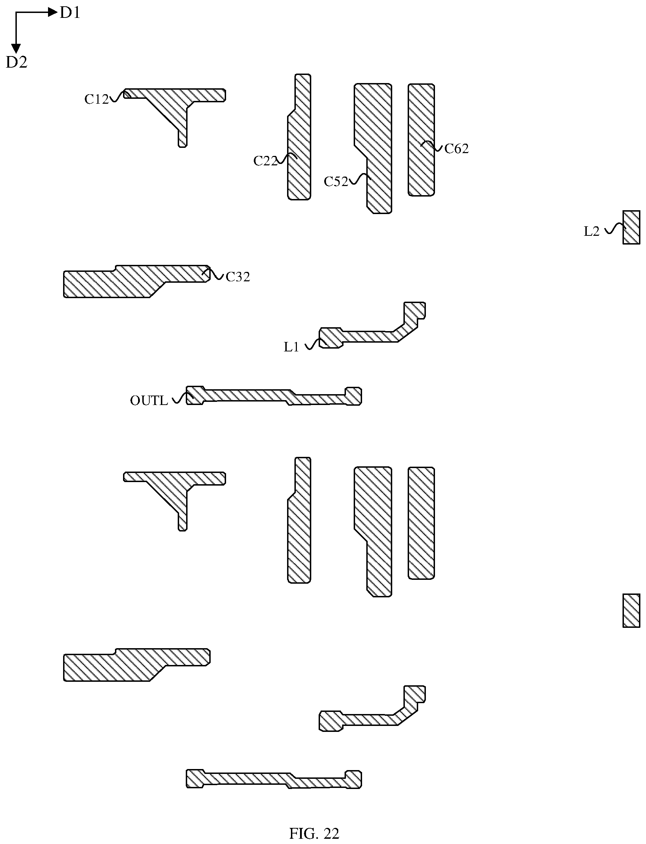

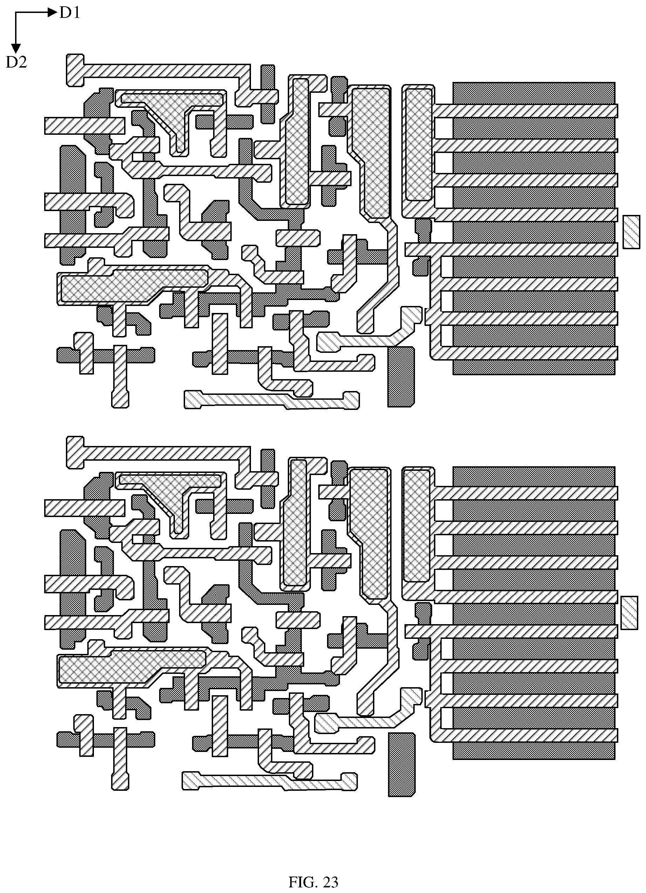

(3) A pattern of a second conductive layer is formed. In an exemplary implementation, forming the pattern of the second conductive layer may include depositing a second insulation thin film and a second conductive thin film on the base substrate on which the aforementioned patterns are formed, patterning the second conductive thin film by a patterning process, to form a pattern of a second insulation layer covering the pattern of the first conductive layer and the pattern of the second conductive layer located on the pattern of the second insulation layer, as shown in FIGS. 20 to 23. FIG. 20 is a schematic diagram of a pattern of a second conductive layer in the display substrate according to FIGS. 7, 9 to 11, FIG. 21 is a schematic diagram of the display substrate according to FIGS. 7, 9 to 11 after a pattern of a second conductive layer is formed, FIG. 22 is a schematic diagram of a pattern of a second conductive layer of the display substrate according to FIG. 8, and FIG. 23 is a schematic diagram of the display substrate according to FIG. 8 after the pattern of the second conductive layer is formed. In an exemplary implementation, the second conductive layer may be referred to as a second gate metal (GATE2) layer.

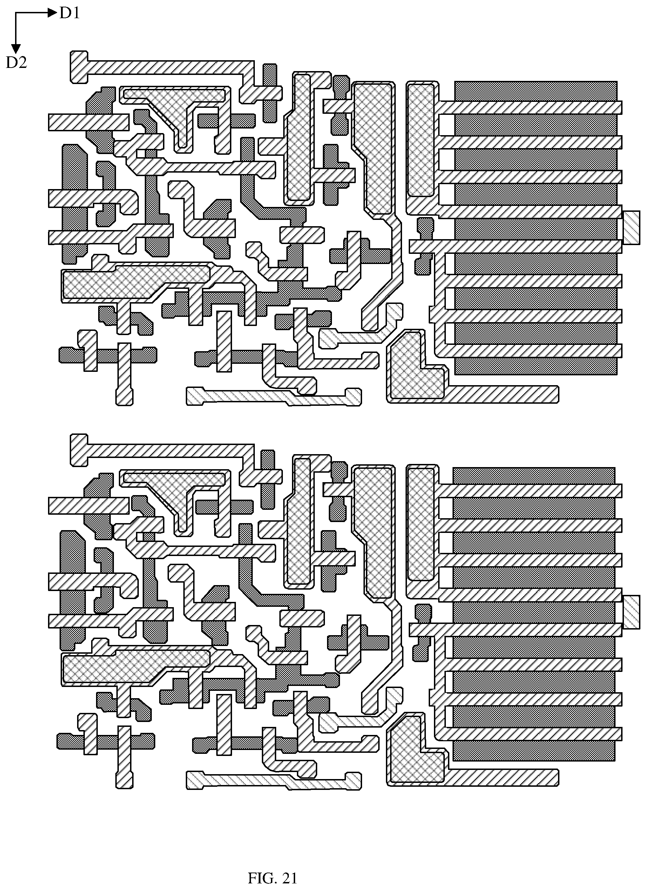

In an exemplary implementation, as shown in FIGS. 20 and 21, in the display substrate according to FIGS. 7, 9 to 11, the pattern of the second conductive layer may include at least a second plate C12 of a first capacitor to a second plate C62 of a sixth capacitor, a cascaded output line OUTL, a first connection line L1, and a second connection line L2 located in each stage of shift register.

In an exemplary implementation, in the display substrate according to FIG. 8, the pattern of the second conductive layer may include at least a second plate C12 of a first capacitor to a second plate C32 of a third capacitor, a second plate C52 of a fifth capacitor, a second plate C62 of a sixth capacitor, a cascaded output line OUTL, a first connection line L1, and a second connection line L2 in each stage of shift register.

In an exemplary implementation, an orthographic projection of the second plate C12 of the first capacitor on the base substrate is at least partially overlapped with an orthographic projection of the first plate of the first capacitor on the base substrate. An area of the second plate C12 of the first capacitor is smaller than an area of the first plate of the first capacitor. A shape of the second plate C12 of the first capacitor is the same as a shape of the first plate of the first capacitor.

In an exemplary implementation, an orthographic projection of a second plate C22 of a second capacitor on the base substrate is at least partially overlapped with an orthographic projection of the first plate of the second capacitor on the base substrate. An area of the second plate C22 of the second capacitor is smaller than an area of the first plate of the second capacitor. A shape of the second plate C22 of the second capacitor is the same as a shape of the first plate of the second capacitor.

In an exemplary implementation, an orthographic projection of the second plate C32 of the third capacitor on the base substrate is at least partially overlapped with an orthographic projection of the first plate of the third capacitor on the base substrate. An area of the second plate C32 of the third capacitor is smaller than an area of the first plate of the third capacitor. A shape of the second plate C32 of the third capacitor is the same as a shape of the first plate of the third capacitor.

In an exemplary implementation, an orthographic projection of a second plate C42 of the fourth capacitor on the base substrate is at least partially overlapped with an orthographic projection of the first plate of the fourth capacitor on the base substrate. An area of the second plate C42 of the fourth capacitor is smaller than an area of the first plate of the fourth capacitor.

In an exemplary implementation, an orthographic projection of the second plate C52 of the fifth capacitor on the base substrate is at least partially overlapped with an orthographic projection of the first plate of the fifth capacitor on the base substrate. The second plate C52 of the fifth capacitor has a same shape as the first plate of the fifth capacitor, and an area of the second plate C52 of the fifth capacitor is less than an area of the first plate of the fifth capacitor.

In an exemplary implementation, an orthographic projection of the second plate C62 of the sixth capacitor on the base substrate is at least partially overlapped with an orthographic projection of the first plate of the sixth capacitor on the base substrate. The second plate C62 of the sixth capacitor has a same shape as the first plate C51 of the sixth capacitor, and an area of the second plate C62 of the sixth capacitor is less than an area of the first plate of the sixth capacitor.

In an exemplary implementation, the cascaded output line OUTL has a shape of a strip and extends in the first direction D1.

In an exemplary implementation, an orthographic projection of the first connection line L1 on the base substrate is located between an orthographic projection of the gate electrode of the eighteenth transistor on the base substrate and an orthographic projection of the gate electrode of the twenty-first transistor (also the first plate of the fifth capacitor) on the base substrate. The first connection line L1 has a polyline shape and extends at least partially in the first direction D1.

In an exemplary implementation, an orthographic projection of the second connection line L2 on the base substrate is located on a side of an orthographic projection of the gate electrode of the twenty-fifth transistor (also the gate electrode of the twenty-sixth transistor) on the base substrate close to the display area. The second connection line L2 has a shape of a strip and extends in the second direction D2.

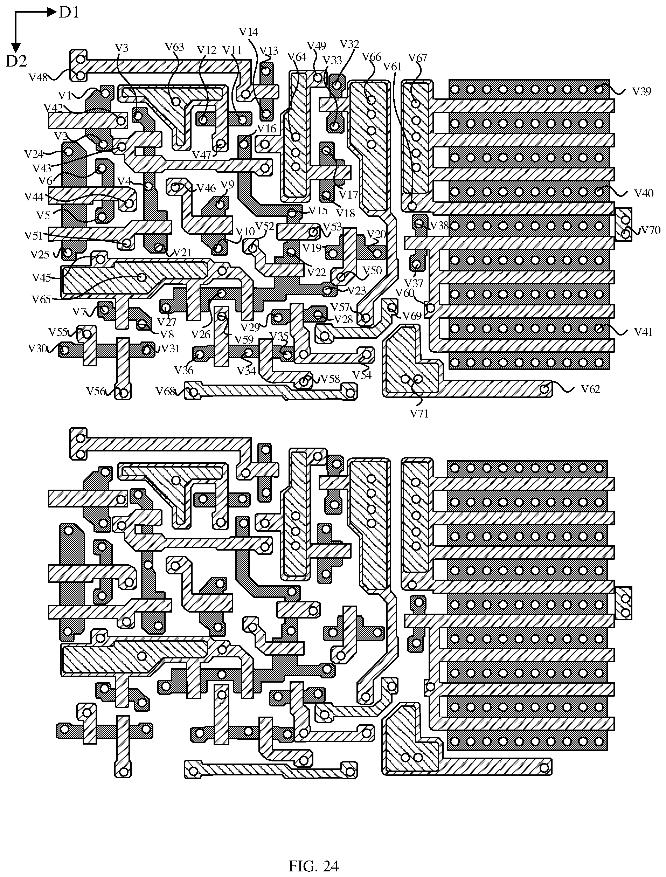

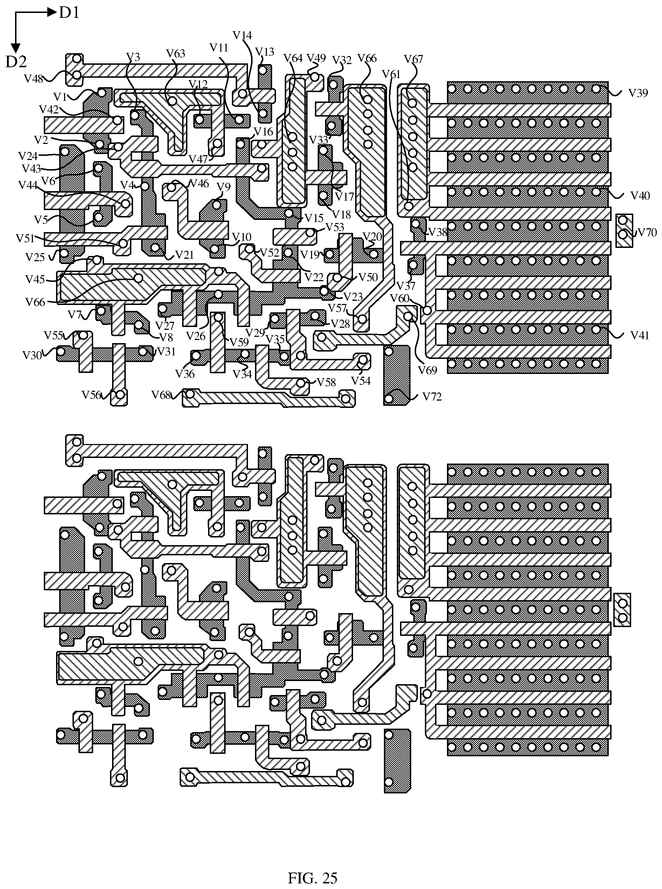

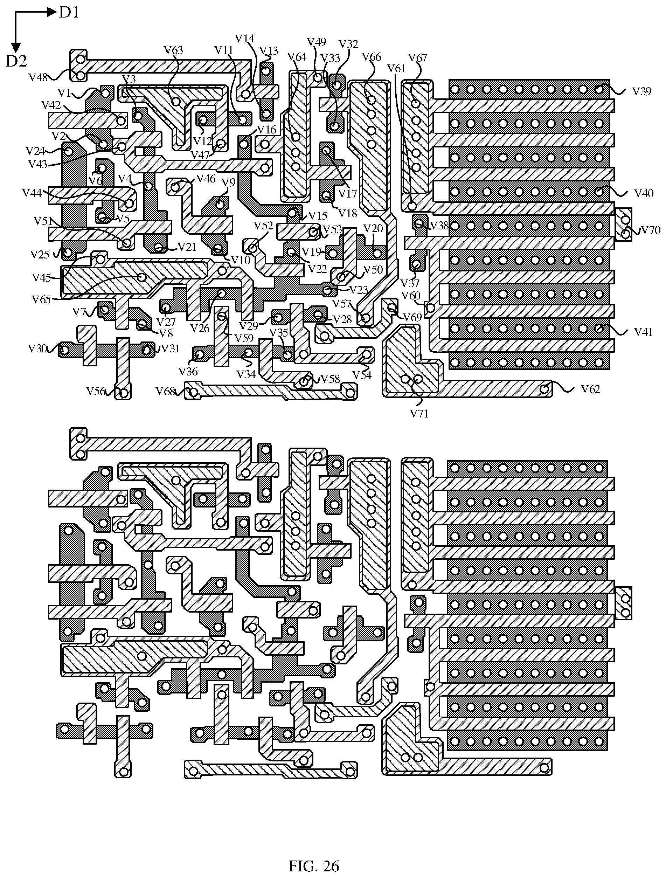

(4) A pattern of a third insulation layer is formed. In an exemplary implementation, forming the pattern of the third insulation layer may include depositing a third insulation thin film on the base substrate on which the aforementioned patterns are formed, patterning the third insulation thin film by a patterning process, to form the pattern of the third insulation layer covering the aforementioned structures, with the third insulation layer being provided with patterns a plurality of via, as shown in FIGS. 24 and 25. FIG. 24 is a schematic diagram of the display substrate according to FIGS. 7, 10, and 11 after a pattern of a third insulation layer is formed, FIG. 25 is a schematic diagram of the display substrate according to FIG. 8 after the pattern of the third insulation layer is formed, and FIG. 26 is a schematic diagram of the display substrate according to FIG. 9 after a pattern of a third insulation layer is formed.

In an exemplary implementation, as shown in FIG. 24, in the display substrate according to FIGS. 7, 10, and 11, the pattern of the third insulation layer may include at least a first via V1 to a seventy-first via V71 located in each stage of shift register.

In an exemplary implementation, as shown in FIG. 25, in the display substrate according to FIG. 8, the pattern of the third insulation layer may include at least a first via V1 to a sixty-first via V61, a sixty-third via V63 to a seventieth via V70, and a seventy-second via V72 located in each stage of shift register.

In an exemplary implementation, as shown in FIG. 26, in the display substrate according to FIG. 9, the pattern of the third insulation layer may include at least a first via V1 to a fifty-fourth via V54, and a fifty-sixth via V56 to a seventy-first via V71 located in each stage of shift register.

In an exemplary implementation, an orthographic projection of the first via V1 on the base substrate is within a range of an orthographic projection of the first region of the active pattern of the first transistor on the base substrate. The first insulation layer and the second insulation layer within the first via V1 are etched away to expose a surface of the first region of the active pattern of the first transistor. The first via V1 is configured such that the first electrode of the first transistor (also the first electrode of the fourteenth transistor) to be formed subsequently is connected with the first region of the active pattern of the first transistor through the first via V1.

In an exemplary implementation, an orthographic projection of the second via V2 on the base substrate is within a range of an orthographic projection of the second region of the active pattern of the first transistor on the base substrate. The first insulation layer and the second insulation layer within the second via V2 are etched away to expose a surface of the second region of the active pattern of the first transistor. The second via V2 is configured such that the second electrode of the first transistor to be formed subsequently is connected with the second region of the active pattern of the first transistor through the second via V2.

In an exemplary implementation, an orthographic projection of the third via V3 on the base substrate is within a range of an orthographic projection of the first region of the active pattern of the second transistor on the base substrate. The first insulation layer and the second insulation layer within the third via V3 are etched away to expose a surface of the first region of the active pattern of the second transistor. The third via V3 is configured to such that the first electrode of the second transistor to be formed subsequently is connected with the first region of the active pattern of the second transistor through the third via V3.

In an exemplary implementation, an orthographic projection of the fourth via V4 on the base substrate is within a range of an orthographic projection of the second region of the active pattern of the second transistor (also the first region of the active pattern of the eleventh transistor) on the base substrate. The first insulation layer and the second insulation layer within the fourth via V4 are etched away to expose a surface of the second region of the active pattern of the second transistor (also the first region of the active pattern of the eleventh transistor). The fourth via V4 is configured such that the second electrode of the second transistor (also the second electrode of the third transistor and the first electrode of the eleventh transistor) to be formed subsequently is connected with the second region of the active pattern of the second transistor (also the first region of the active pattern of the eleventh transistor) through the fourth via V4.

In an exemplary implementation, an orthographic projection of the fifth via V5 on the base substrate is within a range of an orthographic projection of the first region of the active pattern of the third transistor on the base substrate. The first insulation layer and the second insulation layer within the fifth via V5 are etched away to expose a surface of the first region of the active pattern of the third transistor. The fifth via V5 is configured such that the first electrode of the third transistor to be formed subsequently is connected with the first region of the active pattern of the third transistor through the fifth via V5.

In an exemplary implementation, an orthographic projection of the sixth via V6 on the base substrate is within a range of an orthographic projection of the second region of the active pattern of the third transistor on the base substrate. The first insulation layer and the second insulation layer within the sixth via V6 are etched away to expose a surface of the second region of the active pattern of the third transistor. The sixth via V6 is configured such that the second electrode of the second transistor (also the second electrode of the third transistor and the first electrode of the eleventh transistor) to be formed subsequently is connected with the second region of the active pattern of the third transistor through the sixth via V6.

In an exemplary implementation, an orthographic projection of the seventh via V7 on the base substrate is within a range of an orthographic projection of the first region of the active pattern of the fourth transistor on the base substrate. The first insulation layer and the second insulation layer within the seventh via V7 are etched away, to expose a surface of the first region of the active pattern of the fourth transistor. The seventh via V7 is configured such that the first electrode of the fourth transistor to be formed subsequently is connected with the first region of the active pattern of the fourth transistor through the seventh via V7.

In an exemplary implementation, an orthographic projection of the eighth via V8 on the base substrate is within a range of an orthographic projection of a second region of the active pattern of the fourth transistor on the base substrate. The first insulation layer and the second insulation layer within the eighth via V8 are etched away, to expose a surface of the second region of the active pattern of the fourth transistor. The eighth via V8 is configured such that a second electrode of the fourth transistor (also the second electrode of the fifth transistor) to be formed subsequently is connected with the second region of the active pattern of the fourth transistor through the eighth via V8.

In an exemplary implementation, an orthographic projection of the ninth via V9 on the base substrate is within a range of an orthographic projection of the first region of the active pattern of the fifth transistor on the base substrate. The first insulation layer and the second insulation layer within the ninth via V9 are etched away, to expose a surface of the second region of the active pattern of the fifth transistor. The ninth via V9 is configured such that the first electrode of the fifth transistor to be formed subsequently is connected with the first region of the active pattern of the fifth transistor through the ninth via V9.

In an exemplary implementation, an orthographic projection of the tenth via V10 on the base substrate is within a range of an orthographic projection of a second region of the active pattern of the fifth transistor on the base substrate. The first insulation layer and the second insulation layer within the tenth via V10 are etched away, to expose a surface of the second region of the active pattern of the fifth transistor. The tenth via V10 is configured such that a second electrode of the fourth transistor (also the second electrode of the fifth transistor) to be formed subsequently is connected with the second region of the active pattern of the fifth transistor through the tenth via V10.

In an exemplary implementation, an orthographic projection of the eleventh via V11 on the base substrate is within a range of an orthographic projection of the first region of the active pattern of the sixth transistor on the base substrate. The first insulation layer and the second insulation layer within the eleventh via V11 are etched away, to expose a surface of the first region of the active pattern of the sixth transistor. The eleventh via V11 is configured such that the first electrode of the sixth transistor to be formed subsequently is connected with the first region of the active pattern of the sixth transistor through the eleventh via V11.

In an exemplary implementation, an orthographic projection of the twelfth via V12 on the base substrate is within a range of an orthographic projection of the second region of the active pattern of the sixth transistor on the base substrate. The first insulation layer and the second insulation layer within the twelfth via V12 are etched away, to expose a surface of the second region of the active pattern of the sixth transistor. The twelfth via V12 is configured such that the second electrode of the sixth transistor (also the first electrode of the seventh transistor) to be formed subsequently is connected with the second region of the active pattern of the sixth transistor through the twelfth via V12.

In an exemplary implementation, an orthographic projection of the thirteenth via V13 on the base substrate is within a range of an orthographic projection of a first region of the active pattern of the seventh transistor on the base substrate. The first insulation layer and the second insulation layer within the thirteenth via V13 are etched away, to expose a surface of the first region of the active pattern of the seventh transistor. The thirteenth via V13 is configured such that the second electrode of the sixth transistor (also the first electrode of the seventh transistor) to be formed subsequently is connected with the first region of the active pattern of the seventh transistor through the thirteenth via V13.

In an exemplary implementation, an orthographic projection of the fourteenth via V14 on the base substrate is within a range of an orthographic projection of the second region of the active pattern of the seventh transistor on the base substrate. The first insulation layer and the second insulation layer within the fourteenth via V14 are etched away, to expose a surface of the second region of the active pattern of the seventh transistor. The fourteenth via V14 is configured such that the second electrode of the seventh transistor (also the second electrode of an eighth transistor) to be formed subsequently is connected with the second region of the active pattern of the seventh transistor through the fourteenth via V14.

In an exemplary implementation, an orthographic projection of the fifteenth via V15 on the base substrate is within a range of an orthographic projection of the first region of the active pattern of the eighth transistor (also the first region of the active pattern of the thirteenth transistor) on the base substrate. The first insulation layer and the second insulation layer within the fifteenth via V15 are etched away, to expose a surface of the first region of the active pattern of the eighth transistor (also the first region of the active pattern of the thirteenth transistor). The fifteenth via V15 is configured such that the first electrode of the eighth transistor (also the first electrode of the ninth transistor, the first electrode of the thirteenth transistor, and the first electrode of the twenty-fifth transistor) to be formed subsequently is connected with the first region of the active pattern of the eighth transistor (also the first region of the active pattern of the thirteenth transistor) through the fifteenth via V15.

In an exemplary implementation, an orthographic projection of the sixteenth via V16 on the base substrate is within a range of an orthographic projection of the second region of the active pattern of the eighth transistor on the base substrate. The first insulation layer and the second insulation layer within the sixteenth via V16 are etched away, to expose a surface of the second region of the active pattern of the eighth transistor. The sixteenth via V16 is configured such that the second electrode of the seventh transistor (also the first electrode of the eighth transistor) to be formed subsequently is connected with the second region of the active pattern of the eighth transistor through the sixteenth via V16.

In an exemplary implementation, an orthographic projection of the seventeenth via V17 on the base substrate is within a range of an orthographic projection of the first region of the active pattern of the ninth transistor on the base substrate. The first insulation layer and the second insulation layer within the seventeenth via V17 are etched away, to expose a surface of the first region of the active pattern of the ninth transistor. The seventeenth via V17 is configured such that the first electrode of the eighth transistor (also the first electrode of the ninth transistor, the first electrode of the thirteenth transistor and the first electrode of the twenty-fifth transistor) to be formed subsequently is connected with the first region of the active pattern of the ninth transistor through the seventeenth via V17.

In an exemplary implementation, an orthographic projection of the eighteenth via V18 on the base substrate is within a range of an orthographic projection of a second region of the active pattern of the ninth transistor on the base substrate. The first insulation layer and the second insulation layer within the eighteenth via V18 are etched away, to expose a surface of the second region of the active pattern of the ninth transistor. The eighteenth via V18 is configured such that the second electrode of the ninth transistor (also the second electrode of the tenth transistor) to be formed subsequently is connected with the second region of the active pattern of the ninth transistor through the eighteenth via V18.

In an exemplary implementation, an orthographic projection of the nineteenth via V19 on the base substrate is within a range of an orthographic projection of the first region of the active pattern of the tenth transistor on the base substrate. The first insulation layer and the second insulation layer within the nineteenth via V19 are etched away, to expose a surface of the first region of the active pattern of the tenth transistor. The nineteenth via V19 is configured such that the first electrode of the tenth transistor to be formed subsequently is connected with the first region of the active pattern of the tenth transistor through the nineteenth via V19.

In an exemplary implementation, an orthographic projection of the twentieth via V20 on the base substrate is within a range of an orthographic projection of a second region of the active pattern of the tenth transistor on the base substrate. The first insulation layer and the second insulation layer within the twentieth via V20 are etched away, to expose a surface of the second region of the active pattern of the tenth transistor. The twentieth via V20 is configured such that the second electrode of the ninth transistor (also the second electrode of the tenth transistor) to be formed subsequently is connected with the second region of the active pattern of the tenth transistor through the twentieth via V20.

In an exemplary implementation, an orthographic projection of the twenty-first via V21 on the base substrate is within a range of an orthographic projection of the second region of the active pattern of the eleventh transistor on the base substrate. The first insulation layer and the second insulation layer within the twenty-first via V21 are etched away, to expose a surface of the second region of the active pattern of the eleventh transistor. The twenty-first via V21 is configured such that the second electrode of the eleventh transistor to be formed subsequently is connected with the second region of the active pattern of the eleventh transistor through the twenty-first via V21.

In an exemplary implementation, an orthographic projection of the twenty-second via V22 on the base substrate is within a range of an orthographic projection of the first region of the active pattern of the twelfth transistor (also the second region of the active pattern of the thirteenth transistor) on the base substrate. The first insulation layer and the second insulation layer within the twenty-second via V22 are etched away, to expose a surface of the first region of the active pattern of the twelfth transistor (also the second region of the active pattern of the thirteenth transistor). The twenty-second via V22 is configured such that the first electrode of the twelfth transistor (also the second electrode of the thirteenth transistor and the first electrode of the eighteenth transistor) to be formed subsequently is connected with the first region of the active pattern of the twelfth transistor (also the second region of the active pattern of the thirteenth transistor) through the twenty-second via V22.

In an exemplary implementation, an orthographic projection of the twenty-third via V23 on the base substrate is within a range of an orthographic projection of the second region of the active pattern of the twelfth transistor (also the second region of the active pattern of the sixteenth transistor) on the base substrate. The first insulation layer and the second insulation layer within the twenty-third via V23 are etched away, to expose a surface of the second region of the active pattern of the twelfth transistor (also the second region of the active pattern of the sixteenth transistor). The twenty-third via V23 is configured such that the second electrode of the twelfth transistor (also the second electrode of the sixteenth transistor) to be formed subsequently is connected with the second region of the active pattern of the twelfth transistor (also the second region of the active pattern of the sixteenth transistor) through the twenty-third via V23.

In an exemplary implementation, an orthographic projection of the twenty-fourth via V24 on the base substrate is within a range of an orthographic projection of the first region of the active pattern of the fourteenth transistor on the base substrate. The first insulation layer and the second insulation layer within the twenty-fourth via V24 are etched away, to expose a surface of the first region of the active pattern of the fourteenth transistor. The twenty-fourth via V24 is configured such that the first electrode of the first transistor (also the first electrode of the fourteenth transistor) to be formed subsequently is connected with the first region of the active pattern of the fourteenth transistor through the twenty-fourth via V24.

In an exemplary implementation, an orthographic projection of the twenty-fifth via V25 on the base substrate is within a range of an orthographic projection of the second region of the active pattern of the fifteenth transistor on the base substrate. The first insulation layer and the second insulation layer within the twenty-fifth via V25 are etched away, to expose a surface of the second region of the active pattern of the fifteenth transistor. The twenty-fifth via V25V26 is configured such that the second electrode of the fifteenth transistor to be formed subsequently is connected with the second region of the active pattern of the fifteenth transistor through the twenty-fifth via V25.

In an exemplary implementation, an orthographic projection of the twenty-sixth via V26 on the base substrate is within a range of an orthographic projection of the first region of the active pattern of the sixteenth transistor (also the first region of the active pattern of the seventeenth transistor) on the base substrate. The first insulation layer and the second insulation layer within the twenty-sixth via V26 are etched away, to expose a surface of the first region of the active pattern of the sixteenth transistor (also the first region of the active pattern of the seventeenth transistor). The twenty-sixth via V26 is configured such that the first electrode of the sixteenth transistor (also the first electrode of the seventeenth transistor) to be formed subsequently is connected with the first region of the active pattern of the sixteenth transistor (also the first region of the active pattern of the seventeenth transistor) through the twenty-sixth via V26.

In an exemplary implementation, an orthographic projection of the twenty-seventh via V27 on the base substrate is within a range of an orthographic projection of the second region of the active pattern of the seventeenth transistor on the base substrate. The first insulation layer and the second insulation layer within the twenty-seventh via V27 are etched away, to expose a surface of the second region of the active pattern of the seventeenth transistor. The twenty-seventh via V27 is configured such that the second electrode of the seventeenth transistor (also the second electrode of the eighteenth transistor) to be formed subsequently is connected with the second region of the active pattern of the seventeenth transistor through the twenty-seventh via V27.

In an exemplary implementation, an orthographic projection of the twenty-eighth via V28 on the base substrate is within a range of an orthographic projection of the first region of the active pattern of the eighteenth transistor on the base substrate. The first insulation layer and the second insulation layer within the twenty-eighth via V28 are etched away, to expose a surface of the first region of the active pattern of the eighteenth transistor. The twenty-eighth via V28 is configured such that the first electrode of the twelfth transistor (also the second electrode of the thirteenth transistor and the first electrode of the eighteenth transistor) to be formed subsequently is connected with the first region of the active pattern of the eighteenth transistor through the twenty-eighth via V28.

In an exemplary implementation, an orthographic projection of the twenty-ninth via V29 on the base substrate is within a range of an orthographic projection of the second region of the active pattern of the eighteenth transistor on the base substrate. The first insulation layer and the second insulation layer within the twenty-ninth via V29 are etched away, to expose a surface of the second region of the active pattern of the eighteenth transistor. The twenty-ninth via V29 is configured such that the second electrode of the seventeenth transistor (also the second electrode of the eighteenth transistor) to be formed subsequently is connected with the second region of the active pattern of the eighteenth transistor through the twenty-ninth via V29.

In an exemplary implementation, an orthographic projection of the thirtieth via V30 on the base substrate is within a range of an orthographic projection of the first region of the active pattern of the nineteenth transistor on the base substrate. The first insulation layer and the second insulation layer within the thirtieth via V30 are etched away, to expose a surface of the first region of the active pattern of the nineteenth transistor. The thirtieth via V30 is configured such that the first electrode of the nineteenth transistor to be formed subsequently is connected with the first region of the active pattern of the nineteenth transistor through the thirtieth via V30.

In an exemplary implementation, an orthographic projection of the thirty-first via V31 on the base substrate is within a range of an orthographic projection of the second region of the active pattern of the twentieth transistor on the base substrate. The first insulation layer and the second insulation layer within the thirty-first via V31 are etched away, to expose a surface of the second region of the active pattern of the twentieth transistor. The thirty-first via V31 is configured such that the second electrode of the twentieth transistor (also the second electrode of the twenty-second transistor and the second electrode of the twenty-third transistor) to be formed subsequently is connected with the second region of the active pattern of the twentieth transistor through the thirty-first via V31.

In an exemplary implementation, an orthographic projection of the thirty-second via V32 on the base substrate is within a range of an orthographic projection of the first region of the active pattern of the twenty-first transistor on the base substrate. The first insulation layer and the second insulation layer within the thirty-second via V32 are etched away, to expose a surface of the first region of the active pattern of the twenty-first transistor. The thirty-second via V32 is configured such that the first electrode of the twenty-first transistor to be formed subsequently is connected with the first region of the active pattern of the twenty-first transistor through the thirty-second via V32.

In an exemplary implementation, an orthographic projection of the thirty-third via V33 on the base substrate is within a range of an orthographic projection of the second region of the active pattern of the twenty-first transistor on the base substrate. The first insulation layer and the second insulation layer within the thirty-third via V33 are etched away, to expose a surface of the second region of the active pattern of the twenty-first transistor. The thirty-third via V33 is configured such that the second electrode of the twenty-first transistor (also the second electrode of the twenty-fourth transistor) to be formed subsequently is connected with the second region of the active pattern of the twenty-first transistor through the thirty-third via V33.

In an exemplary implementation, an orthographic projection of the thirty-fourth via V34 on the base substrate is within a range of an orthographic projection of the first region of the active pattern of the twenty-second transistor (also the first region of the active pattern of the twenty-third transistor) on the base substrate. The fourth insulation layer within the thirty-fourth via V34 is etched away, to expose a surface of the first region of the active pattern of the twenty-second transistor (also the first region of the active pattern of the twenty-third transistor). The thirty-fourth via V34 is configured such that the first electrode of the twenty-second transistor (also the first electrode of the twenty-third transistor) to be formed subsequently is connected with the first region of the active pattern of the twenty-second transistor (also the first region of the active pattern of the twenty-third transistor) through the thirty-fourth via V34.

In an exemplary implementation, an orthographic projection of the thirty-fifth via V35 on the base substrate is within a range of an orthographic projection of the second region of the active pattern of the twenty-second transistor on the base substrate. The fourth insulation layer within the thirty-fifth via V35 is etched away, to expose a surface of the second region of the active pattern of the twenty-second transistor. The thirty-fifth via V35 is configured such that the second electrode of the twentieth transistor (also the second electrode of the twenty-second transistor and the second electrode of the twenty-third transistor) to be formed subsequently is connected with the second region of the active pattern of the twenty-second transistor through the thirty-fifth via V35.

In an exemplary implementation, an orthographic projection of the thirty-sixth via V36 on the base substrate is within a range of an orthographic projection of the second region of the active pattern of the twenty-third transistor on the base substrate. The first insulation layer and the second insulation layer within the thirty-sixth via V36 are etched away, to expose a surface of the second region of the active pattern of the twenty-third transistor. The thirty-sixth via V36 is configured such that the second electrode of the twentieth transistor (also the second electrode of the twenty-second transistor and the second electrode of the twenty-third transistor) to be formed subsequently is connected with the second region of the active pattern of the twenty-third transistor through the thirty-sixth via V36.

In an exemplary implementation, an orthographic projection of the thirty-seventh via V37 on the base substrate is within a range of an orthographic projection of a first region of the active pattern of the twenty-fourth transistor on the base substrate. The first insulation layer and the second insulation layer within the thirty-seventh via V37 are etched away, to expose a surface of the first region of the active pattern of the twenty-fourth transistor. The thirty-seventh via V37 is configured such that the first electrode of the twenty-fourth transistor to be formed subsequently is connected with the first region of the active pattern of the twenty-fourth transistor through the thirty-seventh via V37.

In an exemplary implementation, an orthographic projection of the thirty-eighth via V38 on the base substrate is within a range of an orthographic projection of the second region of the active pattern of the twenty-fourth transistor on the base substrate. The first insulation layer and the second insulation layer within the thirty-eighth via V38 are etched away, to expose a surface of the second region of the active pattern of the twenty-fourth transistor. The thirty-eighth via V38 is configured such that the second electrode of the twenty-first transistor (also the second electrode of the twenty-fourth transistor) to be formed subsequently is connected with the second region of the active pattern of the twenty-fourth transistor through the thirty-eighth via V38.

In an exemplary implementation, an orthographic projection of the thirty-ninth via V39 on the base substrate is within a range of an orthographic projection of the first region of the active pattern of the twenty-fifth transistor on the base substrate. The first insulation layer and the second insulation layer within the thirty-ninth via V39 are etched away, to expose a surface of the first region of the active pattern of the twenty-fifth transistor. The thirty-ninth via V39 is configured such that the first electrode of the eighth transistor (also the first electrode of the ninth transistor, the first electrode of the thirteenth transistor and the first electrode of the twenty-fifth transistor) to be formed subsequently is connected with the first region of the active pattern of the twenty-fifth transistor through the thirty-ninth via V39.

In an exemplary implementation, an orthographic projection of the fortieth via V40 on the base substrate is within a range of an orthographic projection of the second region of the active pattern of the twenty-fifth transistor (also the second region of the active pattern of the twenty-sixth transistor) on the base substrate. The first insulation layer and the second insulation layer in the thirty-ninth via V39 are etched away, to expose a surface of the second region of the active pattern of the twenty-fifth transistor (also the second region of the active pattern of the twenty-sixth transistor). The thirty-ninth via V39 is configured such that the second electrode of the twenty-fifth transistor (also the second electrode of the twenty-sixth transistor) to be formed subsequently is connected with the second region of the active pattern of the twenty-fifth transistor (also the second region of the active pattern of the twenty-sixth transistor) through the fortieth via V40.

In an exemplary implementation, an orthographic projection of the forty-first via V41 on the base substrate is within a range of an orthographic projection of the first region of the active pattern of the twenty-sixth transistor on the base substrate. The first insulation layer and the second insulation layer within the forty-first via V41 are etched away, to expose a surface of the first region of the active pattern of the twenty-sixth transistor. The forty-first via V41 is configured such that the first electrode of the twenty-sixth transistor to be formed subsequently is connected with the first region of the active pattern of the twenty-sixth transistor through the forty-first via V41.

In an exemplary implementation, an orthographic projection of the forty-second via V42 on the base substrate is within a range of an orthographic projection of the gate electrode of the first transistor on the base substrate. The second insulation layer within the forty-second via V42 is etched away, to expose a surface of the gate electrode of the first transistor. The forty-second via V42 is configured such that one signal line of the first clock signal line and the second clock signal line to be formed subsequently and the first electrode of the second transistor are connected with the gate electrode of the first transistor through the forty-second via V42.

In an exemplary implementation, an orthographic projection of the forty-third via V43 on the base substrate is within a range of an orthographic projection of the gate electrode of the second transistor (also the gate electrode of the eighth transistor) on the base substrate. The second insulation layer within the forty-third via V43 is etched away, to expose a surface of the gate electrode of the second transistor (also the gate electrode of the eighth transistor). The forty-third via V43 is configured such that the second electrode of the first transistor and the first electrode of the twelfth transistor (also the second electrode of the thirteenth transistor and the first electrode of the eighteenth transistor) to be formed subsequently are connected with the gate electrode of the second transistor (also the gate electrode of the eighth transistor) through the forty-third via V43.

In an exemplary implementation, an orthographic projection of the forty-fourth via V44 on the base substrate is within a range of an orthographic projection of the gate electrode of the third transistor (also the gate electrode of the fourteenth transistor) on the base substrate. The second insulation layer within the forty-fourth via V44 is etched away, to expose a surface of the gate electrode of the third transistor (also the gate electrode of the fourteenth transistor). The forty-fourth via V44 is configured such that one of the first clock signal line and the second clock signal line and a third connection line to be formed subsequently are connected with the gate electrode of the third transistor (also the gate electrode of the fourteenth transistor) through the forty-fourth via V44.

In an exemplary implementation, an orthographic projection of the forty-fifth via V45 on the base substrate is within a range of an orthographic projection of the gate electrode of the fourth transistor (also the gate electrode of the sixteenth transistor, the gate electrode of the seventeenth transistor, and the first plate of the third capacitor) on the base substrate. The second insulation layer within the forty-fifth via V45 is etched away, to expose a surface of the gate electrode of the fourth transistor (also the gate electrode of the sixteenth transistor, the gate electrode of the seventeenth transistor, and the first plate of the third capacitor). The forty-fifth via V45 is configured such that the second electrode of the fifteenth transistor and the first electrode of the sixteenth transistor to be formed subsequently are connected with the gate electrode of the fourth transistor (also the gate electrode of the sixteenth transistor, the gate electrode of the seventeenth transistor, and the first plate of the third capacitor) through the forty-fifth via V45.

In an exemplary implementation, an orthographic projection of the forty-sixth via V46 on the base substrate is within a range of an orthographic projection of the gate electrode of the fifth transistor on the base substrate. The second insulation layer within the forty-sixth via V46 is etched away, to expose a surface of the gate electrode of the fifth transistor. The forty-sixth via V46 is configured such that the second electrode of the second transistor (also the second electrode of the third transistor and the first electrode of the eleventh transistor) to be formed subsequently is connected with the gate electrode of the fifth transistor through the forty-sixth via V46.

In an exemplary implementation, an orthographic projection of the forty-seventh via V47 on the base substrate is within a range of an orthographic projection of the gate electrode of the sixth transistor (the first plate of the first capacitor) on the base substrate. The second insulation layer within the forty-seventh via V47 is etched away, to expose a surface of the gate electrode of the sixth transistor (the first plate of the first capacitor). The forty-seventh via V47 is configured such that the second electrode of the eleventh transistor to be formed subsequently is connected with the gate electrode of the sixth transistor (the first plate of the first capacitor) through the forty-seventh via V47.

In an exemplary implementation, an orthographic projection of the forty-eighth via V48 on the base substrate is within a range of an orthographic projection of the gate electrode of the seventh transistor on the base substrate. The second insulation layer within the forty-eighth via V48 is etched away, to expose a surface of the gate electrode of the seventh transistor. The forty-eighth via V48 is configured such that a fourth connection line and the first electrode of the sixth transistor are connected with the gate electrode of the seventh transistor through the forty-eighth via V48.

In an exemplary implementation, an orthographic projection of the forty-ninth via V49 on the base substrate is within a range of an orthographic projection of the gate electrode of the ninth transistor (also the first plate of the second capacitor) on the base substrate. The second insulation layer within the forty-ninth via V49 is etched away, to expose a surface of the gate electrode of the ninth transistor (also the first plate of the second capacitor). The forty-ninth via V49 is configured such that a second electrode of a seventh transistor (also the second electrode of the eighth transistor) to be formed subsequently is connected with the gate electrode of the ninth transistor (also the first plate of the second capacitor) through the forty-ninth via V49.

In an exemplary implementation, an orthographic projection of the fiftieth via V50 on the base substrate is within a range of an orthographic projection of the gate electrode of the tenth transistor on the base substrate. The second insulation layer within the fiftieth via V50 is etched away, to expose a surface of the gate electrode of the tenth transistor. The fiftieth via V50 is configured such that the second electrode of the twelfth transistor (also the second electrode of the sixteenth transistor) to be formed subsequently is connected with the gate electrode of the tenth transistor through the fiftieth via V50.

In an exemplary implementation, an orthographic projection of the fifty-first via V51 on the base substrate is within a range of an orthographic projection of the gate electrode of the eleventh transistor (also the gate electrode of the fifteenth transistor) on the base substrate. The second insulation layer within the fifty-first via V51 is etched away, to expose a surface of the gate electrode of the eleventh transistor (also the gate electrode of the fifteenth transistor). The fifty-first via V51 is configured such that the first electrode of the third transistor to be formed subsequently is connected with the gate electrode of the eleventh transistor (also the gate electrode of the fifteenth transistor) through the fifty-first via V51.

In an exemplary implementation, an orthographic projection of the fifty-second via V52 on the base substrate is within a range of an orthographic projection of the gate electrode of the twelfth transistor on the base substrate. The second insulation layer within the fifty-second via V52 is etched away, to expose a surface of the gate electrode of the twelfth transistor. The fifty-second via V52 is configured such that a fifth connection line to be formed subsequently is connected with the gate electrode of the twelfth transistor through the fifty-second via V52.

In an exemplary implementation, an orthographic projection of the fifty-third via V53 on the base substrate is within a range of an orthographic projection of the gate electrode of the thirteenth transistor on the base substrate. The second insulation layer within the fifty-third via V53 is etched away, to expose a surface of the gate electrode of the thirteenth transistor. The fifty-third via V53 is configured such that a sixth connection line to be formed subsequently is connected with the gate electrode of the thirteenth transistor through the fifty-third via V53.

In an exemplary implementation, an orthographic projection of the fifty-fourth via V54 on the base substrate is within a range of an orthographic projection of the gate electrode of the eighteenth transistor on the base substrate. The second insulation layer within the fifty-fourth via V54 is etched away, to expose a surface of the gate electrode of the eighteenth transistor. The fifty-fourth via V54 is configured such that the second electrode of the twentieth transistor (also the second electrode of the twenty-second transistor and the second electrode of the twenty-third transistor) and a seventh connection line to be formed subsequently are connected with the gate electrode of the eighteenth transistor through the fifty-fourth via V54.

In an exemplary implementation, an orthographic projection of the fifty-fifth via V55 on the base substrate is within a range of an orthographic projection of the gate electrode of the nineteenth transistor on the base substrate. The second insulation layer within the fifty-fifth via V55 is etched away, to expose a surface of the gate electrode of the nineteenth transistor. The fifty-fifth via V55 is configured such that a node connection line to be formed subsequently is connected with the gate electrode of the nineteenth transistor through the fifty-fifth via V55.

In an exemplary implementation, an orthographic projection of the fifty-sixth via V56 on the base substrate is within a range of an orthographic projection of the gate electrode of the twentieth transistor on the base substrate. The second insulation layer within the fifty-sixth via V56 is etched away, to expose a surface of the gate electrode of the twentieth transistor. The fifty-sixth via V56 is configured such that a first electrode of a first transistor (also a first electrode of a fourteenth transistor) in a next stage of shift register to be formed subsequently is connected with the gate electrode of the twentieth transistor through the fifty-sixth via V56.

In an exemplary implementation, an orthographic projection of the fifty-seventh via V57 on the base substrate is within a range of an orthographic projection of the gate electrode of the twenty-first transistor (also the first plate of the fifth capacitor) on the base substrate. The second insulation layer within the fifty-sixth via V56 is etched away, to expose a surface of the gate electrode of the twentieth transistor. The fifty-sixth via V56 is configured such that the seventh connection line to be formed subsequently is connected with the gate electrode of the twentieth transistor through the fifty-seventh via V57.

In an exemplary implementation, an orthographic projection of the fifty-eighth via V58 on the base substrate is within a range of an orthographic projection of the gate electrode of the twenty-second transistor on the base substrate. The second insulation layer in the fifty-eighth via V58 is etched away, to expose a surface of the gate electrode of the twenty-second transistor. The fifty-eighth via V58 is configured such that an eighth connection line to be formed subsequently is connected with the gate electrode of the twenty-second transistor through the fifty-eighth via V58.

In an exemplary implementation, an orthographic projection of the fifty-ninth via V59 on the base substrate is within a range of an orthographic projection of the gate electrode of the twenty-third transistor on the base substrate. The fifty-ninth via V59 exposes a surface of the gate electrode of the twenty-third transistor. The fifty-ninth via V59 is configured such that the eighth connection line and the seventh connection line to be formed subsequently are connected with the gate electrode of the twenty-third transistor through the fifty-ninth via V59.

In an exemplary implementation, an orthographic projection of the fifty-ninth via V59 on the base substrate is within a range of an orthographic projection of the gate electrode of the twenty-third transistor on the base substrate. The second insulation layer within the fifty-ninth via V59 is etched away, to expose a surface of the gate electrode of the twenty-third transistor. The fifty-ninth via V59 is configured such that the second electrode of the fourth transistor (also the second electrode of the fifth transistor) to be formed subsequently is connected with the gate electrode of the twenty-third transistor through the fifty-ninth via V59.

In an exemplary implementation, an orthographic projection of the sixtieth via V60 on the base substrate is within an orthographic projection of the gate electrode of the twenty-fourth transistor (the gate electrode of the twenty-sixth transistor) on the base substrate. The second insulation layer within the sixtieth via V60 is etched away, to expose a surface of the gate electrode of the twenty-fourth transistor (the gate electrode of the twenty-sixth transistor). The sixtieth via V60 is configured such that a ninth connection line to be formed subsequently is connected with the gate electrode of the twenty-fourth transistor (the gate electrode of the twenty-sixth transistor) through the sixtieth via V60.

In an exemplary implementation, an orthographic projection of the sixty-first via V61 on the base substrate is within a range of an orthographic projection of the gate electrode of the twenty-fifth transistor (also the first plate of the sixth capacitor) on the base substrate. The second insulation layer within the sixty-first via V61 is etched away, to expose a surface of the gate electrode of the twenty-fifth transistor (also the first plate of the sixth capacitor). The sixty-first via V61 is configured such that the second electrode of the twenty-first transistor (also the second electrode of the twenty-fourth transistor) to be formed subsequently is connected with the gate electrode of the twenty-fifth transistor (also the first plate of the sixth capacitor) through the sixty-first via V61.

In an exemplary implementation, an orthographic projection of the sixty-second via V62 on the base substrate is within a range of an orthographic projection of the first plate of the fourth capacitor on the base substrate. The second insulation layer within the sixty-second via V62 is etched away, to expose a surface of the first plate of the fourth capacitor. The sixty-second via V62 is configured such that a tenth connection line to be formed subsequently is connected with the first plate of the fourth capacitor through the sixty-second via V62.

In an exemplary implementation, an orthographic projection of the sixty-third via V63 on the base substrate is within a range of an orthographic projection of the second plate of the first capacitor on the base substrate. The sixty-third via V63 exposes a surface of the second plate of the first capacitor. The sixty-third via V63 is configured such that a second electrode of the sixth transistor (also the first electrode of the seventh transistor) to be formed subsequently is connected with the second plate of the first capacitor through the sixty-third via V63.

In an exemplary implementation, an orthographic projection of the sixty-fourth via V64 on a substrate is within a range of an orthographic projection of the second plate of the second capacitor on the base substrate. The sixty-fourth via V64 exposes a surface of the second plate of the second capacitor. The sixty-fourth via V64 is configured such that the first electrode of the eighth transistor (also the first electrode of the ninth transistor, the first electrode of a thirteenth transistor, and the first electrode of the twenty-fifth transistor) to be formed subsequently is connected with the second plate of the second capacitor through the sixty-fourth via V64.

In an exemplary implementation, an orthographic projection on the base substrate of the sixty-fifth via V65 is within a range of an orthographic projection of the second plate of the third capacitor on the base substrate. The sixty-fifth via V65 exposes a surface of the second plate of the third capacitor. The sixty-fifth via V65 is configured such that the second electrode of the fourth transistor (also the second electrode of the fifth transistor) to be formed subsequently is connected with the second plate of the third capacitor through the sixty-fifth via V65.

In an exemplary implementation, an orthographic projection of the sixty-sixth via V66 on the base substrate is within a range of an orthographic projection of the second plate of the fifth capacitor on the base substrate. The sixty-sixth via V66 exposes a surface of the second plate of the fifth capacitor. The sixty-sixth via V66 is configured such that the second electrode of the twenty-first transistor (also the second electrode of the twenty-fourth transistor) to be formed subsequently is connected with the second plate of the fifth capacitor through the sixty-sixth via V66.

In an exemplary implementation, an orthographic projection of the sixty-seventh via V67 on a substrate is within a range of an orthographic projection of the second plate of the sixth capacitor on the base substrate. The sixty-seventh via V67 exposes a surface of the second plate of the sixth capacitor. The sixty-seventh via V67 is configured such that the first electrode of the eighth transistor (also the first electrode of the ninth transistor, the first electrode of the thirteenth transistor, and the first electrode of the twenty-fifth transistor) to be formed subsequently is connected with the second plate of the sixth capacitor through the sixty-seventh via V67.

In an exemplary implementation, an orthographic projection of the sixty-eighth via V68 on the base substrate is within a range of an orthographic projection of the cascaded output line on the base substrate. The sixty-eighth via V68 exposes a surface of the cascaded output line. The sixty-eighth via V68 is configured such that a first electrode of a first transistor (also a first electrode of a fourteenth transistor) and a second electrode of a ninth transistor (also a second electrode of a tenth transistor) in the next stage of shift register or the cascaded connection line to be formed subsequently are connected with the cascaded output line through the sixty-eighth via V68.

In an exemplary implementation, an orthographic projection of the sixty-ninth via V69 on the base substrate is within a range of an orthographic projection of the first connection line on the base substrate. The sixty-ninth via V69 exposes a surface of the first connection line. The sixty-ninth via V69 is configured such that the second electrode of the seventeenth transistor (also the second electrode of the eighteenth transistor) and the ninth connection line to be formed subsequently are connected with the first connection line through the sixty- ninth via V69.

In an exemplary implementation, an orthographic projection of the seventieth via V70 on the base substrate is within a range of an orthographic projection of the second connection line on the base substrate. The seventieth via V70 exposes a surface of the second connection line. The seventieth via V70 is configured such that the second electrode of the twenty-fifth transistor (also the second electrode of the twenty-sixth transistor) to be formed subsequently is connected with the second connection line through the seventieth via V70.

In an exemplary implementation, an orthographic projection of the seventy-first via V71 on the base substrate is within a range of an orthographic projection of the second plate of the fourth capacitor on the base substrate. The seventy-first via V71 exposes a surface of the second plate of the fourth capacitor. The seventy-first via V71 is configured such that the second electrode of the ninth transistor (also the second electrode of the tenth transistor) to be formed subsequently is connected with the second plate of the fourth capacitor through the seventy-first via V71.

In an exemplary implementation, an orthographic projection of the seventy-second via V72 on the base substrate is within a range of an orthographic projection of the voltage stabilization connection line on the base substrate. The seventy-second via V72 exposes a surface of the voltage stabilization connection line. The seventy-second via V72 is configured such that the second electrode of the ninth transistor (also the second electrode of the tenth transistor) and the cascade connection line to be formed subsequently are connected with the voltage stabilization connection line through the seventy-second via V72.

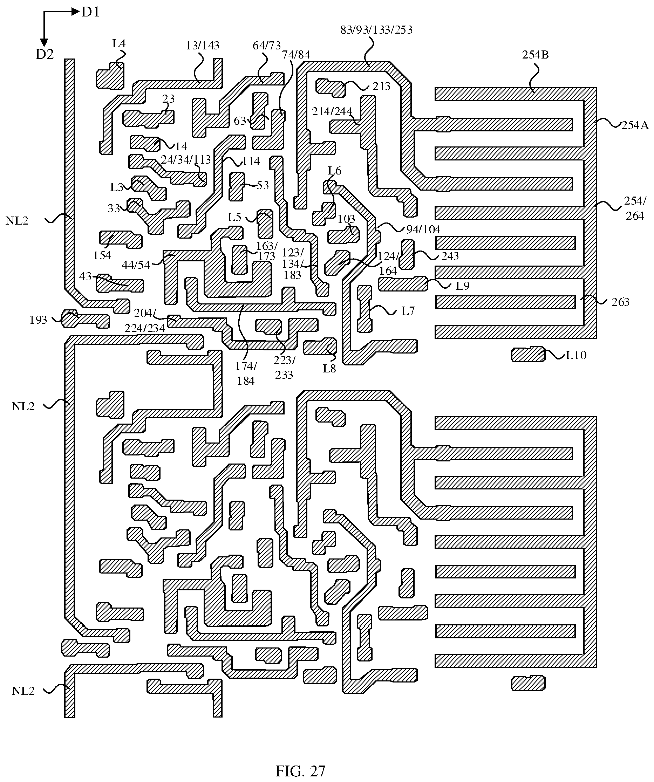

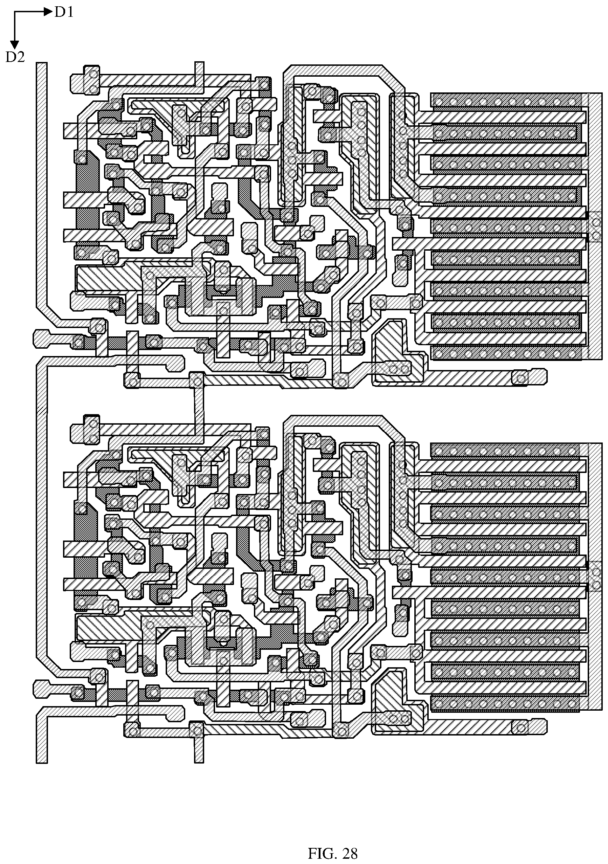

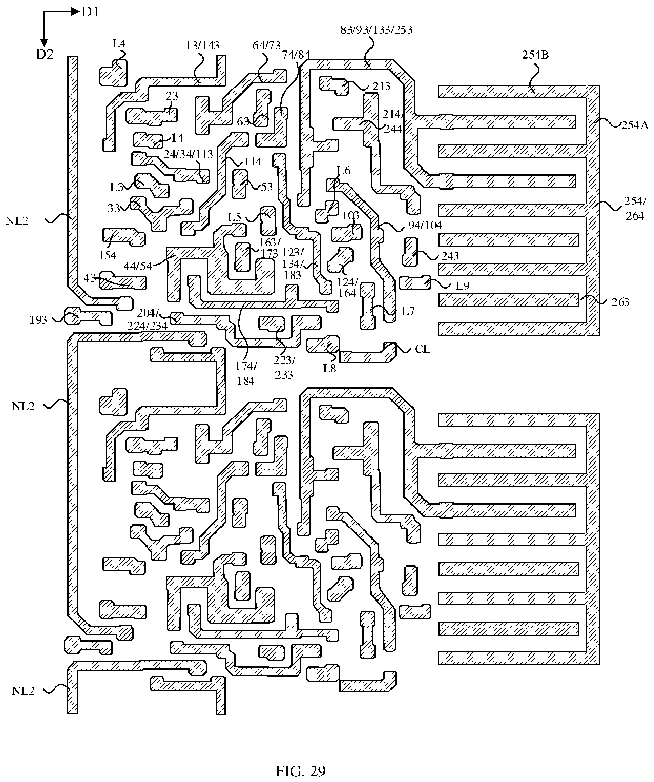

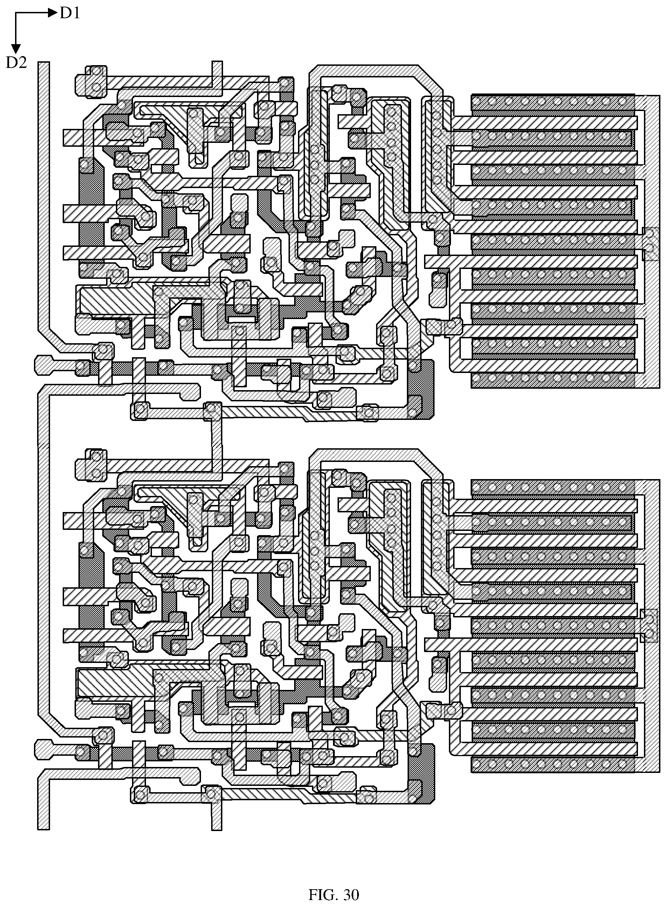

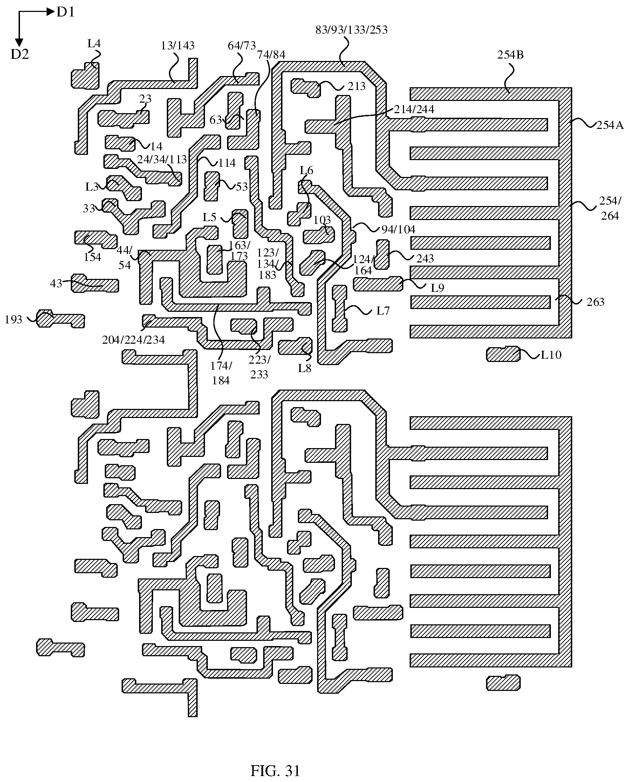

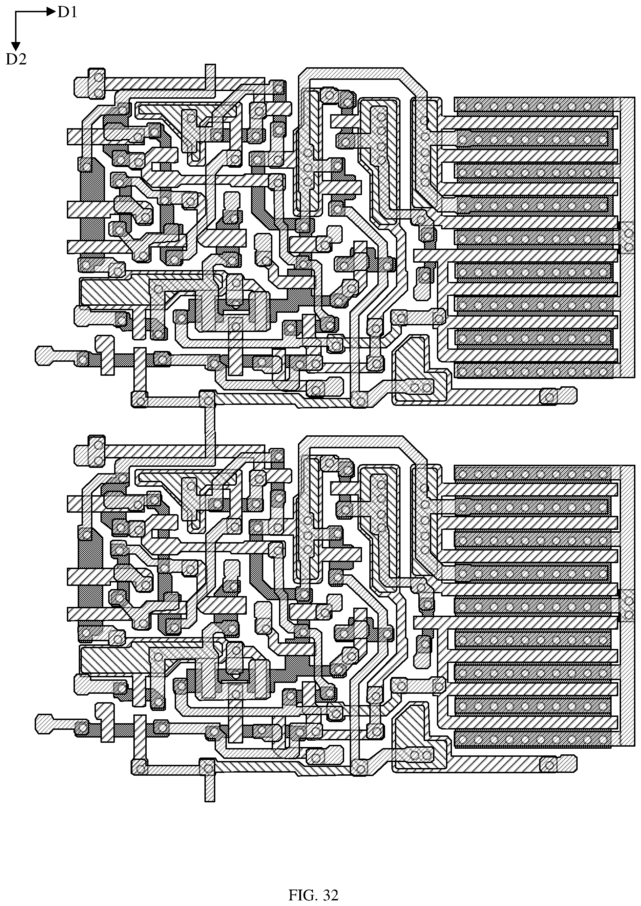

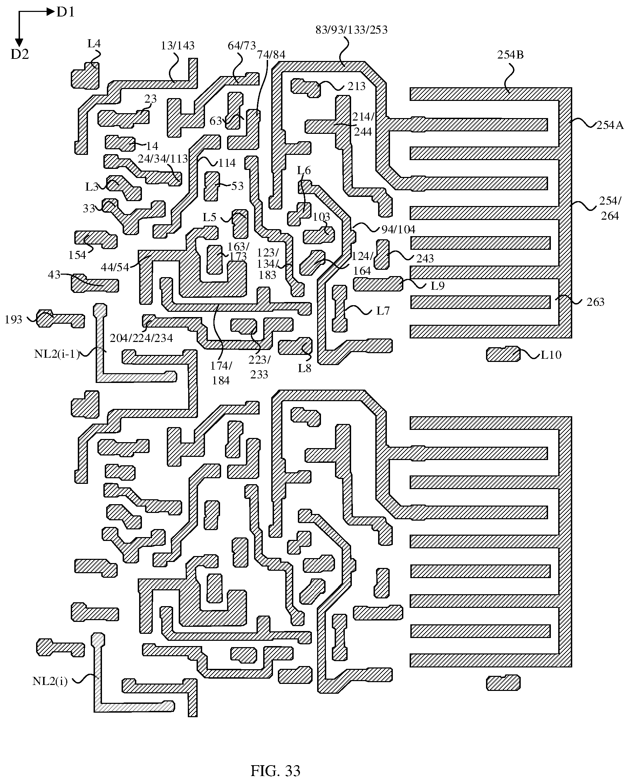

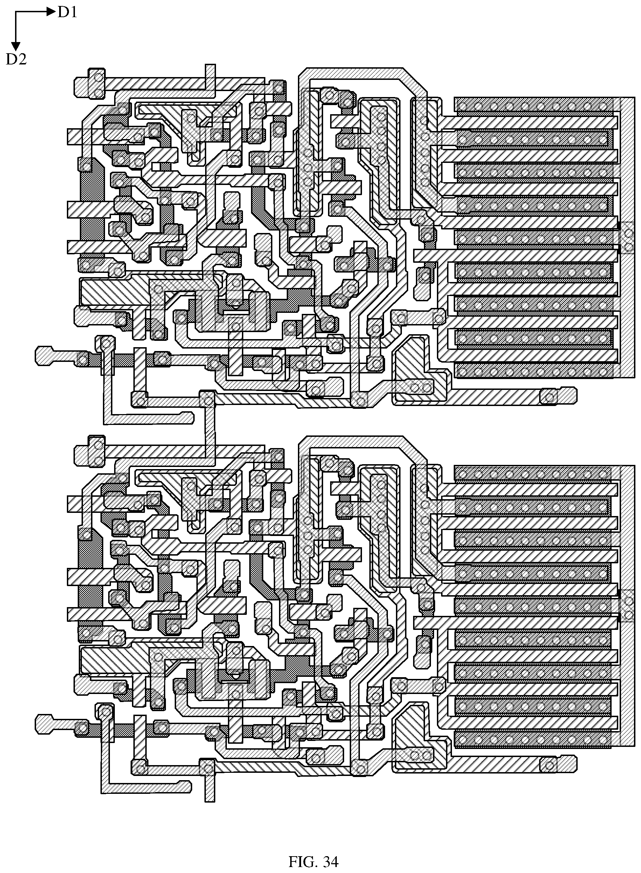

(5) A pattern of a third conductive layer is formed. In an exemplary implementation, forming the pattern of the third conductive layer may include: depositing a third conductive thin film on the base substrate on which the aforementioned patterns are formed, patterning the third conductive thin film using a patterning process, to form the third conductive layer disposed on the fifth insulation layer, as shown in FIGS. 27 to 34. FIG. 27 is a schematic diagram of a pattern of a third conductive layer in the display substrate according to FIG. 7, FIG. 28 is a schematic diagram of the display substrate according to FIG. 7 after the pattern of the third conductive layer is formed, FIG. 29 is a schematic diagram of a pattern of a third conductive layer in the display substrate according to FIG. 8. FIG. 30 is a schematic diagram of the display substrate according to FIG. 8 after the pattern of the third conductive layer is formed. FIG. 31 is a schematic diagram of a pattern of a third conductive layer in the display substrate according to FIG. 9. FIG. 32 is a schematic diagram of the display substrate according to FIG. 9 after the pattern of the third conductive layer is formed. FIG. 33 is a schematic diagram of a pattern of a third conductive layer in the display substrate according to FIGS. 10 and 11. FIG. 34 is a schematic diagram of the display substrate according to FIGS. 10 and 11 after the pattern of the third conductive layer is formed. In an exemplary implementation, the third conductive layer may be referred to as a first source drain metal (SD1) layer.

In an exemplary implementation, as shown in FIGS. 27 to 34, in the display substrates according to FIGS. 7 to 11, the pattern of the third conductive layer may include at least a first electrode 13 and a second electrode 14 of a first transistor to a first electrode 143 of a fourteenth transistor, a second electrode 154 of a fifteenth transistor, a first electrode 163 and a second electrode 164 of a sixteenth transistor to a first electrode 183 and a second electrode 184 of a eighteenth transistor, a first electrode 193 of a nineteenth transistor, a second electrode 204 of a twentieth transistor, a first electrode 213 and a second electrode 213 of a twenty-first transistor to a first electrode 263 and a second electrode 264 of a twenty-sixth transistor, and a third connection line L3 to a ninth connection line L9 located in each stage of shift register.

In an exemplary implementation, as shown in FIGS. 27 and 28, in the display substrate according to FIG. 7, the pattern of the third conductive layer may include at least a tenth connection line L10 and a second node connection line NL2 of a node connection line.

In an exemplary implementation, as shown in FIGS. 29 and 30, in the display substrate according to FIG. 8, the pattern of the third conductive layer may include at least a cascaded connection line CL and a second node connection line NL2 of a node connection line.

In an exemplary implementation, as shown in FIGS. 31 and 32, in the display substrate according to FIG. 9, the pattern of the third conductive layer may include at least a tenth connection line L10.

In an exemplary implementation, as shown in FIGS. 33 and 34, in the display substrate according to FIGS. 10 and 11, the pattern of the third conductive layer may include at least a second node connection line NL2 of a node connection line.

In an exemplary implementation, the first electrode 13 of the first transistor and the first electrode 143 of the fourteenth transistor are formed into an integral structure. The first electrode 13 of the first transistor (also the first electrode 143 of the fourteenth transistor) has a polyline shape and extends at least partially in the first direction D1. The first electrode 13 of the first transistor (also the first electrode 143 of the fourteenth transistor) is connected with the first region of the active pattern of the first transistor through the first via, with the first region of the active pattern of the fourteenth transistor through the twenty-fourth via, with a gate electrode of a twentieth transistor of a previous stage of shift register through the fifty-sixth via, and with the cascade output line through the sixty-eighth via.

In an exemplary implementation, the second electrode 14 of the first transistor is disposed separately. The second electrode 14 of the first transistor may have a shape of a strip and extend in the first direction D1. The second electrode 14 of the first transistor is connected with the second region of the active pattern of the first transistor through the second via, and with the gate electrode of the second transistor (also the gate electrode of the eighth transistor) through the fourth-third via.

In an exemplary implementation, the first electrode 23 of the second transistor is disposed separately. The first electrode 23 of the second transistor has a shape of a strip and extends in the first direction D1. The first electrode 23 of the second transistor is connected with the first region of the active pattern of the second transistor through the third via, and with the gate electrode of the first transistor through the forty-second via.

In an exemplary implementation, the second electrode 24 of the second transistor, the second electrode 34 of the third transistor, and the first electrode 113 of the eleventh transistor are formed into an integral structure. The integral structure of the second electrode 24 of the second transistor, the second electrode 34 of the third transistor, and the first electrode 113 of the eleventh transistor has a polyline shape and extends at least partially in the first direction D1. The second electrode 24 of the second transistor (also the second electrode 34 of the third transistor and the first electrode 113 of the eleventh transistor) is connected with the second region of the active pattern of the second transistor (also the first region of the active pattern of the eleventh transistor) through the fourth via, with the second region of the active pattern of the third transistor through the sixth via, and with the gate electrode of the fifth transistor through the forty-sixth via.

In an exemplary implementation, the first electrode 33 of the third transistor is disposed separately. The first electrode 33 of the second transistor has a shape of a strip and extends at least partially in the first direction D1. The first electrode 33 of the third transistor is connected with the first region of the active pattern of the third transistor through the fifth via, and with the gate electrode of the eleventh transistor (also the gate electrode of the fifteenth transistor) through the fifty-first via.

In an exemplary implementation, the first electrode 43 of the fourth transistor is disposed separately. The first electrode 43 of the fourth transistor has a shape of a strip and extends at least partially in the first direction D1. The first electrode 43 of the fourth transistor is connected with the first region of the active pattern of the fourth transistor through the seventh via.

In an exemplary implementation, the second electrode 44 of the fourth transistor and the second electrode 54 of the fifth transistor are disposed separately into an integral structure. The second electrode 44 of the fourth transistor (also the second electrode 54 of the fifth transistor) is connected with the second region of the active pattern of the fourth transistor through the eighth via, with the second region of the active pattern of the fifth transistor through the tenth via, with the gate electrode of the twenty-third transistor through the fifty-ninth via, and with the second plate of the third capacitor through the sixty-fifth via.

In an exemplary implementation, the first electrode 53 of the fifth transistor is disposed separately. The first electrode 53 of the fifth transistor has a shape of a strip and extends in the second direction D2. The first electrode 53 of the fifth transistor is connected with the first region of the active pattern of the fifth transistor through the ninth via.

In an exemplary implementation, the first electrode 63 of the sixth transistor is disposed separately. The first electrode 63 of the sixth transistor has a shape of letter "I". The first electrode 63 of the sixth transistor is connected with the first region of the active pattern of the sixth transistor through the eleventh via, and with the gate electrode of the seventh transistor through the forty-eighth via.

In an exemplary implementation, the second electrode 64 of the sixth transistor and the first electrode 73 of the seventh transistor are formed into an integral structure. The integral structure of the second electrode 64 of the sixth transistor and the first electrode 73 of the seventh transistor has a polyline shape and extends at least partially in the first direction D1. The second electrode 64 of the sixth transistor (also the first electrode 73 of the seventh transistor) is connected with the second region of the active pattern of the sixth transistor through the twelfth via, with the first region of the active pattern of the seventh transistor through the thirteenth via, and with the second plate of the first capacitor through the sixty-third via.

In an exemplary implementation, the second electrode 74 of the seventh transistor and the second electrode 84 of the eighth transistor are formed into an integral structure. The integral structure of the second electrode 74 of the seventh transistor and the first electrode 84 of the eighth transistor has a shape of "┘". The second electrode 74 of the seventh transistor (also the first electrode 84 of the eighth transistor) is connected with the second region of the active pattern of the seventh transistor through the fourteenth via, with the second region of the active pattern of the eighth transistor through the sixteenth transistor, and with the gate electrode of the ninth transistor (also the first plate of the second capacitor) through the forth-ninth via.

In an exemplary implementation, the first electrode 83 of the eighth transistor, the first electrode 93 of the ninth transistor, the first electrode 133 of the thirteenth transistor, and the first electrode 253 of the twenty-fifth transistor are formed into an integral structure. The first electrode 83 of the eighth transistor (also the first electrode 93 of the ninth transistor, the first electrode 133 of the thirteenth transistor, and the first electrode 253 of the twenty-fifth transistor) is connected with the first region of the active pattern of the eighth transistor (also the first region of the active pattern of the thirteenth transistor) through the fifteenth via, with the first region of the active pattern of the ninth transistor through the seventeenth via, with the first region of the active pattern of the twenty-fifth transistor through the thirty-ninth via, with the second plate of the second capacitor through the sixty-fourth via, and with the second plate of the sixth capacitor through the sixty-seventh via.

In an exemplary implementation, the second electrode 94 of the ninth transistor and the first electrode 104 of the tenth transistor are formed into an integral structure. The integral structure of the second electrode 94 of the ninth transistor and the first electrode 104 of the tenth transistor has a shape of a strip and extends at least partially in the second direction D2. In the display substrate according to FIGS. 7 and 9 to 11, the second electrode 94 of the ninth transistor (also the second electrode 104 of the tenth transistor) is connected with the second region of the active pattern of the ninth transistor through the eighteenth via, with the second region of the active pattern of the tenth transistor through the twentieth via, with the cascaded output line through the sixty-eighth via, and with the second plate of the fourth capacitor through the seventy-first via. In the display substrate according to FIG. 8, the second electrode 94 of the ninth transistor (also the second electrode 104 of the tenth transistor) is connected with the second region of the active pattern of the ninth transistor through the eighteenth via, with the second region of the active pattern of the tenth transistor through the twentieth via, and with the voltage stabilization connection line through the seventy-three via.

In an exemplary implementation, the first electrode 103 of the tenth transistor may be disposed separately. The first electrode 103 of the tenth transistor has a shape of a strip and extends in the first direction D1. The first electrode 103 of the tenth transistor is connected with the first region of the active pattern of the tenth transistor through the nineteenth via.

In an exemplary implementation, the second electrode 114 of the eleventh transistor may be disposed separately. The second electrode 114 of the eleventh transistor has a polyline shape and extends at least partially in the second direction D2. The second electrode 114 of the eleventh transistor is connected with the second region of the active pattern of the eleventh transistor through the twenty-first via, and with the gate electrode of the sixth transistor (also the first plate of the first capacitor) through the forty-seventh via.

In an exemplary implementation, the first electrode 123 of the twelfth transistor, the second electrode 134 of the thirteenth transistor, and the first electrode 183 of the eighteenth transistor are formed into an integral structure. The integral structure of the first electrode 123 of the twelfth transistor, the second electrode 134 of the thirteenth transistor, and the first electrode 183 of the eighteenth transistor has a polyline shape and extends at least partially in the second direction D2. The first electrode 123 of the twelfth transistor (also the second electrode 134 of the thirteenth transistor and the first electrode 183 of the eighteenth transistor) is connected with the first region of the active pattern of the twelfth transistor (also the second region of the active pattern of the thirteenth transistor) through the twenty-second via, with the first region of the active pattern of the eighteenth transistor through the twenty-eighth via, and with the gate electrode of the second transistor (also the gate electrode of the eighth transistor) through the forty-third via.

In an exemplary implementation, the second electrode 124 of the twelfth transistor and the first electrode 164 of the sixteenth transistor are formed into an integral structure. The integral structure of the second electrode 124 of the twelfth transistor and the first electrode 164 of the sixteenth transistor has a shape of a straight line, and an extension direction of this integral structure intersects with the first direction D1 and the second direction D2. The second electrode 124 of the twelfth transistor (also the second electrode 164 of the sixteenth transistor) is connected with the second region of the active pattern of the twelfth transistor (also the second region of the active pattern of the sixteenth transistor) through the twenty-third via, and with the gate electrode of the tenth transistor through the fiftieth via.

In an exemplary implementation, the second electrode 154 of the fifteenth transistor may be disposed separately. The second electrode 154 of the fifteenth transistor has a shape of a strip and extends in the first direction D1. The second electrode 154 of the fifteenth transistor is connected with the second region of the active pattern of the fifteenth transistor through the twenty-fifth via, and with the gate electrode of the fourth transistor (also the gate electrode of the sixteenth transistor, the gate electrode of the seventeenth transistor, and the first plate of the third capacitor) through the forth-fifth via.

In an exemplary implementation, the first electrode 163 of the sixteenth transistor and the first electrode 173 of the seventeenth transistor are formed into an integral structure. The integral structure of the first electrode 163 of the sixteenth transistor and the first electrode 173 of the seventeenth transistor has a shape of a strip and extends in the second direction D2. The first electrode 163 of the sixteenth transistor (also the first electrode 173 of the seventeenth transistor) is connected with the first region of the active pattern of the sixteenth transistor (also the first region of the active pattern of the seventeenth transistor) through the twenty-sixth via, and with the gate electrode of the fourth transistor (also the gate electrode of the sixteenth transistor, the gate electrode of the seventeenth transistor, and the first plate of the third capacitor) through the forty-fifth via.

In an exemplary implementation, the second electrode 174 of the seventeenth transistor and the second electrode 184 of the eighteenth transistor are formed into an integral structure. The integral structure of the second electrode 174 of the seventeenth transistor and the second electrode 184 of the eighteenth transistor has a shape of letter "F" rotating to the left. The second electrode 174 of the seventeenth transistor (also the second electrode 184 of the eighteenth transistor) is connected with the second region of the active pattern of the seventeenth transistor through the twenty-seventh via, with the second region of the active pattern of the eighteenth transistor through the twenty-ninth via, and with the first connection line through the sixty-ninth via.

In an exemplary implementation, the first electrode 193 of the nineteenth transistor may be disposed separately. The first electrode 193 of the nineteenth transistor has a shape of a strip and extends in the first direction D1. The first electrode 193 of the nineteenth transistor is connected with the first region of the active pattern of the nineteenth transistor through the thirtieth via.

In an exemplary implementation, the second electrode 204 of the twentieth transistor, the second electrode 224 of the twenty-second transistor, and the second electrode 234 of the twenty-third transistor are formed into an integral structure. The second electrode 204 of the twentieth transistor, the second electrode 224 of the twenty-second transistor, and the second electrode 234 of the twenty-third transistor have a polyline shape and extend at least partially in the first direction D1. The second electrode 204 of the twentieth transistor (also the second electrode 224 of the twenty-second transistor and the second electrode 234 of the twenty-third transistor) is connected with the second region of the active pattern of the twentieth transistor through the thirty-first via, with the second region of the active pattern of the twenty-second transistor through the thirty-fifth via, with the second region of the active pattern of the twenty-third transistor through the thirty-sixth via, and with the gate electrode of the eighteenth transistor through the fifty-fourth via.

In an exemplary implementation, the first electrode 213 of the twenty-first transistor is disposed separately. The first electrode 213 of the twenty-first transistor has a shape of a strip and extends in the first direction D1. The first electrode 213 of the twenty-first transistor is connected with the first region of the active pattern of the twenty-first transistor through the thirty-second via, and is connected with the gate electrode of the ninth transistor (also the first plate of the second capacitor) through the forty-ninth via.

In an exemplary implementation, the second electrode 214 of the twenty-first transistor and the second electrode 244 of the twenty-fourth transistor are formed into an integral structure. The integral structure of the second electrode 214 of the twenty-first transistor and the second electrode 244 of the twenty-fourth transistor has a polyline shape and extends at least partially in the second direction D2. The second electrode 214 of the twenty-first transistor (also the second electrode 244 of the twenty-fourth transistor) is connected with the second region of the active pattern of the twenty-first transistor through the thirty-third via, with the second region of the active pattern of the twenty-fourth transistor through the thirty-eighth via, with the gate electrode of the twenty-fifth transistor (also the first plate of the sixth capacitor) through the sixty-first via, and with the second plate of the fifth capacitor through the sixty-sixth via.

In an exemplary implementation, the second electrode 224 of the twenty-second transistor and the second electrode 234 of the twenty-third transistor are formed into an integral structure. The integral structure of the second electrode 224 of the twenty-second transistor and the second electrode 234 of the twenty-third transistor has a shape of a strip and extends in the first direction D1. The first electrode 223 of the twenty-second transistor (also the first electrode 233 of the twenty-third transistor) is connected with the first region of the active pattern of the twenty-second transistor (also the first region of the active pattern of the twenty-third transistor) through the thirty-fourth via.

In an exemplary implementation, the first electrode 243 of the twenty-fourth transistor is disposed separately. The first electrode 243 of the twenty-fourth transistor has a shape of a strip and extends in the second direction D2. The first electrode 243 of the twenty-fourth transistor is connected with the first region of the active pattern of the twenty-fourth transistor through the thirty-seventh via.

In an exemplary implementation, the second electrode 254 of the twenty-fifth transistor and the second electrode 264 of the twenty-sixth transistor are formed into an integral structure. The integral structure of the second electrode 254 of the twenty-fifth transistor and the second electrode 264 of the twenty-sixth transistor has a comb-like shape, and the comb teeth are located on a side of the comb back away from the display area. The second electrode 254 of the twenty-fifth transistor (also the second electrode 264 of the twenty-sixth transistor) is connected with the second region of the active pattern of the twenty-fifth transistor (also the second region of the active pattern of the twenty-sixth transistor) through the fortieth via, and is connected with the second connection line through the seventieth via.

In an exemplary implementation, the first electrode 263 of the twenty-sixth transistor is disposed separately. The first electrode 263 of the twenty-sixth transistor has a shape of a strip and extends in the first direction D1. The first electrode 263 of the twenty-sixth transistor is connected with the first region of the active pattern of the twenty-sixth transistor through the forty-first via.

In an exemplary implementation, the third connection line L3 has a shape of a strip and extends at least partially in the first direction D1. The third connection line L3 is connected with the gate electrode of the third transistor (also the gate electrode of the fourteenth transistor) through the forty-forth via.

In an exemplary implementation, the fourth connection line L4 has a shape of a strip and extends at least partially in the first direction D1. The fourth connection line L4 is connected with the gate electrode of the seventh transistor through the forty-eighth via.

In an exemplary implementation, the fifth connection line L5 has a shape of a strip and extends at least partially in the second direction D2. The fifth connection line L5 is connected with the gate electrode of the twelfth transistor through the fifty-second via.

In an exemplary implementation, the sixth connection line L6 has a shape of a strip and extends at least partially in the first direction D1. The sixth connection line L6 is connected with the gate electrode of the thirteenth transistor through the fifty-third via.

In an exemplary implementation, the seventh connection line L7 has a shape of a strip and extends at least partially in the second direction D2. The seventh connection line L7 is connected with the gate electrode of the eighteenth transistor through the fifty-fourth via, and with the gate electrode of the twenty-first transistor (also the first plate of the fifth capacitor) through the fifty-seventh via.

In an exemplary implementation, the eighth connection line L8 has a shape of a strip and extends at least partially in the first direction D1. The eighth connection line L8 is connected with the gate electrode of the twenty-second transistor through the fifty-eighth via.

In an exemplary implementation, the ninth connection line L9 has a shape of a strip and extends at least partially in the first direction D1. The ninth connection line L9 is connected with the gate electrode of the twenty-fourth transistor (the gate electrode of the twenty-sixth transistor) through the sixtieth via, and with the first connection line through the sixty-ninth via.

In an exemplary implementation, the tenth connection line L10 is connected with the first plate of the fourth capacitor through the sixty-second via.

In an exemplary implementation, the cascaded connection line is connected with the cascaded output line through the sixty-eighth via, and with the voltage stabilization connection line through the seventy-second via.

In an exemplary implementation, a second node connection line of an i-th node connection line is connected with a gate electrode of a nineteenth transistor in an (i+1)-st stage of shift register.

In an exemplary implementation, the second node connection line NL2 in the display substrate according to FIGS. 7 and 8 has a shape of letter "n" with an opening facing the display area, and the second node connection line NL2 in the display substrate according to FIGS. 10 and 11 has a shape of "└".

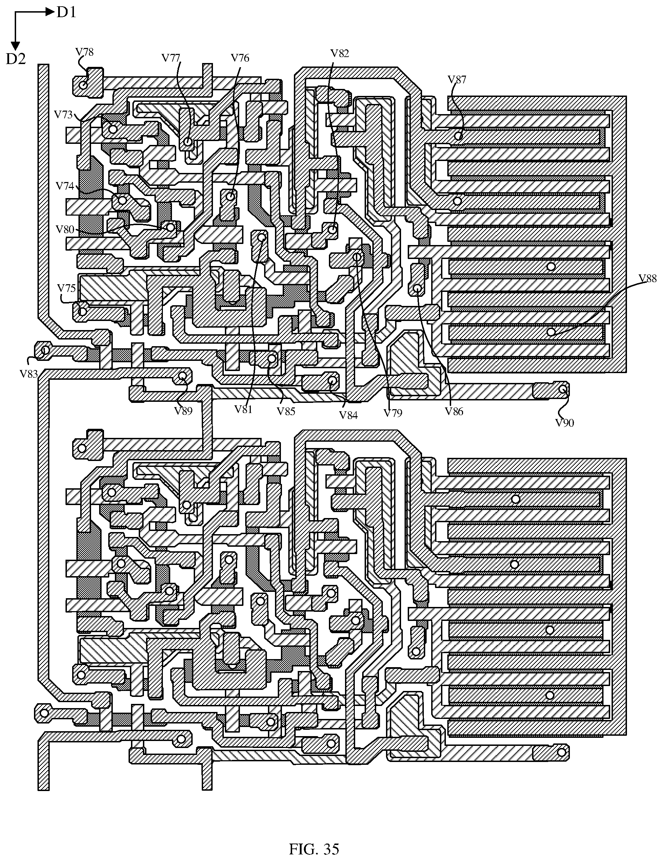

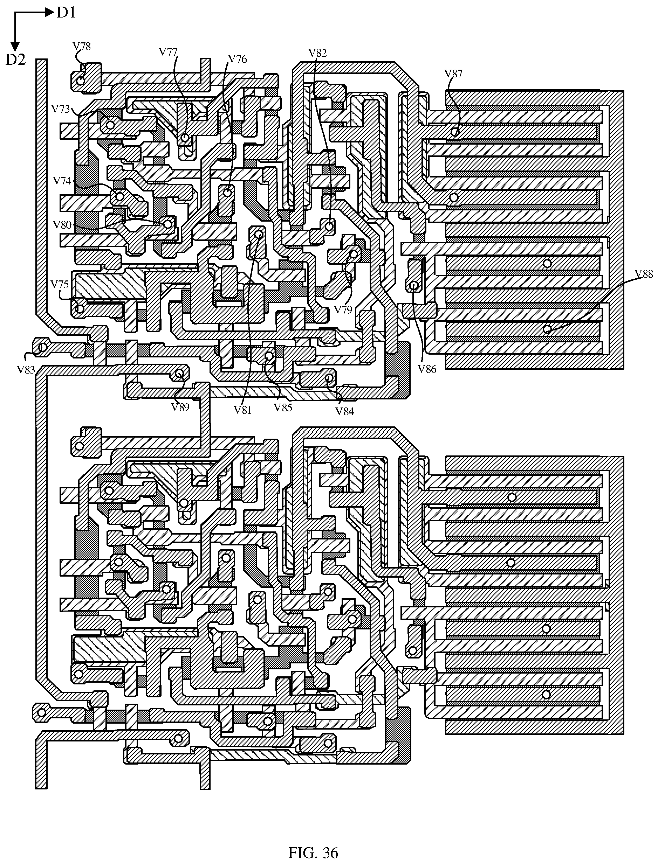

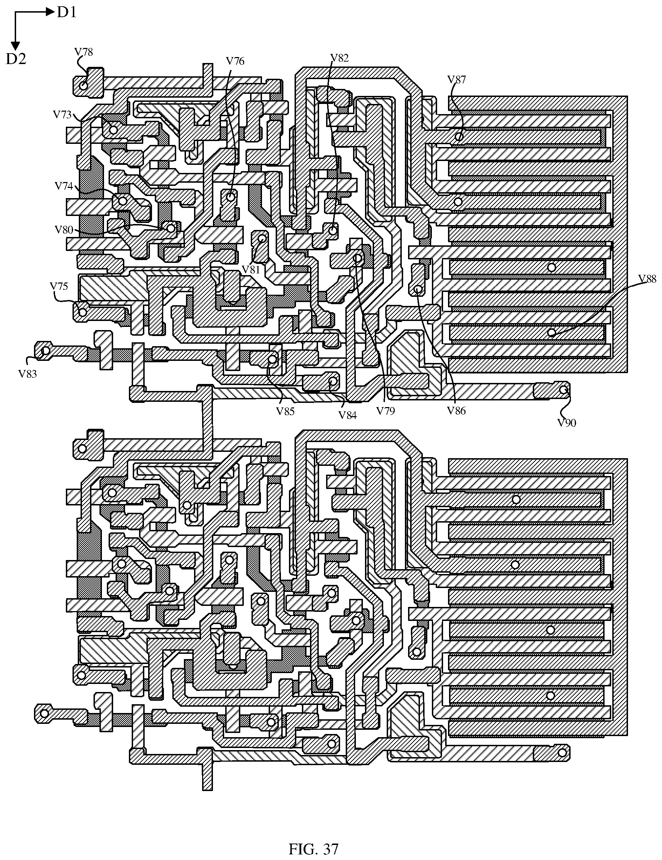

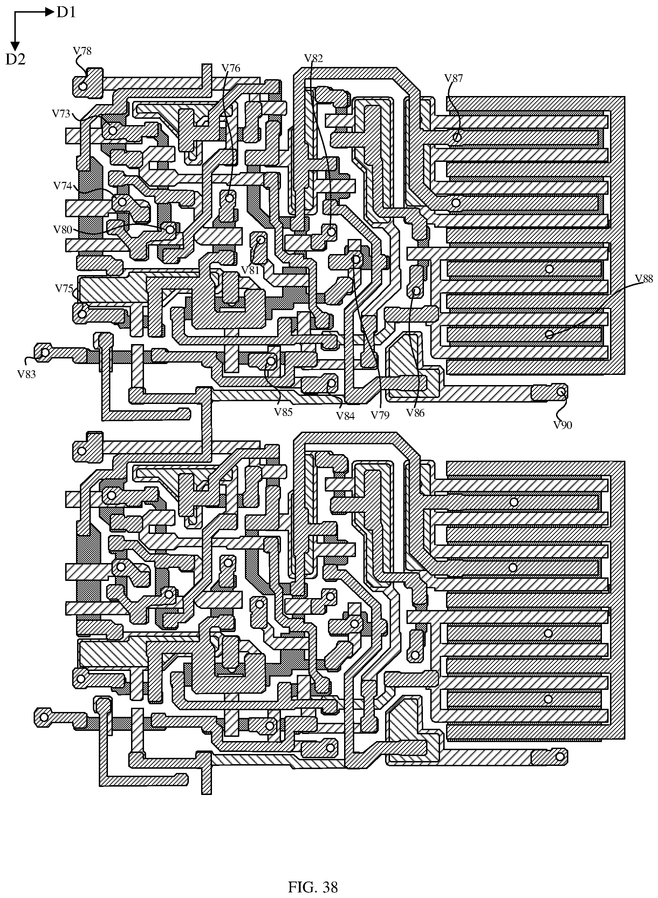

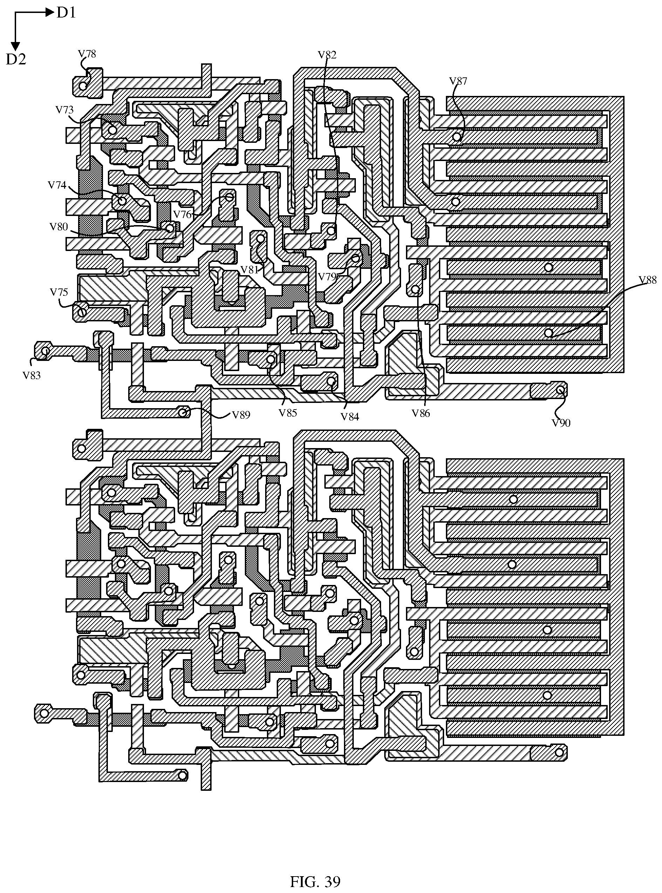

(6) A pattern of a fourth insulation layer is formed. In an exemplary implementation, forming the pattern of the fourth insulation layer may include: depositing a fourth insulation thin film on the base substrate on which the aforementioned patterns are formed, patterning the fourth insulation thin film by a patterning process, to form the pattern of the fourth insulation layer covering the aforementioned structures, wherein the fourth insulation layer is provided with patterns of a plurality of vias. As shown in FIGS. 35 to 39, FIG. 35 is a schematic diagram of the display substrate according to FIG. 7 after a pattern of a fourth insulation layer is formed. FIG. 36 is a schematic diagram of the display substrate according to FIG. 8 after a pattern of a fourth insulation layer is formed. FIG. 37 is a schematic diagram of the display substrate according to FIG. 9 after a pattern of a fourth insulation layer is formed. FIG. 38 is a schematic diagram of the display substrate according to FIG. 10 after a pattern of a fourth insulation layer is formed. FIG. 39 is a schematic diagram of the display substrate according to FIG. 11 after a pattern of a fourth insulation layer is formed.

In an exemplary implementation, as shown in FIG. 35, the pattern of the fourth insulation layer in the display substrate according to FIG. 7 may include at least a seventy-third via V73 to a ninetieth via V90 in each stage of shift register.

In an exemplary implementation, as shown in FIG. 36, the pattern of the fourth insulation layer in the display substrate according to FIG. 8 may include at least a seventy-third via V73 to an eighty-ninth via V89 in each stage of shift register.

In an exemplary implementation, as shown in FIGS. 37 and 38, the pattern of the fourth insulation layer in the display substrate according to FIGS. 9 and 10 may include at least a seventy-third via V73 to a seventy-sixth via V76, a seventy-eighth via V78 to an eighty-eighth via V88, and a ninetieth via V90 in each stage of shift register.

In an exemplary implementation, as shown in FIG. 39, the pattern of the fourth insulation layer in the display substrate according to FIG. 11 may include at least a seventy-third via V73 to a seventy-sixth via V76, and a seventy-eighth via V78 to a ninetieth via V90 in each stage of shift register.

In an exemplary implementation, an orthographic projection of the seventy-third via V73 on the base substrate is within a range of an orthographic projection of the first electrode of the second transistor on the base substrate. The seventy-third via V73 exposes a surface of the first electrode of the second transistor. The seventy-third via V73 is configured such that one of the first clock signal line and the second clock signal line to be formed subsequently is connected with the first electrode of the second transistor through the seventy-third via V73. FIGS. 35 to 39 illustrate an example in which the first electrode of the second transistor is connected with the second clock signal line.

In an exemplary implementation, an orthographic projection of the seventy-fourth via V74 on the base substrate is within a range of an orthographic projection of the third connection line on the base substrate. The seventy-fourth via V74 exposes a surface of the third connection line. The seventy-fourth via V74 is configured such that one of the first clock signal line and the second clock signal line to be formed subsequently is connected with the third connection line through the seventy-fourth via V74. FIGS. 35 to 39 are illustrated by taking a connection of the third connection line with the second clock signal line as an example.

In an exemplary implementation, an orthographic projection of the seventy-fifth via V75 on the base substrate is within a range of an orthographic projection of the first electrode of the fourth transistor on the base substrate. The seventy-fifth via V75 exposes a surface of the first electrode of the fourth transistor. The seventy-fifth via V75 is configured such that the other of the first clock signal line and the second clock signal line to be formed subsequently is connected with the first electrode of the fifth transistor (also the first electrode of the eighth transistor, the first electrode of the ninth transistor, and the first electrode of the fourth transistor) through the seventy-fifth via V75. Figs. 35 to 39 are illustrated by taking a connection of the first electrode of the fourth transistor with the second clock signal line as an example.

In an exemplary implementation, an orthographic projection of the seventy-sixth via V76 on the base substrate is within a range of an orthographic projection of the first electrode of the fifth transistor on the base substrate. The seventy-sixth via V76 exposes a surface of the first electrode of the fifth transistor. The seventy-sixth via V76 is configured such that a second power supply line to be formed subsequently is connected with the first electrode of the fifth transistor through the seventy-sixth via V76.

In an exemplary implementation, an orthographic projection of the seventy-seventh via V77 on the base substrate is within a range of an orthographic projection of the second electrode of the sixth transistor (also the first electrode of the seventh transistor) on the base substrate. The seventy-seventh via V77 exposes a surface of the second electrode of the sixth transistor (also the first electrode of the seventh transistor). The seventy-seventh via V77 is configured such that a first node connection line of a node connection line to be formed subsequently is connected with the second electrode of the sixth transistor (also the first electrode of the seventh transistor) through the seventy-seventh via V77.

In an exemplary implementation, an orthographic projection of the seventy-eighth via V78 on the base substrate is within a range of an orthographic projection of the fourth connection line on the base substrate. The seventy-eighth via V78 exposes a surface of the fourth connection line. The seventy-eighth via V78 is configured such that the other of the first clock signal line and the second clock signal line to be formed subsequently is connected with the fourth connection line through the seventy-eighth via V78.

In an exemplary implementation, an orthographic projection of the seventy-ninth via V79 on the base substrate is within a range of an orthographic projection of the first electrode of the tenth transistor on the base substrate. The seventy-ninth via V79 exposes a surface of the first electrode of the tenth transistor. The seventy-ninth via V79 is configured such that the fifth power supply line to be formed subsequently is connected with the first electrode of the tenth transistor through the seventy-ninth via V79.

In an exemplary implementation, an orthographic projection of the eightieth via V80 on the base substrate is within a range of an orthographic projection of the first electrode of the third transistor on the base substrate. The eightieth via V80 exposes a surface of the first electrode of the third transistor. The eightieth via V80 is configured such that the first power supply line to be formed subsequently is connected with the first electrode of the third transistor through the eightieth via V80.

In an exemplary implementation, an orthographic projection of the eighty-first via V81 on the base substrate is within a range of an orthographic projection of the fifth connection line on the base substrate. The eighty-first via V81 exposes a surface of the fifth connection line. The eighty-first via V81 is configured such that the third power supply line to be formed subsequently is connected with the fifth connection line through the eighty-first via V81.

In an exemplary implementation, an orthographic projection of the eighty-second via V82 on the base substrate is within a range of an orthographic projection of the sixth connection line on the base substrate. The eighty-second via V82 exposes a surface of the sixth connection line. The eighty-second via V82 is configured such that the fourth power supply line to be formed subsequently is connected with the sixth connection line through the eighty-second via V82.

In an exemplary implementation, an orthographic projection of the eighty-third via V83 on the base substrate is within a range of an orthographic projection of the first electrode of the nineteenth transistor on the base substrate. The eighty-third via V83 exposes a surface of the first electrode of the nineteenth transistor. The eighty-third via V83 is configured such that a latch signal line to be formed subsequently is connected with the first electrode of the nineteenth transistor through the eighty-third via V83.

In an exemplary implementation, an orthographic projection of the eighty-fourth via V84 on the base substrate is within a range of an orthographic projection of the eighth connection line on the base substrate. The eighty-fourth via V84 exposes a surface of the eighth connection line. The eighty-fourth via V84 is configured such that the fourth power supply line to be formed subsequently is connected with the eighth connection line through the eighty-fourth via V84.

In an exemplary implementation, an orthographic projection of the eighty-fifth via V85 on the base substrate is within a range of an orthographic projection of the first electrode of the twenty-second transistor (also the first electrode of the twenty-third transistor) on the base substrate. The eighty-fifth via V85 exposes a surface of the first electrode of the twenty-second transistor (also the first electrode of the twenty-third transistor). The eighty-fifth via V85 is configured such that the third power supply line to be formed subsequently is connected with the first electrode of the twenty-second transistor (also the first electrode of the twenty-third transistor) through the eighty-fifth via V85.

In an exemplary implementation, an orthographic projection of the eighty-sixth via V86 on the base substrate is within a range of an orthographic projection of the first electrode of the twenty-fourth transistor on the base substrate. The eighty-sixth via V86 exposes a surface of the first electrode of the twenty-fourth transistor, and the eighty-sixth via V86 configured such that the sixth power supply line to be formed subsequently is connected with the first electrode of the twenty-fourth transistor through the eighty-sixth via V86.

In an exemplary implementation, an orthographic projection of the eighty-seventh via V87 on the base substrate is within a range of an orthographic projection of the first electrode of the eighth transistor (also the first electrode of the ninth transistor, the first electrode of the thirteenth transistor, and the first electrode of the twenty-fifth transistor) on the base substrate. The eighty-seventh via V87 exposes a surface of the first electrode of the eighth transistor (also the first electrode of the ninth transistor, the first electrode of the thirteenth transistor and the first electrode of the twenty-fifth transistor). The eighty-seventh via V87 is configured such that the seventh power supply line or the eighth power supply line to be formed subsequently is connected with the first electrode of the eighth transistor (also the first electrode of the ninth transistor, the first electrode of the thirteenth transistor, and the first electrode of the twenty-fifth transistor) through the eighty-seventh via V87.

In an exemplary implementation, an orthographic projection of the eighty-eighth via V88 on the base substrate is within a range of an orthographic projection of the first electrode of the twenty-sixth transistor on the base substrate. The eighty-eighth via V88 exposes a surface of the first electrode of the twenty-sixth transistor. The eighty-eighth via V88 is configured such that the ninth power supply line to be formed subsequently is connected with the first electrode of the twenty-sixth transistor through the eighty-eighth via V88.

In an exemplary implementation, an orthographic projection of the eighty-ninth via V89 on the base substrate is within a range of an orthographic projection of the second node connection line on the base substrate. The eighty-ninth via V89 exposes a surface of the second node connection line. In the display substrate according to FIGS. 7, 8 and 10, the eighty-ninth via V89 is configured such that the first node connection line to be formed subsequently is connected with the second node connection line through the eighty-ninth via V89. In the display substrate according to FIG. 11, the eighty-ninth via V89 is configured such that the third node connection line to be formed subsequently is connected with the second node connection line through the eighty-ninth via V89.

In an exemplary implementation, an orthographic projection of the ninetieth via V90 on the base substrate is within a range of an orthographic projection of the tenth connection line on the base substrate. The ninetieth via V90 exposes a surface of the tenth connection line. The ninetieth via V90 is configured such that the ninth power supply line to be formed subsequently is connected with the tenth connection line through the ninetieth via V90.

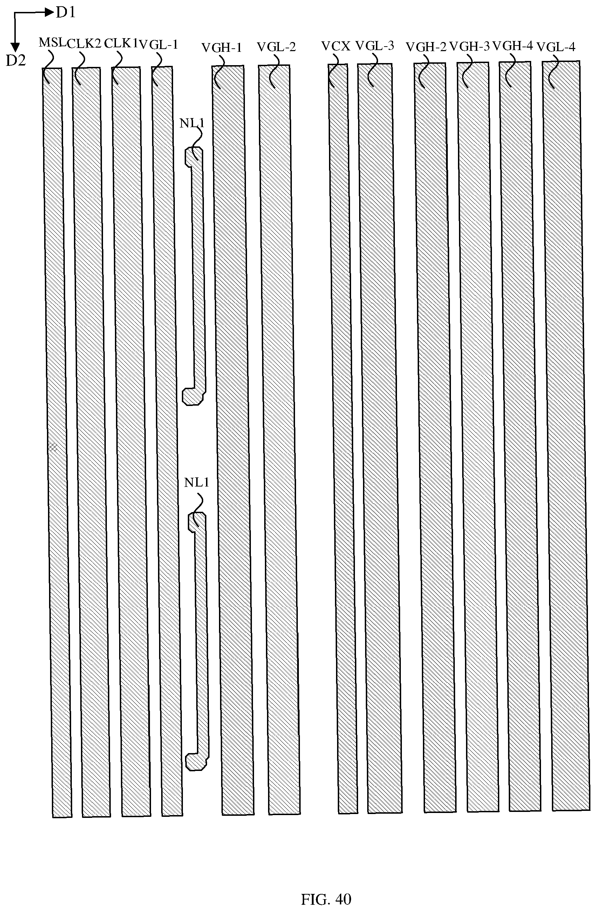

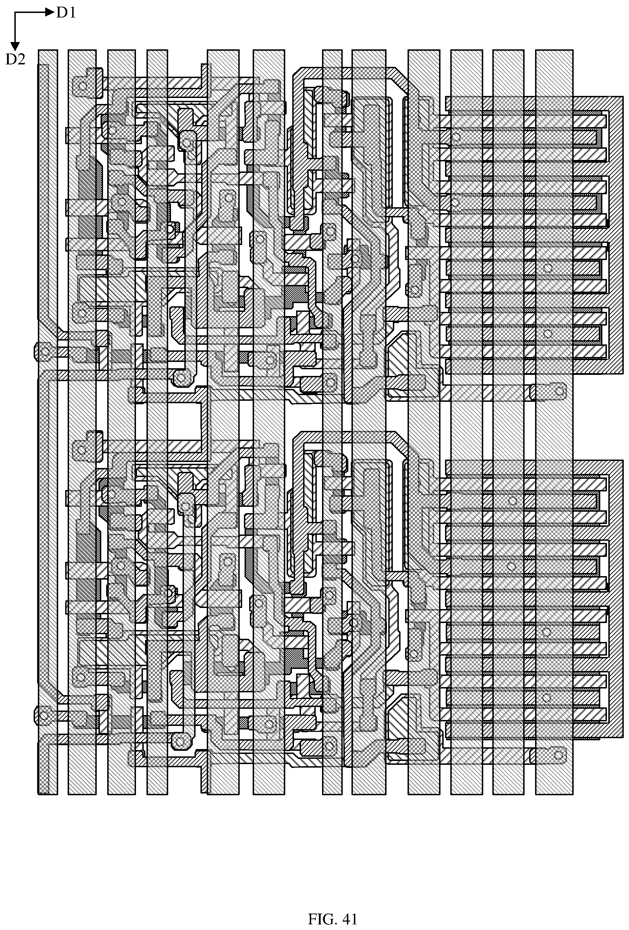

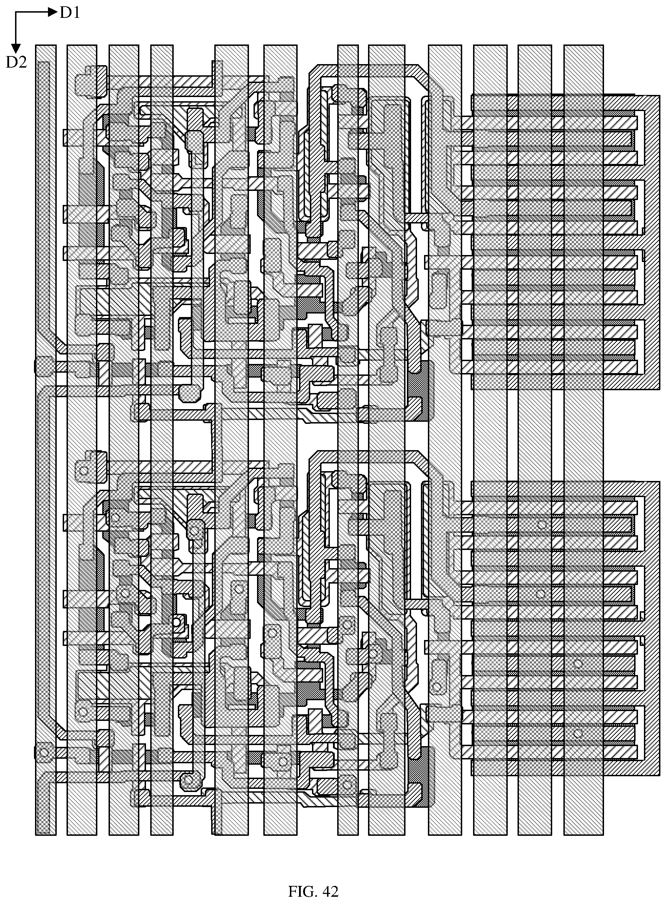

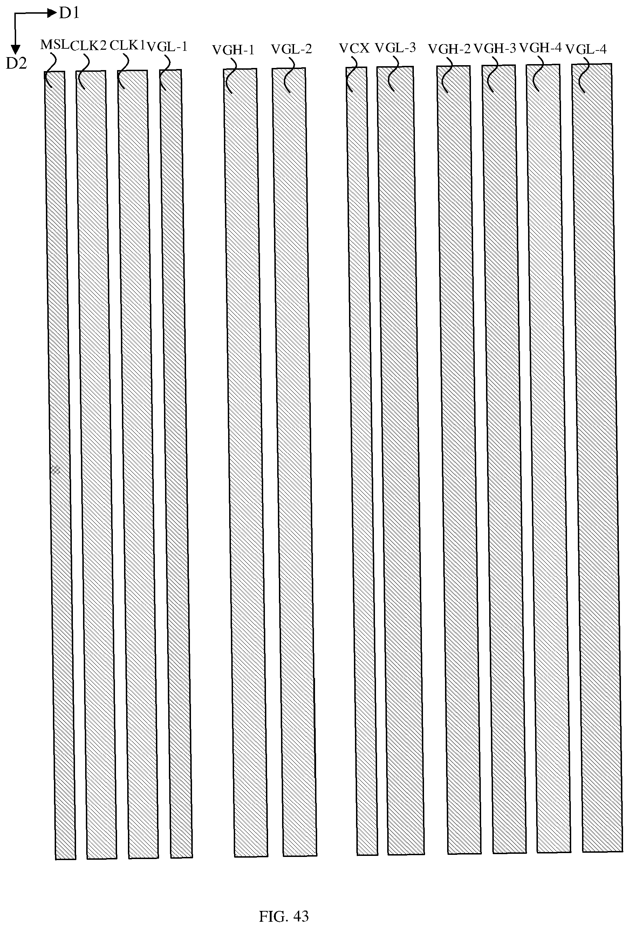

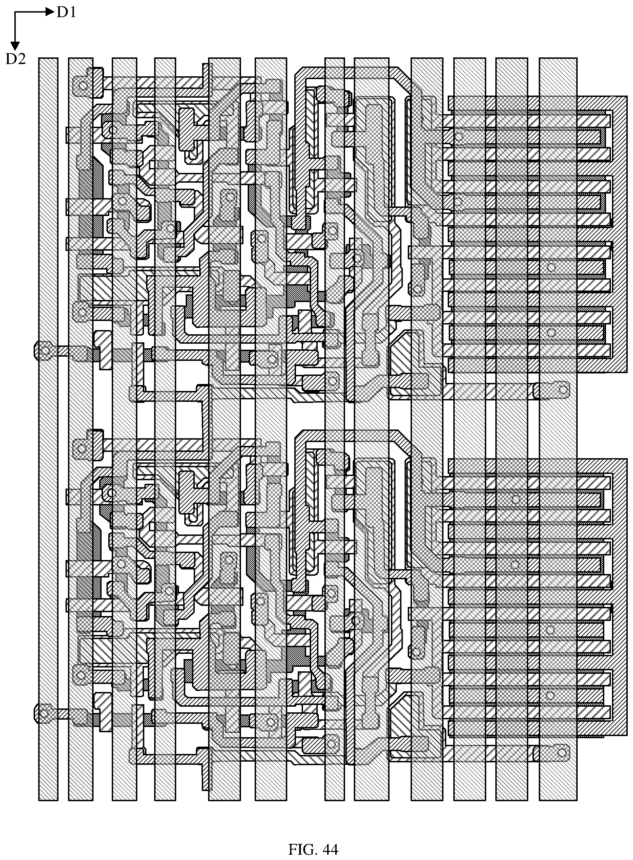

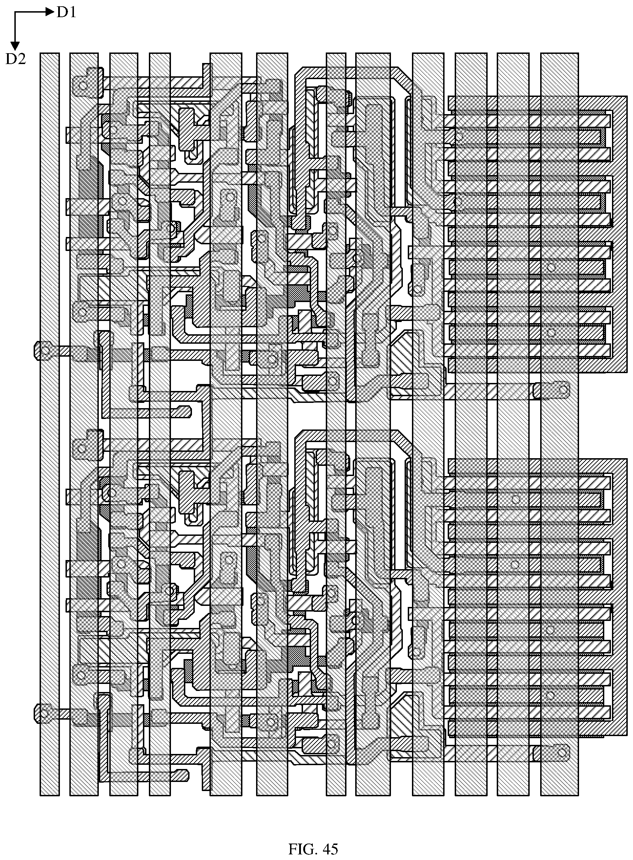

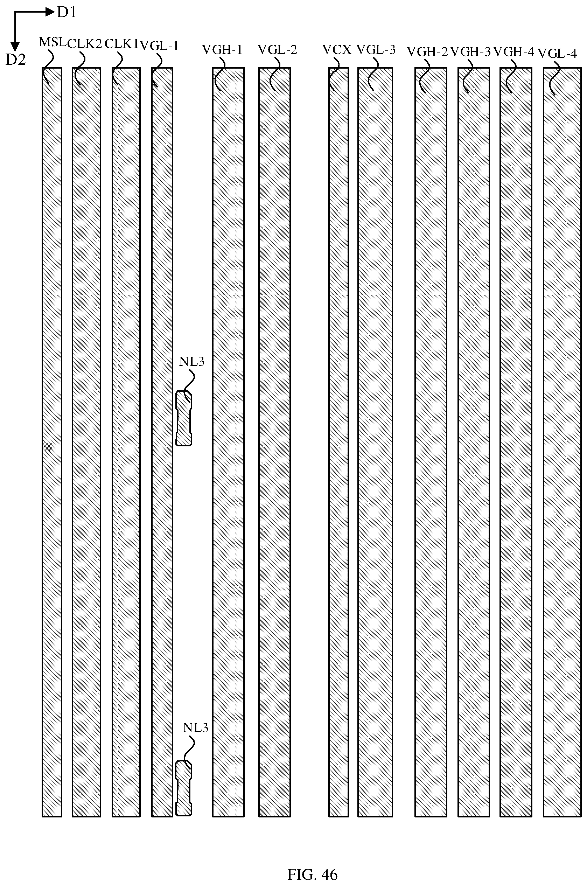

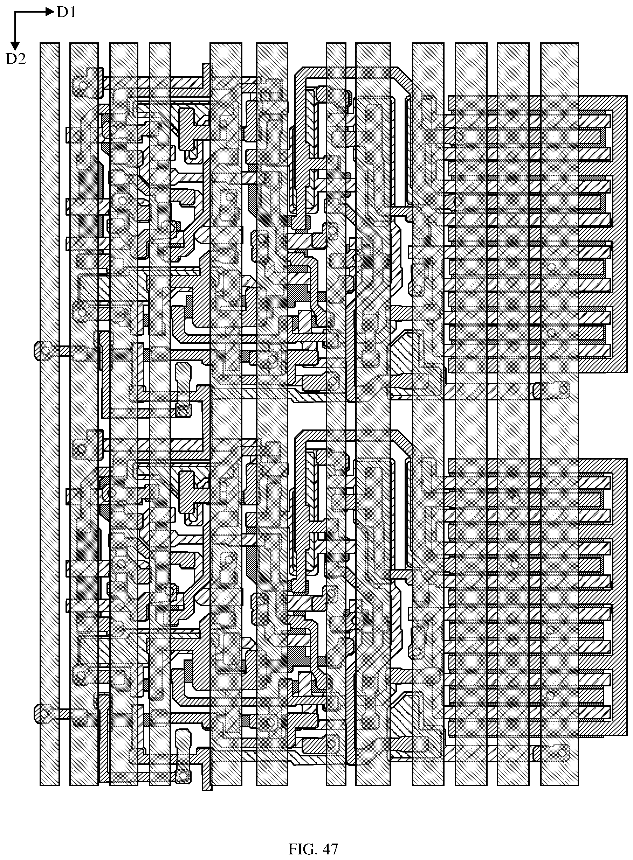

(7) A pattern of a fourth conductive layer is formed. In an exemplary implementation, forming the pattern of the fourth conductive layer may include: depositing a fourth conductive thin film on the base substrate on which the aforementioned patterns are formed, patterning the fourth conductive thin film using a patterning process, to form the fourth conductive layer disposed on the fourth insulation layer, as shown in FIGS. 40 to 47. FIG. 40 is a schematic diagram of a pattern of a fourth conductive layer of the display substrate according to FIGS. 7 and 8. FIG. 41 is a schematic diagram of the display substrate according to FIG. 7 after the pattern of the fourth conductive layer is formed. FIG. 42 is a schematic diagram of the display substrate according to FIG. 8 after the pattern of the fourth conductive layer is formed. FIG. 43 is a schematic diagram of the pattern of the fourth conductive layer in the display substrate according to FIG. 9 and 10. FIG. 44 is a schematic diagram of the display substrate according to FIG. 10 after the pattern of the fourth conductive layer is formed. FIG. 45 is a schematic diagram of the display substrate according to FIG. 10 after the pattern of the fourth conductive layer is formed. FIG. 46 is a schematic diagram of the pattern of the fourth conductive layer of the display substrate according to FIG. 11. FIG. 47 is a schematic diagram of the display substrate according to FIG. 11 after the pattern of the fourth conductive layer is formed. In an exemplary implementation, the fourth conductive layer may be referred to as a second source drain metal (SD2) layer.

In an exemplary implementation, as shown in FIGS. 41 to 47, in the display substrate according to FIGS. 7 to 11, the pattern of the fourth conductive layer may at least include a latch signal line MSL, a second clock signal line CLK2, a first clock signal line CLK1, a first power supply line VGL-1, a second power supply line VGH-1, a third power supply line VGL-2, a fourth power supply line VCX, a fifth power supply line VGL-3, a sixth power supply line VGH-2, a seventh power supply line VGH-3, an eighth power supply line VGH-4, and a ninth power supply line VGL-4.

In an exemplary implementation, as shown in FIG. 41, in the display substrate according to FIGS. 7 and 8, the pattern of the fourth conductive layer may include at least a first node connection line NL1 of a node connection line. The first node connection line NL1 extends in the second direction D2.

In an exemplary implementation, as shown in FIG. 46, in the display substrate according to FIG. 11, the pattern of the fourth conductive layer may include at least a third node connection line NL3 of a node connection line. The third node connection line NL3 extends in the second direction D2.

In an exemplary implementation, the latch signal line MSL, the second clock signal line CLK2, the first clock signal line CLK1, the first power supply line VGL-1, the second power supply line VGH-1, the third power supply line VGL-2, the fourth power supply line VCX, the fifth power supply line VGL-3, the sixth power supply line VGH-2, the seventh power supply line VGH-3, the eighth power supply line VGH-4, and the ninth power supply line VGL-4 are arranged sequentially along a direction close to the display area.

In an exemplary implementation, at least one signal line of the latch signal line MSL, the second clock signal line CLK2, the first clock signal line CLK1, the first power supply line VGL-1, the second power supply line VGH-1, the third power supply line VGL-2, the fourth power supply line VCX, the fifth power supply line VGL-3, the sixth power supply line VGH-2, the seventh power supply line VGH-3, the eighth power supply line VGH-4, and the ninth power supply line VGL-4 extends at least partially in the second direction D2.

In an exemplary implementation, an orthographic projection of the latch signal line MSL on the base substrate is located on a side of orthographic projections of the plurality of transistors in the shift register on the base substrate away from the display area. An orthographic projection of at least one signal line of the first clock signal line CLK1, the second clock signal line CLK2, the first power supply line VGL-1, the second power supply line VGH-1, the third power supply line VGL-2, the fourth power supply line VCX, the fifth power supply line VGL-3, the sixth power supply line VGH-2, the seventh power supply line VGH-3, the eighth power supply line VGH-4, and the ninth power supply line VGL-4 on the base substrate is at least partially overlapped with orthographic projections of some of transistors in the shift register on the base substrate. The above signal lines are arranged in such a manner that an area occupied by the gate drive circuit and signal lines connected thereto can be reduced, and the narrow bezels of the display substrate can be realized.

In an exemplary implementation, the latch signal line MSL is connected with a first electrode of a nineteenth transistor T19 of at least one shift register through the eighty-third via V83.

In an exemplary implementation, the second clock signal line CLK2 is connected with the first electrode of the second transistor through the seventy-third via, or with the first electrode of the fifth transistor (also the first electrode of the eighth transistor, the first electrode of the ninth transistor, and the first electrode of the fourth transistor) through the seventy-fifth via, and with the fourth connection line through the seventy-eighth via.

In an exemplary implementation, the first clock signal line CLK1 is connected with the first electrode of the fifth transistor (also the first electrode of the eighth transistor, the first electrode of the ninth transistor, and the first electrode of the fourth transistor) through the seventy-fifth via, and with the fourth connection line through the seventy-eighth via, or with the first electrode of the second transistor through the seventy-third via.

In an exemplary implementation, the first power supply line VGL-1 is connected with the first electrode of the third transistor through the eightieth via.

In an exemplary implementation, the second power supply line VGH-1 is connected with the first electrode of the fifth transistor through the seventy-sixth via.

In an exemplary implementation, the third power supply line VGL-2 is connected with the fifth connection line through the eighty-first via, and with the first electrode of the twenty-second transistor (also the first electrode of the twenty-third transistor) through the eighty-fifth via.

In an exemplary implementation, the fourth power supply line VCX is connected with the sixth connection line through the eighty-second via, and with the eighth connection line through the eighty-fourth via.

In an exemplary implementation, the fifth power supply line VGL-3 is connected with the first electrode of the tenth transistor through the seventy-ninth via.

In an exemplary implementation, the sixth power supply line VGH-2 is connected with the first electrode of the twenty-fourth transistor through the eighty-sixth via.

In an exemplary implementation, the seventh power supply line VGH-3 is connected with a seventh power supply line of one shift register of the i-th shift register and the (i+1)-st shift register through the eighty-seventh via, or the eighth power supply line is connected with the first electrode of the eighth transistor (also the first electrode of the ninth transistor, the first electrode of the thirteenth transistor, and the first electrode of the twenty-fifth transistor) through the eighty-seventh via.

In an exemplary implementation, the eighth power supply line VGH-4 is connected with a seventh power supply line of the other shift register of the i-th shift register and the (i+1)-st shift register through the eighty-seventh via, or the eighth power supply line is connected with the first electrode of the eighth transistor (also the first electrode of the ninth transistor, the first electrode of the thirteenth transistor, and the first electrode of the twenty-fifth transistor) through the eighty-seventh via.

In an exemplary implementation, the ninth power supply line VGL-4 is connected with the first electrode of the twenty-sixth transistor through the eighty-eighth via.

In an exemplary implementation, the ninth power supply line VGL-4 is connected with the tenth connection line through the ninetieth via.

In an exemplary implementation, in the display substrate according to FIGS. 7 and 8, a first node connection line of an i-th node connection line is connected with a second electrode of a sixth transistor (also a first electrode of a seventh transistor) in the i-th stage of shift register through a seventy-seventh via, and is connected with a second node connection line in an (i+1)-st stage of shift register through the eighty-ninth via.

In an exemplary implementation, in the display substrate according to FIG. 11, a third node connection line NL3 of an i-th node connection line is connected with a second node connection line through an eighty-ninth via.

In an exemplary implementation, the first connection line to the eleventh connection line are provided to function as connection electrodes, so that depths of vias in the display substrate can be reduced, and reliability of the display substrate can be improved.

In an exemplary implementation, the latch signal line MSL, the second clock signal line CLK2, the first clock signal line CLK1, the first power supply line VGL-1, the second power supply line VGH-1, the third power supply line VGL-2, the fourth power supply line VCX, the fifth power supply line VGL-3, the sixth power supply line VGH-2, the seventh power supply line VGH-3, the eighth power supply line VGH-4, and the ninth power supply line VGL-4 may be designed to have equal width, or may be designed to have different widths, may be straight lines, or may be polylines, which not only can facilitate a layout of the shift registers, but also can reduce the parasitic capacitance between the signal lines, the present disclosure is not limited thereto.

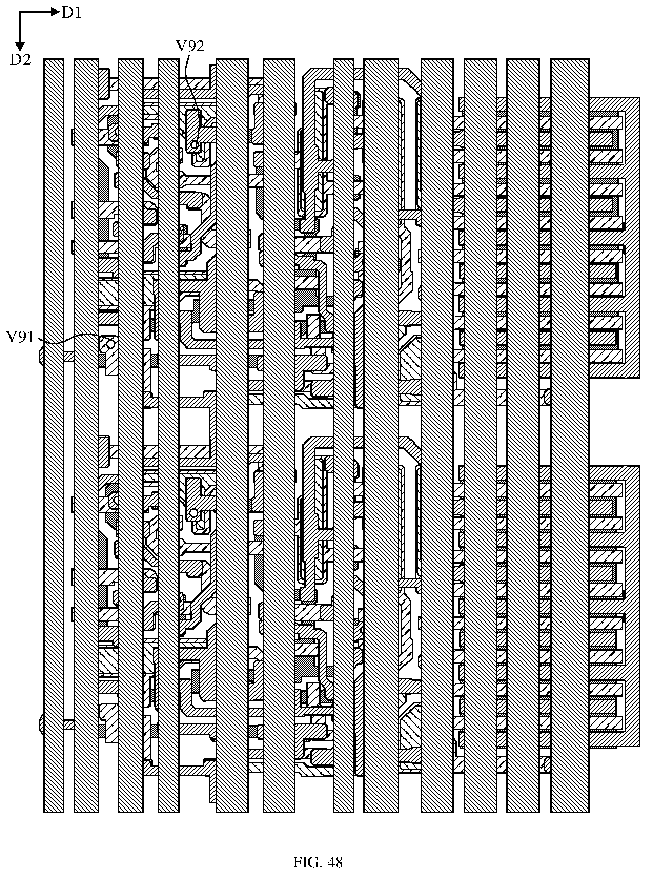

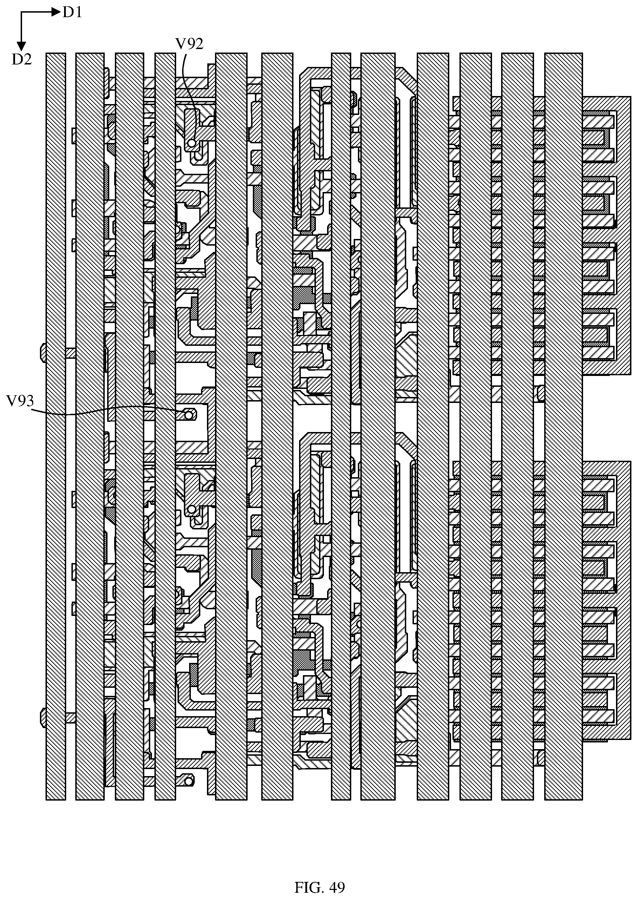

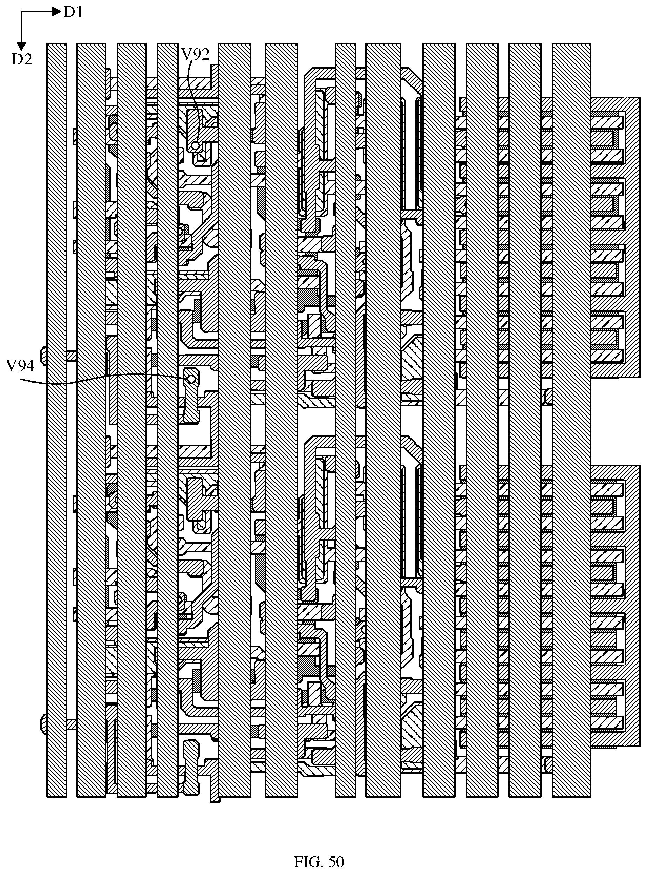

(8) A first planarization layer is formed. In an exemplary implementation, forming the pattern of the first planarization layer may include depositing a fifth insulation thin film on the base substrate on which the aforementioned patterns are formed, coating a first planarization thin film, patterning the fifth insulation thin film and the first planarization thin film by a patterning process, to form the pattern of the fifth insulation layer covering the aforementioned structures and the pattern of the first planarization layer covering the pattern of the fifth insulation layer, wherein the fifth insulation layer and the first planarization layer are provided with patterns of a plurality of vias, as shown in FIGS. 48 to 50. FIG. 48 is a schematic diagram of the display substrate according to FIG. 9 after a pattern of a first planarization layer is formed. FIG. 49 is a schematic diagram of the display substrate according to FIG. 10 after a pattern of a first planarization layer is formed. FIG. 50 is a schematic diagram of the display substrate according to FIG. 11 after a pattern of a first planarization layer is formed.

In an exemplary implementation, as shown in FIG. 48, the pattern of the first planarization layer of the display substrate according to FIG. 9 may include at least a ninety-first via V91 and a ninety-second via V92 in each stage of shift register.

In an exemplary implementation, as shown in FIG. 49, the pattern of the fourth insulation layer of the display substrate according to FIG. 10 may include at least a ninety-second via V92 and a ninety-third via V93 in each stage of shift register.

In an exemplary implementation, as shown in FIG. 50, the pattern of the fourth insulation layer of the display substrate according to FIG. 11 may include at least a ninety-second via V92 and a ninety-fourth via V94 in each stage of shift register.

In an exemplary implementation, an orthographic projection of the ninety-first via V91 on the base substrate is within a range of an orthographic projection of the gate electrode of the nineteenth transistor on the base substrate. The second insulation layer, the third insulation layer, the fourth insulation layer and the fifth insulation layer within the ninety-first via V91 are etched away, to expose a surface of the gate electrode of the nineteenth transistor. The ninety-first via V91 is configured such that the node connection line to be formed subsequently is connected with the gate electrode of the nineteenth transistor through the ninety-first via V91.

In an exemplary implementation, an orthographic projection of the ninety-second via V92 on the base substrate is within a range of an orthographic projection of the second electrode of the sixth transistor (also the first electrode of the seventh transistor) on the base substrate. The fourth insulation layer and the fifth insulation layer within the ninety-second via V92 are etched away, and a surface of the second electrode of the sixth transistor (also the first electrode of the seventh transistor) is exposed. In the display substrate according to FIG. 9, the ninety-second via V92 is configured such that the node connection line to be formed subsequently is connected with the second electrode of the sixth transistor (also the first electrode of the seventh transistor) through the ninety-second via V92. In the display substrate according to FIG. 11, the ninety-second via V92 is configured such that the first connection line of the node connection line to be formed subsequently is connected with the second electrode of the sixth transistor (also the first electrode of the seventh transistor) through the ninety-second via V92,

In an exemplary implementation, an orthographic projection of the ninety-third via V93 on the base substrate is within a range of an orthographic projection of the second node connection line of the node connection line on the base substrate. The fourth insulation layer and the fifth insulation layer within the ninety-third via V93 are etched away, and a surface of the second node connection line of the node connection line is exposed. The ninety-third via V93 is configured such that the first node connection line of the node connection line to be formed subsequently is connected with the second node connection line of the node connection line through the ninety-third via V93.

In an exemplary implementation, an orthographic projection of the ninety-fourth via V94 on the base substrate is within a range of an orthographic projection of the third node connection line of the node connection line on the base substrate. The fifth insulation layer within the ninety-fourth via V94 is etched away, and a surface of the third node connection line of the node connection line is exposed. The ninety-fourth via V94 is configured such that the first node connection line of the node connection line to be formed subsequently is connected with the third node connection line of the node connection line through the ninety-fourth via V94.

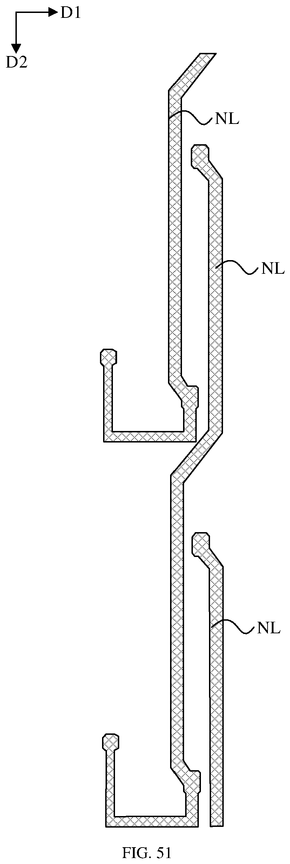

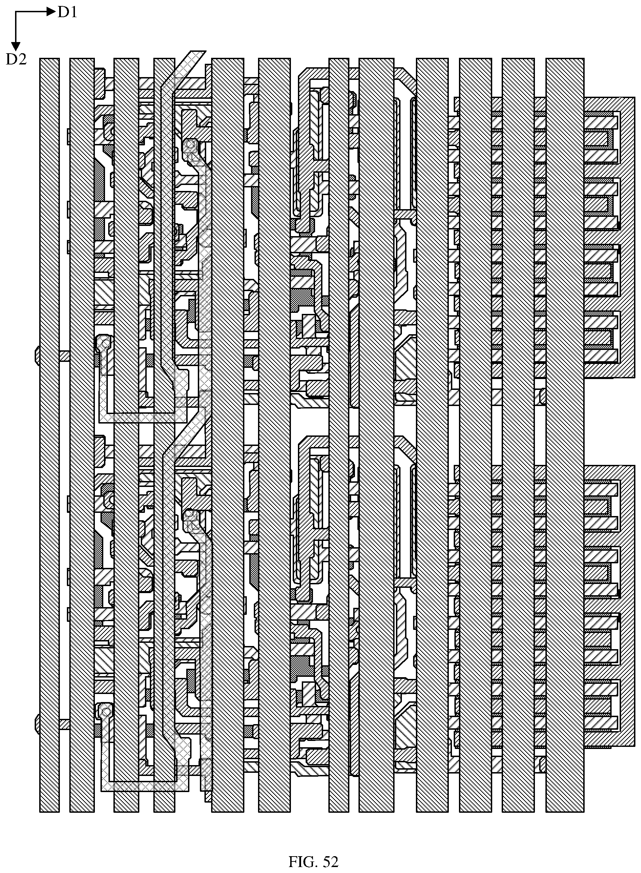

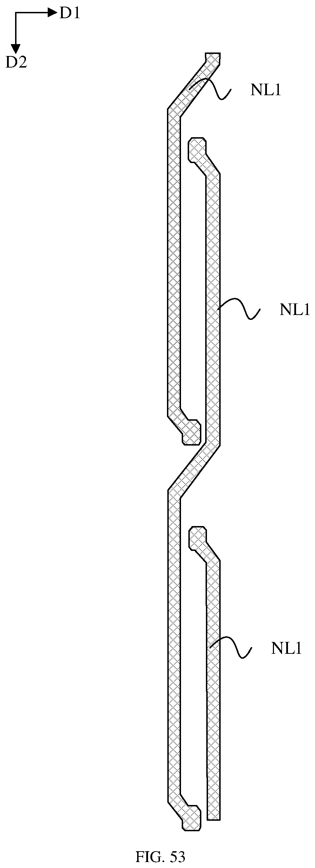

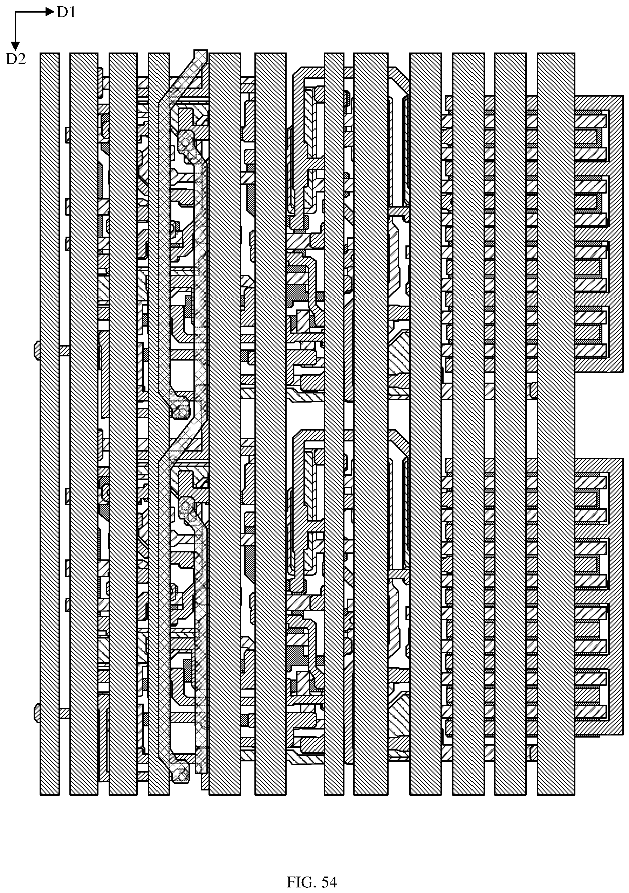

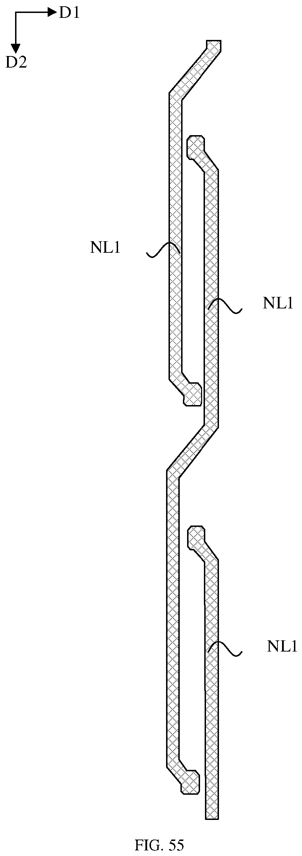

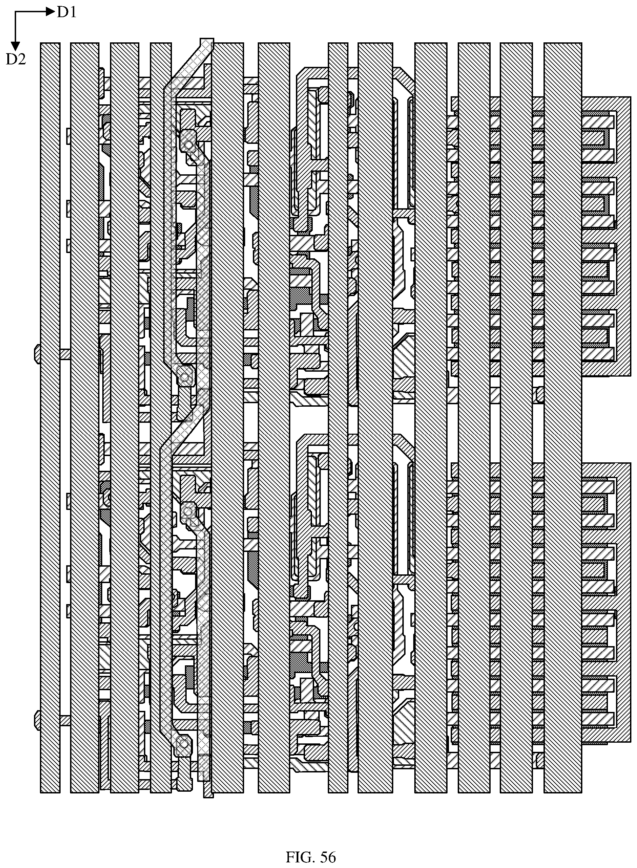

(9) A pattern of a fifth conductive layer is formed. In an exemplary implementation, forming the pattern of the fifth conductive layer may include depositing a fifth conductive thin film on the base substrate on which the aforementioned patterns are formed, patterning the fifth conductive thin film using a patterning process, to form the pattern of the fifth conductive layer disposed on the fifth insulation layer, as shown in FIGS. 51 to 56. FIG. 51 is a schematic diagram of a pattern of a fifth conductive layer in the display substrate according to FIG. 9. FIG. 52 is a schematic diagram of the display substrate according to FIG. 9 after the pattern of the fifth conductive layer is formed. FIG. 53 is a schematic diagram of a pattern of a fifth conductive layer in the display substrate according to FIG. 10. FIG. 54 is a schematic diagram of the display substrate according to FIG. 10 after the pattern of the fifth conductive layer is formed. FIG. 55 is a schematic diagram of a pattern of a fifth conductive layer in the display substrate according to FIG. 11. FIG. 56 is a schematic diagram of the display substrate according to FIG. 11 after the pattern of the fifth conductive layer is formed. In an exemplary implementation, the fifth conductive layer may be referred to as a third source drain metal (SD3) layer.

In an exemplary implementation, as shown in FIGS. 51 and 52, in the display substrate according to FIG. 9, the pattern of the fifth conductive layer may include at least a node connection line NL. The node connection line NL is connected with the gate electrode of the nineteenth transistor through the ninety-first via, and with the second electrode of the sixth transistor (also the first electrode of the seventh transistor) through the ninety-second via.

In an exemplary implementation, as shown in FIGS. 53 and 54, in the display substrate according to FIG. 10, the pattern of the fifth conductive layer may include at least a first node connection line NL1. An i-th node connection line NL1 is connected with a second electrode of a sixth transistor of an i-th shift register (also a first electrode of a seventh transistor) through a ninety-second via, and with a gate electrode of a nineteenth transistor of an (i+1)-st shift register through a ninety-third via.

In an exemplary implementation, as shown in FIGS. 55 and 56, in the display substrate according to FIG. 11, the pattern of the fifth conductive layer may at least include a first node connection line NL1. An i-th node connection line NL1 is connected with a second electrode of a sixth transistor of an i-th shift register (also a first electrode of a seventh transistor) through a ninety-second via, and with a third node connection line through a ninety-fourth via.

So far, a drive circuit layer has been manufactured on the base substrate. In a plane parallel to the display substrate, the drive circuit layer may include a plurality of shift registers electrically connected with the first clock signal line, the second clock signal line, the first power supply line to the ninth power supply line and the latch signal line. In a plane perpendicular to the display panel, the drive circuit layer may be disposed on the base substrate. In the display substrate according to FIGS. 7 and 8, the drive circuit layer may include the semiconductor layer, the first insulation layer, the first conductive layer, the second insulation layer, the second conductive layer, the third insulation layer, the third conductive layer, the fourth insulation layer, and the fourth conductive layer sequentially disposed on the base substrate. In the display substrate according to FIGS. 9 to 11, the drive circuit layer may include the semiconductor layer, the first insulation layer, the first conductive layer, the second insulation layer, the second conductive layer, the third insulation layer, the third conductive layer, the fourth insulation layer, the fourth conductive layer, the fifth insulation layer, and the fifth conductive layer sequentially disposed on the base substrate.

In an exemplary implementation, the base substrate may be a rigid base substrate or a flexible base substrate. The rigid base substrate may be, but is not limited to, one or more of glass and metal foil,. the flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber.

In an exemplary implementation, the flexible base substrate may include a first flexible material layer, a first inorganic material layer, a semiconductor layer, a second flexible material layer, and a second inorganic material layer which are stacked. Materials of the first flexible material layer and the second flexible material layer may be Polyimide (PI), Polyethylene Terephthalate (PET), or a surface-treated polymer soft film, etc., and materials of the first inorganic material layer and the second inorganic material layer may be Silicon Nitride (SiNx), Silicon Oxide (SiOx), or the like, for improving water and oxygen resistance of the base substrate. The first inorganic material layer and the second inorganic material layer may also be referred to as barrier layers, and a material of the semiconductor layer may be amorphous silicon (a-si). In an exemplary implementation, taking a stacked structure of PI1/Barrier1/a-si/PI2/Barrier2 as an example, its preparation process may include: first coating a layer of polyimide on a glass carrier board, after the layer of polyimide is cured to form a film, a first flexible (PI1) layer is formed; then depositing a layer of barrier thin film on the first flexible layer to form a first barrier (Barrier 1) layer overlaying the first flexible layer; then depositing a layer of amorphous silicon thin film on the first barrier layer to form an amorphous silicon (a-si) layer overlaying the first barrier layer; then coating another layer of polyimide on the amorphous silicon layer, after this layer of polyimide is cured to form a film, a second flexible (PI2) layer is formed; and then depositing a layer of barrier thin film on the second flexible layer to form a second barrier (Barrier 2) layer overlaying the second flexible layer, so as to complete preparation of the base substrate.

In an exemplary implementation, the semiconductor layer may be an amorphous silicon layer, a polycrystalline silicon layer, or may be a metal oxide layer. Herein, the metal oxide layer may be made of an oxide including indium and tin, an oxide including tungsten and indium, an oxide including tungsten, indium and zinc, an oxide including titanium and indium, an oxide including titanium, indium and tin, an oxide including indium and zinc, an oxide including silicon, indium and tin, or an oxide including indium or gallium and zinc. The metal oxide layer may be a single layer, a double-layer, or a multi-layer.

In an exemplary implementation, the first conductive layer, the second conductive layer, the third conductive layer, the fourth conductive layer, and the fifth conductive layer may be made of a metal material, such as any one or more of Argentum (Ag), Copper (Cu), Aluminum (Al), and Molybdenum (Mo), or an alloy material of the aforementioned metals, such as an Aluminum Neodymium alloy (AlNd) or a Molybdenum Niobium alloy (MoNb), and may be of a single-layer structure or a multi-layer composite structure, such as Mo/Cu/Mo.

In an exemplary implementation, the first insulation layer, the second insulation layer, the third insulation layer, the fourth insulation layer, and the fifth insulation layer may be made of any one or more of Silicon Oxide (SiOx), Silicon Nitride (SiNx), and Silicon Oxynitride (SiON), and may be a single layer, multiple-layers, or a composite layer.

In an exemplary implementation, after preparation of the drive circuit layer is completed, a light emitting structure layer is prepared on the drive circuit layer, and a preparation process of the light emitting structure layer may include following operations.

An anode conductive thin film is deposited on the base substrate on which the aforementioned patterns are formed, the anode conductive thin film is patterned using a patterning process, to form a pattern of an anode conductive layer disposed on a second planarization layer; a pixel definition thin film is deposited on the base substrate on which the aforementioned patterns are formed; the pixel definition thin film is patterned using the patterning process to form a pattern of a pixel definition layer exposing the pattern of the anode conductive layer; an organic light-emitting material is coated on the base substrate on which the pattern of the pixel definition layer is formed; the organic light emitting material is patterned through the patterning process, to form a pattern of an organic structure layer; a cathode conductive thin film is deposited on the base substrate on which the pattern of the organic material layer is formed; and, the cathode conductive thin film is patterned through the patterning process, to form a cathode conductive layer.

So far, the light emitting structure layer has been manufactured on the base substrate.

In an exemplary implementation, the anode conductive layer includes at least a plurality of anode patterns. The plurality of anode patterns may include an anode of a first light emitting device, an anode of a second light emitting device, an anode of a third light emitting device, and an anode of a fourth light emitting device. The anode of the first light emitting device is located in a red sub-pixel emitting red light, the anode of the second light emitting device may be located in a blue sub-pixel emitting blue light, the anode of the third light emitting device may be located in a first green sub-pixel emitting green light, and the anode of the fourth light emitting device may be located in a second green sub-pixel emitting green light.

In an exemplary implementation, the anode of the first light emitting device and the anode of the second light emitting device may be alternately disposed in the first direction, and the anode of the third light emitting device and the anode of the fourth light emitting device may be alternately disposed in the first direction. Or, the anode of the first light emitting device and the anode of the second light emitting device may be alternately disposed in the second direction, and the anode of the third light emitting device and the anode of the fourth light emitting device may be alternately disposed in the second direction.

In an exemplary implementation, four sub-pixels in one pixel unit may have the same or different anode shapes and areas.

In an exemplary implementation, the anode conductive layer may be of a single-layer structure, such as Indium Tin Oxide (ITO) or Indium Zinc Oxide (IZO), or may be of a multi-layer composite structure, such as ITO/Ag/ITO.

In an exemplary implementation, the organic structure layer may at least include: an organic light emitting layer of the light emitting device.

In an exemplary implementation, the cathode conductive layer may include at least cathodes of a plurality of light emitting devices.

In an exemplary implementation, the cathode layer may be made of a metal material, such as any one or more of argentum (Ag), copper (Cu), aluminum (Al), and molybdenum (Mo), or a conductive alloy material of the above metals, such as an Aluminum Neodymium alloy (AlNd) or a Molybdenum Niobium alloy (MoNb), and may have a single-layer structure or a multi-layer composite structure, such as Mo/Cu/Mo. Exemplarily, the fourth conductive layer may be of a three-layer stacked structure formed of titanium, aluminum, and titanium.

The display substrate according to the embodiment of the present disclosure may be applied to a display product with any resolution.

In an exemplary implementation, the subsequent preparation process may include forming an encapsulation structure layer on the cathode conductive layer, and the encapsulation structure layer may include a first encapsulation layer, a second encapsulation layer and a third encapsulation layer which are stacked. The first encapsulation layer and the third encapsulation layer may be made of an inorganic material, the second encapsulation layer may be made of an organic material, and the second encapsulation layer is arranged between the first encapsulation layer and the third encapsulation layer to ensure that external water vapor cannot enter the light emitting structure layer.

An embodiment of the present disclosure further provides a display apparatus, which may include: a display substrate.

The display substrate is the display substrate according to any of the aforementioned embodiments, and has similar implementation principles and implementation effects, which will not be repeated here.

In an exemplary implementation, the display apparatus may be any product or component with a display function such as a wearable device, a mobile phone, a tablet computer, a television, a display, a laptop computer, a digital photo frame, and a navigator.

The drawings of the embodiments of the present disclosure only involve structures involved in the embodiments of the present disclosure, and other structures may refer to a common general design.

For the sake of clarity, a thickness and size of a layer or a micro structure are enlarged in the accompanying drawings used for describing the embodiments of the present disclosure. It may be understood that when an element such as a layer, film, region, or substrate is described as being "on" or "under" another element, the element may be "directly" located "on" or "under" the another element, or there may be an intermediate element.

Although the implementations of the present disclosure are disclosed above, the contents are only implementations used for ease of understanding of the present disclosure, but not intended to limit the present disclosure. Any of those skilled in the art of the present disclosure can make any modifications and variations in the implementations and details without departing from the essence and scope of the present disclosure. However, the protection scope of the present disclosure should be subject to the scope defined by the appended claims.

## Claims

1. A display substrate having a display area and a non-display area, wherein the display area is provided with a pixel drive circuit, and the non-display area is provided with a gate drive circuit, the gate drive circuit comprises a plurality of shift registers which are cascaded, at least one stage of shift register comprises a shift sub-circuit and an output sub-circuit, wherein the shift sub-circuit is provided with a first node;
the shift sub-circuit is connected with a signal input terminal, a first clock signal terminal, a second clock signal terminal, a first power supply terminal, a second power supply terminal and a cascaded signal output terminal respectively, and is configured to provide a signal of the first power supply terminal or the second power supply terminal to the cascaded signal output terminal under control of signals of the signal input terminal, the first clock signal terminal and the second clock signal terminal;
the output sub-circuit is connected with a control signal terminal, a third power supply terminal, a fourth power supply terminal, the cascaded signal output terminal and a drive signal output terminal respectively, and is configured to provide a signal of the third power supply terminal or the fourth power supply terminal to the drive signal output terminal under control of signals of the latch signal terminal, the control signal terminal and the cascaded signal output terminal; and
the control signal terminal is connected with a first node of a previous stage of shift register with respect to a current stage of shift register, the drive signal output terminal is connected with the pixel drive circuit, and the cascaded signal output terminal is connected with a signal input terminal of at least one stage of shift register other than the current stage of shift register.

2. The display substrate of claim 1, wherein the shift sub-circuit comprises at least a sixth transistor, a seventh transistor, a ninth transistor, and a tenth transistor; and
the first node is connected with the sixth transistor and the seventh transistor respectively, the ninth transistor is connected with the first power supply terminal and the cascaded signal output terminal respectively, and the tenth transistor is connected with the second power supply terminal and the cascaded signal output terminal respectively.

3. The display substrate of claim 1 or 2, wherein the shift sub-circuit comprises a fourth capacitor;
a first plate of the fourth capacitor is connected with the second power supply terminal, and a second plate of the fourth capacitor is connected with the cascaded signal output terminal;
a range of a capacitance value of the fourth capacitor is from 10 farads to 80 farads.

4. The display substrate of claim 1 or 2, wherein the output sub-circuit comprises at least a nineteenth transistor, a twentieth transistor, a twenty-fourth transistor, a twenty-fifth transistor, and a twenty-sixth transistor;
the nineteenth transistor is connected with the latch signal terminal, the twentieth transistor is connected with the cascaded signal output terminal, the twenty-fourth transistor is connected with the third power supply terminal, the twenty-fifth transistor is connected with the third power supply terminal and the drive signal output terminal respectively, and the twenty-sixth transistor is connected with the fourth power supply terminal and the drive signal output terminal respectively.

5. The display substrate of claim 1, wherein the shift sub-circuit is further provided with a fifth node, the shift sub-circuit further comprises a fourth transistor and a fifth transistor, the fifth node is connected with the fourth transistor and the fifth transistor respectively; and
the output sub-circuit is further connected with the fifth node and the fourth power supply terminal respectively.

6. The display substrate of claim 5, wherein the output sub-circuit comprises at least a nineteenth transistor, a twentieth transistor, a twenty-second transistor, a twenty-third transistor, a twenty-fourth transistor, a twenty-fifth transistor, and a twenty-sixth transistor;
the nineteenth transistor is connected with the latch signal terminal, the twentieth transistor is connected with the cascaded signal output terminal, the twenty-second transistor is connected with the fourth power supply terminal, the twenty-third transistor is connected with the fifth node and the fourth power supply terminal respectively, the twenty-fourth transistor is connected with the third power supply terminal, the twenty-fifth transistor is connected with the third power supply terminal and the drive signal output terminal respectively, and the twenty-sixth transistor is connected with the fourth power supply terminal and the drive signal output terminal respectively.

7. The display substrate of claim 1 or 2, wherein the shift sub-circuit comprises a ninth transistor and a tenth transistor, and the output sub-circuit comprises a twenty-fifth transistor and a twenty-sixth transistor, and one of the transistors comprises an active pattern;
a length of an active pattern of at least one of the twenty-fifth transistor and the twenty-sixth transistor in a first direction is greater than a length of an active pattern of at least one of the ninth transistor and the tenth transistors in the first direction, and a length of an active pattern of at least one of the twenty-fifth transistor and the twenty-sixth transistor in a second direction is greater than a length of an active pattern of at least one of the ninth transistor and the tenth transistor in the second direction, wherein the first direction and the second direction intersect.

8. The display substrate of claim 7, wherein a channel width-to-length ratio of the active pattern of at least one of the twenty-fifth transistor and the twenty-sixth transistor is greater than or equal to 80/3.

9. The display substrate of claim 1 or 2, further comprising: a plurality of signal lines located in the non-display area, the shift registers comprise a plurality of transistors and a plurality of capacitors, the plurality of signal lines are connected with the shift registers, at least one of the plurality of signal lines extend at least partially in a second direction, one of the transistors comprises: an active pattern, a gate electrode, a first electrode and a second electrode;
the display substrate comprises a base substrate and a drive structure layer disposed on the base substrate, wherein the drive structure layer is provided with a pixel drive circuit and a gate drive circuit, and the drive structure layer comprises a semiconductor layer, a first conductive layer, a second conductive layer, a third conductive layer and a fourth conductive layer sequentially stacked on the base substrate;
the semiconductor layer comprises at least an active pattern of at least one transistor of the plurality of transistors;
the first conductive layer comprises at least a gate electrode of at least one transistor of the plurality of transistors and a first plate of at least one capacitor of the plurality of capacitors;
the second conductive layer comprises at least a second plate of at least one capacitor of the plurality of capacitors;
the third conductive layer comprises at least a first electrode and a second electrode of at least one transistor of the plurality of transistors; and
the fourth conductive layer at least comprises at least one signal line of the plurality of signal lines.

10. The display substrate of claim 9, wherein the shift sub-circuit comprises a fifth transistor, a ninth transistor, a tenth transistor, and a twenty-first transistor; the display substrate further comprises: N voltage stabilization connection lines, N cascaded connection lines and N cascaded output lines, wherein a second electrode of the ninth transistor and a second electrode of the tenth transistor in a shift register are formed into an integral structure, and a gate electrode of the twenty-first transistor and a first plate of a fifth capacitor are formed into an integral structure;
an n-th stabilization connection line is connected with an n-th cascaded connection line and an integral structure of a second electrode of a ninth transistor and a second electrode of a tenth transistor in an n-th stage of shift register respectively, and an n-th cascaded output line is connected with an n-th cascaded connection line and a first electrode of a first transistor in an (n+1)-st stage of shift register respectively, where 1≤n≤N, and N is a total number of stages of the shift register; and
for at least one stage of shift register, an orthographic projection of an integral structure of a second electrode of a ninth transistor and a second electrode of a tenth transistor on the base substrate is at least partially overlapped with an orthographic projection of an integral structure of a gate electrode of a twenty-first transistor and a first plate of a fifth capacitor on the base substrate.

11. The display substrate of claim 10, wherein the stabilization connection lines are located in the semiconductor layer, the cascaded output lines are located in the second conductive layer, and the cascaded connection lines are located in the third conductive layer.

12. The display substrate of claim 10, wherein a line width of a voltage stabilization connection line is greater than a line width of a cascaded connection line and greater than a line width of a cascaded output line; and
a range of a resistance value of the voltage stabilization connection line is from 500 ohms to 5000 ohms.

13. The display substrate of claim 9, wherein the shift sub-circuit comprises a fifth transistor, a ninth transistor, a tenth transistor, a twenty-first transistor and a fourth capacitor, wherein the display substrate further comprises N cascaded output lines, a second electrode of a ninth transistor and a second electrode of the tenth transistor in a shift register are formed into an integral structure, a gate electrode of the twenty-first transistor and a first plate of a fifth capacitor are formed into an integral structure;
an integral structure of a second electrode of a ninth transistor and a second electrode of a tenth transistor in an n-th stage of shift register is connected with an n-th cascaded output line and a second plate of a fourth capacitor in the n-th stage of shift register respectively, where 1≤n≤N, and N is a total number of stages of shift register;
for at least one stage of shift register, an orthographic projection of an integral structure of a second electrode of a ninth transistor and a second electrode of a tenth transistor on the base substrate is not overlapped with an orthographic projection of an integral structure of a gate electrode of a twenty-first transistor and a first plate of a fifth capacitor on the base substrate.

14. The display substrate of claim 13, wherein the cascaded output lines are located in the second conductive layer.

15. The display substrate of claim 9, further comprising N-1 node connection lines, and a shift register further comprises a sixth transistor, a seventh transistor, and a nineteenth transistor; a second electrode of the sixth transistor and a first electrode of the seventh transistor in the shift register are formed into an integral structure; and
an i-th node connection line is connected with an integral structure of a second electrode of a sixth transistor and a first electrode of a seventh transistor in an i-th stage of shift register and a gate electrode of a nineteenth transistor in an (i+1)-st stage of shift register respectively, where 1≤i≤N-1.

16. The display substrate of claim 15, wherein a node connection line comprises: a first node connection line and a second node connection line disposed in different layers;
for the i-th node connection line, a first node connection line is connected with a second node connection line and the integral structure of the second electrode of the sixth transistor and the first electrode of the seventh transistor in the i-th stage of shift register respectively, and the second node connection line is electrically connected with the gate electrode of the nineteenth transistor in the (i+1)-st stage of shift register;
at least one connection line of the first node connection line and the second node connection line extends at least partially in the second direction, an orthographic projection of the first node connection line on the base substrate is not overlapped with an orthographic projection of at least one of the plurality of signal lines on the base substrate, an orthographic projection of the second node connection line on the base substrate is at least partially overlapped with orthographic projections of some of the plurality of signal lines on the base substrate, and an orthographic projection of a part of the second node connection line on the base substrate is at least partially overlapped with an orthographic projection of a first signal line on the base substrate, wherein the first signal line is a signal line of the plurality of signal lines away from the display area.

17. The display substrate of claim 16, wherein the first node connection line is located in the fourth conductive layer and the second node connection line is located in the third conductive layer.

18. The display substrate of claim 15, wherein a node connection line comprises: a first node connection portion and a second node connection portion, and the first node connection portion and the second node connection portion are formed into an integral structure;
for the i-th node connection line, a first node connection portion is connected with a second node connection portion and the integral structure of the second electrode of the sixth transistor and the first electrode of the seventh transistor in the i-th stage of shift register respectively, and the second node connection portion is electrically connected with the gate electrode of the nineteenth transistor in the (i+1)-st stage of shift register; and
the first node connection portion extends at least partially in the second direction, the second node connection portion extends at least partially in a first direction, an orthographic projection of the second node connection portion on the base substrate is at least partially overlapped with orthographic projections of some of the plurality of signal lines on the base substrate, and an orthographic projection of a part of the second node connection portion on the base substrate is on a side of an orthographic projection of a first signal line on the base substrate close to the display area, wherein the first signal line is a signal line of the plurality of signal lines away from the display area.

19. The display substrate of claim 18, wherein the drive structure layer further comprises: a fifth conductive layer located on a side of the fourth conductive layer away from the base substrate; and
the node connection lines are located in the fifth conductive layer.

20. The display substrate of claim 15, wherein a node connection line comprises: a first node connection line and a second node connection line disposed in different layers;
for the i-th node connection line, a first node connection line is connected with the integral structure of the second electrode of the sixth transistor and the first electrode of the seventh transistor in the i-th stage of shift register and a second node connection line respectively, and the second node connection line is electrically connected with the gate electrode of the nineteenth transistor in the (i+1)-st stage of shift register; and
the first node connection line extends at least partially in the second direction, the second node connection line extends at least partially in a first direction, an orthographic projection of the second node connection line on the base substrate is at least partially overlapped with orthographic projections of some of the plurality of signal lines on the base substrate, and an orthographic projection of a part of the second node connection line on the base substrate is located on a side of an orthographic projection of a first signal line on the base substrate close to the display area, wherein the first signal line is a signal line of the plurality of signal lines away from the display area.

21. The display substrate of claim 20, wherein the drive structure layer further comprises: a fifth conductive layer located on a side of the fourth conductive layer away from the base substrate; and
the first node connection line is located in the fifth conductive layer, and the second node connection line is located in the third conductive layer.

22. The display substrate of claim 15, wherein a node connection line comprises: a first node connection line, a second node connection line and a third node connection line disposed in different layers;
for the i-th node connection line, a first node connection line is connected with a third node connection line and the integral structure of the second electrode of the sixth transistor and the first electrode of the seventh transistor in the i-th stage of shift register respectively, and a second node connection line is electrically connected with the third node connection line and the gate electrode of the nineteenth transistor in the (i+1)-st stage of shift register respectively;
the first node connection line and the third node connection line extend at least partially in the second direction, the second node connection line extends at least partially in a first direction, an orthographic projection of the third node connection line on the base substrate is not overlapped with an orthographic projection of at least one of the plurality of signal lines on the base substrate, an orthographic projection of the second node connection line on the base substrate is at least partially overlapped with orthographic projections of some of the plurality of signal lines on the base substrate, and an orthographic projection of a part of the second node connection line on the base substrate is located on a side of an orthographic projection of a first signal line on the base substrate close to the display area, wherein the first signal line is a signal line of the plurality of signal lines away from the display area.

23. The display substrate of claim 22, wherein the drive structure layer further comprises: a fifth conductive layer located on a side of the fourth conductive layer away from the base substrate; and
the first node connection line is located in the fifth conductive layer, the third node connection line is located in the fourth conductive layer, and the second node connection line is located in the third conductive layer.

24. The display substrate of claim 9, wherein the plurality of signal lines comprise a latch signal line, a first clock signal line, a second clock signal line, a first power supply line, a second power supply line, a third power supply line, a fourth power supply line, a fifth power supply line, a sixth power supply line, a seventh power supply line, an eighth power supply line, and a ninth power supply line arranged sequentially along a direction close to the display area;
the latch signal line is configured to provide a signal to a latch signal terminal to which a shift register is connected, and at least one of the first power supply line, the third power supply line, the fifth power supply line and the ninth power supply line is configured to provide a signal to the second power supply terminal or the fourth power supply terminal to which the shift register is connected; the second power supply line, the sixth power supply line, the seventh power supply line and the eighth power supply line are configured to provide signals to the first power supply terminal and the third power supply terminal to which the shift register is connected, and the fourth power supply line is configured to provide a signal to the fifth power supply terminal to which the shift register is connected;
wherein the seventh power supply line is configured to provide a signal to a third power supply terminal to which an i-th shift register is connected, and the eighth power supply line is configured to provide a signal to a third power supply terminal to which an (i+1)-st shift register is connected.

25. The display substrate of claim 24, wherein an orthographic projection of the latch signal line on the base substrate is located on a side of orthographic projections of the plurality of transistors in the shift register on the base substrate away from the display area, and an orthographic projection of at least one of the first clock signal line, the second clock signal line, the first power supply line, the second power supply line, the third power supply line, the fourth power supply line, the fifth power supply line, the sixth power supply line, the seventh power supply line, the eighth power supply line, and the ninth power supply line on the base substrate is at least partially overlapped with orthographic projections of some of the transistors in the shift register on the base substrate.

26. The display substrate of claim 24, wherein signals of at least two of the second power supply line, the sixth power supply line, the seventh power supply line, and the eighth power supply line are the same; or
signals of the second power supply line and the sixth power supply line are the same, signals of the seventh power supply line and the eighth power supply line are the same, and voltage values of signals of the second power supply line and the seventh power supply line are different; or
signals of the sixth power supply line, the seventh power supply line, and the eighth power supply line are the same, and voltage values of signals of the second power supply line and the sixth power supply line are different.

27. The display substrate of claim 24, wherein signals of at least two of the first power supply line, the third power supply line, the fifth power supply line, and the ninth power supply line are the same; or
signals of at least two of the first power supply line, the third power supply line, and the fifth power supply line are the same and are different from a signal of the ninth power supply line.

28. The display substrate of claim 1 or 2, wherein orthographic projections of at least some of transistors and at least some of capacitors comprised in the output sub-circuit on the base substrate are around a side of orthographic projections of at least some of transistors and at least some of capacitors comprised in the shift sub-circuit on the base substrate, and are located on a side of the shift sub-circuit close to the display area.

29. The display substrate of claim 1 or 2, wherein the shift sub-circuit comprises a fourth capacitor; orthographic projections of at least some of transistors comprised in the output sub-circuit on the base substrate are around at least one side of an orthographic projection of the fourth capacitor on the base substrate.

30. A display apparatus, comprising the display substrate according to any one of claims 1 to 29.
